# EUROPEAN PATENT SPECIFICATION

(11) **EP 4 585 815 B1**
(45) Date of publication and mention of the grant of the patent: **09.12.2026**
(21) Application number: 23879067.9
(22) Date of filing: 16.10.2023
(51) Int. Cl.: H04M 1/02, F16C 11/04

(54) **FOLDING ASSEMBLY, FOLDING APPARATUS AND ELECTRONIC DEVICE**
FALTANORDNUNG, FALTVORRICHTUNG UND ELEKTRONISCHE VORRICHTUNG
ENSEMBLE DE PLIAGE, APPAREIL DE PLIAGE ET DISPOSITIF ÉLECTRONIQUE

(30) Priority: 20.10.2022 CN 202211289636
(43) Date of publication of application: 16.07.2025
(73) Proprietor: Huawei Technologies Co., Ltd., Shenzhen, Guangdong 518129 (CN)
(72) Inventor: WANG, Gangchao, Shenzhen, Guangdong 518129 (CN); LI, Yunyong, Shenzhen, Guangdong 518129 (CN); XU, Zhengyi, Shenzhen, Guangdong 518129 (CN); TANG, Zecheng, Shenzhen, Guangdong 518129 (CN); WU, Hao, Shenzhen, Guangdong 518129 (CN); YAN, Huiyin, Shenzhen, Guangdong 518129 (CN)
(74) Representative: Pfenning, Meinig & Partner mbB
(86) International application number: PCT/CN2023/124757
(87) International publication number: WO 2024/083078

(56) References cited:
- EP-A1- 3 842 647
- CN-A- 112 901 643
- CN-A- 113 194 183
- CN-A- 114 006 963
- CN-A- 114 006 963
- CN-A- 115 150 486
- CN-U- 217 428 168
- CN-U- 218 760 886
- KR-A- 20040 045 582
- US-A1- 2022 116 489

## Description

This application claims priority to Chinese Patent Application No. 202211289636.3, filed with the China National Intellectual Property Administration on October 20, 2022 and entitled "FOLDABLE ASSEMBLY, FOLDABLE APPARATUS, AND ELECTRONIC DEVICE".

### TECHNICAL FIELD

This application relates to the field of foldable electronic product technologies, and in particular, to a foldable assembly, a foldable apparatus, and an electronic device.

### BACKGROUND

In recent years, flexible displays are widely used in various foldable electronic devices because of lightness, thinness, non-fragileness, and the like. The foldable electronic device further includes a foldable apparatus used to carry the flexible display. The foldable apparatus generally includes two housings and a foldable assembly connected between the two housings. The two housings are folded relative to each other or unfolded relative to each other through deformation of the foldable assembly, and drive the flexible display to be folded or unfolded.

Currently, the foldable apparatus is easily overfolded when the two housings are unfolded relative to each other to an open state. Consequently, an actual included angle between the two housings is greater than an ideal included angle. A design size and a structure of the flexible display are usually designed based on the ideal included angle. In this case, the foldable apparatus pulls the flexible display when the two housings are overfolded during unfolding. Consequently, a service life of the flexible display is seriously affected.

### SUMMARY

This application provides a foldable assembly, a foldable apparatus, and an electronic device. An electronic device includes a flexible display and a foldable apparatus that carries the flexible display. The foldable apparatus includes a first housing, a foldable assembly, and a second housing that are sequentially connected. The foldable assembly accurately controls an included angle between the first housing and the second housing that are in an open state by using an adjustable rotating mechanism, to avoid overfolding of the foldable apparatus, and prolongs a service life of the flexible display.

According to a first aspect, this application provides a foldable assembly, which may be applied to a foldable electronic device. A foldable apparatus of the electronic device includes a first housing, a second housing, and the foldable assembly. The foldable apparatus is configured to carry a flexible display. The foldable assembly includes a main shaft, a first fastening bracket, a first swing arm, a second fastening bracket, a second swing arm, a limiting member, a stop member, a second fastener, and a first elastic member. The first fastening bracket is configured to be fastened to the first housing, and the second fastening bracket is configured to be fastened to the second housing.

A first end part of the first swing arm is rotatably connected to the main shaft, a second end part of the first swing arm is slidably connected to the first fastening bracket, and the first end part of the first swing arm has a first stop end surface. A first end part of the second swing arm is rotatably connected to the main shaft, a second end part of the second swing arm is slidably connected to the second fastening bracket, and the first end part of the second swing arm has a second stop end surface. The limiting member is fastened to the main shaft, the limiting member has a limiting surface, the limiting surface is inclined relative to a thickness direction of the main shaft and is inclined relative to an extension direction of the main shaft, and the extension direction of the main shaft is perpendicular to the thickness direction of the main shaft. The stop member includes a first stop part, a second stop part, and a mounting part, the first stop part and the second stop part are respectively fastened to two sides of the mounting part, one end of the second fastener is connected to the mounting part, the other end is threadedly connected to the main shaft, the first elastic member abuts between the mounting part and the main shaft, and the stop member abuts against the limiting surface.

The first stop part has a first stop surface, the second stop part has a second stop surface, and neither the first stop surface nor the second stop surface is parallel to the thickness direction of the main shaft. In a process in which the first swing arm and the second swing arm are unfolded relative to each other, the first stop end surface moves in a direction close to the first stop surface, and the second stop end surface moves in a direction close to the second stop surface. When the first swing arm and the second swing arm are in an open state, the first stop end surface at least partially abuts against the first stop surface, and the second stop end surface at least partially abuts against the second stop surface.

In this application, a stop cooperation structure between the first stop surface of the stop member and the first stop end surface of the first swing arm and a stop cooperation structure between the second stop surface of the stop member and the second stop end surface of the second swing arm are disposed, so that when the first swing arm and the second swing arm are unfolded relative to each other to an open state, the first swing arm and the second swing arm can be limited to continue to be rotated relative to each other, and an included angle between the first swing arm and the second swing arm can stay at a preset angle, avoiding excessive rotation.

The first swing arm is slidably connected to the first fastening bracket, the first fastening bracket is configured to be fastened to the first housing, the second swing arm is slidably connected to the second fastening bracket, and the second fastening bracket is configured to be fastened to the second housing. Therefore, stopping of the stop member on the first swing arm and the second swing arm is stopping on the first housing and the second housing. In the electronic device, when the first housing and the second housing are rotated relative to each other to the open state, the first fastening bracket and the second fastening bracket are also rotated relative to each other to the open state. In this way, the first swing arm and the second swing arm are also rotated relative to each other to the open state. In this case, the first end part of the first swing arm and the first end part of the second swing arm abut against the stop member. The stop member is configured to prevent an angle at which the first swing arm and the second swing arm are rotated relative to each other from exceeding a preset value, to prevent an angle at which the first fastening bracket and the second fastening bracket are rotated relative to each other from exceeding the preset value, and prevent an angle at which the first housing and the second housing are rotated relative to each other from exceeding the preset value. Therefore, the stop member stops the first swing arm and the second swing arm, to prevent the first housing and the second housing from being over-folded when the electronic device is in the open state. This prevents the flexible display from being pulled by the first housing and the second housing, improves reliability of the flexible display, and prolongs a service life of the flexible display.

In addition, due to stop effect of the stop member, the included angle between the first housing and the second housing in the open state is equal to the preset value. For example, when the preset value is 180°, the foldable apparatus can provide a flat supporting environment for the flexible display, and flatness of the flexible display is good. This helps optimize overall light and shadow of the electronic device.

In addition, the first stop surface and the second stop surface are disposed on a same stop member, and the first swing arm and the second swing arm are stopped by using the same stop member. This can effectively reduce a quantity of stop members required by the foldable assembly, reduce a space occupied by the stop member inside the foldable assembly, and help reduce costs.

In this application, because the limiting member is fastened to the main shaft, the stop member abuts against the limiting surface of the limiting member, and the limiting member can limit the stop member, structural stability and structural rigidity of the stop member relative to the main shaft can be improved, and the stop member can stop the first swing arm and the second swing arm. In this way, good stop effect is achieved, and an unfolded state of the foldable assembly and the electronic device is stable and reliable.

Because the second fastener is threadedly connected to the main shaft through a, and a position of the second fastener relative to the main shaft is adjustable, the second fastener moves in the thickness direction of the main shaft, and the stop member can move with the second fastener in the thickness direction of the main shaft under cooperation between the second fastener and the first elastic member, to perform position adjustment. Neither the first stop surface nor the second stop surface of the stop member is parallel to the thickness direction of the main shaft, that is, both the first stop surface and the second stop surface are inclined relative to the thickness direction of the main shaft. When the stop member moves in the thickness direction of the main shaft, the first stop surface and the second stop surface move in the thickness direction of the main shaft. When the first swing arm and the second swing arm are in the open state, a position of the first stop end surface of the first swing arm changes with the first stop surface, and a position of the second stop end surface of the second swing arm changes with the second stop surface. In this way, the included angle between the first swing arm and the second swing arm can be adjusted by adjusting a position of the stop member.

For example, both the first stop surface and the second stop surface of the stop member may be perpendicular to the thickness direction of the main shaft. Alternatively, an included angle between the first stop surface and the thickness direction of the main shaft is greater than or equal to 45°, for example, may range from 60° to 90°; and an included angle between the second stop surface and the thickness direction of the main shaft is greater than or equal to 45°, for example, may range from 60° to 90°. In this case, when the first stop surface and the second stop surface move with the stop member in the thickness direction of the main shaft, the included angle between the first swing arm and the second swing arm may be effectively adjusted through small displacement.

In some possible implementations, the foldable assembly further includes a first rotating arm and a second rotating arm. A first end part of the first rotating arm is rotatably connected to the main shaft, and a second end part of the first rotating arm is rotatably connected to the first fastening bracket. A second end part of the second rotating arm is rotatably connected to the main shaft, and a second end part of the second rotating arm is rotatably connected to the second fastening bracket.

In this implementation, the first swing arm is rotatably connected to the main shaft and slidably connected to the first fastening bracket to form a connecting rod slider structure. The first rotating arm is rotatably connected to the main shaft and rotatably connected to the first fastening bracket to form a connecting rod structure. The second swing arm is rotatably connected to the main shaft and slidably connected to the second fastening bracket to form a connecting rod slider structure. The second rotating arm is rotatably connected to the main shaft and rotatably connected to the second fastening bracket to form a connecting rod structure. The foldable assembly implements, by using the connecting rod slider structure and the connecting structure, a process in which the foldable assembly is relatively unfolded or folded. A quantity of components of the foldable assembly is small, a cooperation relationship and a cooperation position are simple, and the components are easy to be manufactured and assembled, which facilitates mass production. In addition, because the main shaft is linked to the first fastening bracket by using the first swing arm and the first rotating arm, and is linked to the second fastening bracket by using the second swing arm and the second rotating arm, the foldable assembly has a good mechanism tensile resistance capability and a good mechanism extrusion resistance capability.

In some possible implementations, the mounting part has a second through hole, the second through hole has at least two stay positions, the at least two stay positions are arranged in the extension direction of the main shaft, and the second fastener passes through one of the stay positions.

In this implementation, when the second fastener passes through the stay position of the stop member, and the second fastener is threadedly connected to the main shaft, the stop member stays at a position relative to the main shaft, and a relative position relationship between the two is stable and reliable. When the second fastener switches from one of the stay positions of the stop member to the other stay position, a stay position of the stop member relative to the main shaft changes, and the stop member and the main shaft are still fixed in relative to each other after the change. Because the at least two stay positions are arranged in the extension direction of the main shaft, when the second fastener switches between different stay positions, the first stop end surface and the second stop end surface can implement position adjustment in the thickness direction of the main shaft, to adjust the included angle between the first swing arm and the second swing arm in the open state.

In some possible implementations, the second through hole is a kidney-shaped hole or a rectangular hole, and a length direction of the second through hole is parallel to the extension direction of the main shaft.

In an implementation, the length direction of the second through hole is parallel to the extension direction of the main shaft, so that a plurality of stay positions may be arranged in the extension direction of the main shaft, the stop member can be continuously adjusted in the extension direction of the main shaft, the first stop end surface and the second stop end surface can be continuously adjusted in the thickness direction of the main shaft, and the angle between the first swing arm and the second swing arm in the open state can be continuously adjusted.

In some possible implementations, the first elastic member may be an elastic gasket, and the elastic member may be provided with a through hole. The elastic gasket may be made of a metal material. For example, the elastic gasket may be an elastic washer, a plate-form spring, or the like. Alternatively, the elastic gasket may be made of an elastic rubber material or the like. In some other implementations, the first elastic member may include a plurality of stacked pieces. For example, the first elastic member may include an elastic washer and a flat washer that are stacked, and the flat washer may be a metal washer, a rubber washer, or the like. In some other implementations, the first elastic member may alternatively be a spring.

In some possible implementations, the foldable assembly further includes a second elastic member, the second elastic member is mounted on the main shaft and is located on a side that is of the stop member and that faces away from the limiting member, the second elastic member abuts against the mounting part, and an elastic force generated by the second elastic member enables the stop member to abut against the limiting surface. In this case, an abutting relationship between the limiting member and the stop member is stable, and the limiting member can limit the stop member, so that stop effect of the stop member is stable and reliable.

In some possible implementations, the foldable assembly further includes a third rotating shaft, the third rotating shaft has a limiting flange, and the third rotating shaft is inserted into the mounting part of the stop member and the second elastic member. Two ends of the second elastic member respectively abut against the limiting flange of the third rotating shaft and the mounting part of the stop member, and one end that is of the third rotating shaft and that is away from the second elastic member is mounted on the main shaft. The second elastic member is in a compressed state, and an elastic force generated by the second elastic member enables the third rotating shaft to abut against the main shaft, and further enables the stop member to tend to approach the limiting member, so that the stop member is enabled to abut against the limiting member. In some other implementations, no limiting flange may alternatively be disposed on the third rotating shaft, and one end that is of the second elastic member and that is away from the stop member may abut against the main shaft or another structural member. The second elastic member may also be in the compressed state, to generate an elastic force, so that the stop member abuts against the limiting member.

In some other implementations, the foldable assembly may not include the second elastic member, a static friction force may exist between the limiting surface of the limiting member and the stop member, and a static friction force may exist between the stop member and the first elastic member. In this implementation, the foldable assembly balances, by using the static friction force between the limiting member and the stop member, a component force of a supporting force of the limiting member on the stop member in the extension direction of the main shaft, so that a position of the stop member relative to the main shaft is stable, and stop effect of the stop member on the first swing arm and the second swing arm is reliable.

In some possible implementations, the stop member has an adjusting surface, and the adjusting surface is parallel to the limiting surface and is in contact with the limiting surface.

In this implementation, the adjusting surface is in surface contact with the contact surface. Therefore, a contact area between the adjusting surface and the limiting surface is large, and an abutting relationship is stable, and the limiting member can limit the stop member, to ensure that a relative position relationship between the stop member and the main shaft is stable.

In some possible implementations, a friction layer is disposed on the limiting surface and/or a friction layer is disposed on the adjusting surface, and the friction layer is configured to increase a static friction coefficient between the limiting surface and the adjusting surface. For example, the friction layer may be disposed on the limiting surface. The friction layer may be fastened to the limiting surface through assembly, and the friction layer may be made of a material with a high static friction coefficient, for example, a frosted film material, or a film material with a concavo-convex texture. Alternatively, the friction layer may perform surface roughening processing on the limiting surface, so that a surface layer of the limiting surface forms the friction layer. The surface roughening process is the conventional technology, and details are not described herein. Similarly, the friction layer may alternatively be disposed on the adjusting surface. For formation of the friction layer, refer to related descriptions of the friction layer on the limiting surface. Details are not described herein again.

In this implementation, the static friction coefficient between the limiting surface and the adjusting surface is increased, so that the static friction force between the limiting surface and the adjusting surface is increased, and the abutting relationship between the limiting surface and the adjusting surface is stable. When the stop member is subject to acting forces of the first swing arm and the second swing arm, the limiting surface and the adjusting surface of the stop member are not prone to separate from the contact relationship, so that stop reliability can be improved.

In some possible implementations, the limiting member includes a first fastening part, a second fastening part, and a third fastening part, the third fastening part is connected between the first fastening part and the second fastening part, and the third fastening part is fastened to the main shaft. The foldable assembly further includes a first rotating shaft and a second rotating shaft that are mounted on the main shaft, the first rotating shaft is inserted into the first end part of the first swing arm and the first fastening part, and the second rotating shaft is inserted into the first end part of the second swing arm and the second fastening part.

In this implementation, because the limiting member is fastened to the main shaft, the first rotating shaft and the second rotating shaft are mounted on the main shaft, the first rotating shaft is inserted into both the first end part of the first swing arm and the first fastening part, and the second rotating shaft is inserted into both the first end part of the second swing arm and the second fastening part, when the first swing arm and the second swing arm are rotated relative to each other, rotation actions are stable and are not prone to shake, which helps improve reliability of the foldable assembly.

In some possible implementations, the first fastening part is further clamped into the first end part of the first swing arm, and the second fastening part is further clamped into the first end part of the second swing arm. This helps further improve stability of the rotation actions of the first swing arm and the second swing arm.

In some possible implementations, the limiting surface includes a first part and a second part that are coplanar, the first part of the limiting surface is located at the first fastening part, and the second part of the limiting surface is located at the second fastening part.

In this implementation, the first part of the limiting surface is located at the first fastening part of the limiting member, the first fastening part is sleeved on the first rotating shaft, the second part of the limiting surface is located at the second fastening part of the limiting member, and the second fastening part is sleeved on the second rotating shaft. Therefore, when the limiting surface is subject to a force, positions of the first part of the limiting surface and the second part of the limiting surface are stable, the limiting surface and the limiting member are not prone to deform, and structural stability is high. In this way, the limiting member can limit the stop member, to reinforce the stop member, thereby improving stop reliability of the stop member.

In some possible implementations, the first stop part has a first adjusting hole, the second stop part has a second adjusting hole, the first rotating shaft passes through the first adjusting hole, the second rotating shaft passes through the second adjusting hole, both the first adjusting hole and the second adjusting hole are rectangular holes or kidney-shaped holes, and length directions of the first adjusting hole and the second adjusting hole are parallel to the thickness direction of the main shaft.

In this implementation, the first rotating shaft passes through the first adjusting hole of the first stop part of the stop member, and the second rotating shaft passes through the second adjusting hole of the second stop part of the stop member. Therefore, the first rotating shaft and the second rotating shaft may limit the stop member to a specific extent, the position of the stop member is stable, and a risk of deformation is low, thereby improving the stop reliability.

In some possible implementations, the first stop part abuts against the first fastening part, and the second stop part abuts against the second fastening part.

In this implementation, because the first rotating shaft further passes through the first adjusting hole of the first stop part of the stop member, the first stop part of the stop member abuts against the first fastening part of the limiting member, the second rotating shaft further passes through the second adjusting hole of the second stop part of the stop member, and the second stop part of the stop member abuts against the second fastening part of the limiting member, positions of the first stop part and the second stop part of the stop member are stable, the risk of deformation is low, thereby improving the stop reliability.

In some possible implementations, for example, the adjusting surface includes a first part and a second part that are coplanar, the first part of the adjusting surface is located at the first stop part, the first adjusting hole part penetrates through the first part of the adjusting surface, the second part of the adjusting surface is located at the second stop part, and the second adjusting hole part penetrates through the second part of the adjusting surface. The two parts of the limiting surface and the two parts of the adjusting surface are in contact with each other in one-to-one correspondence. Therefore, a contact area between the adjusting surface and the limiting surface is large, and an abutting relationship is stable, and the limiting member can limit the stop member, to ensure that a relative position relationship between the stop member and the main shaft is stable.

In some possible implementations, the first stop surface and the second stop surface are of a symmetric structure.

In this implementation, the first stop surface and the second stop surface are symmetric with respect to a plane, and the plane may be parallel to the thickness direction of the main shaft. In this case, when the first swing arm and the second swing arm are unfolded relative to each other to the open state, the first stop end surface of the first swing arm abuts against the first stop surface, and the second stop end surface of the second swing arm abuts against the second stop surface. A stop process of stopping the first swing arm and the second swing arm by the stop member is easy to control, and stop effect is better. In addition, symmetry between the first stop surface and the second stop surface is also beneficial to reducing processing difficulty of the stop member. The first stop end surface of the first swing arm and the second stop end surface of the second swing arm may be of a symmetric structure or a basically symmetric structure.

In some possible implementations, the foldable assembly further includes a damping assembly, and the damping assembly is connected to the first end part of the first swing arm and the first end part of the second swing arm, and is configured to provide a damping force in a process in which the first swing arm and the second swing arm move relative to each other.

For example, the first end part of the first swing arm includes a plurality of first protrusions and a plurality of second protrusions that are disposed away from each other, and the first end part of the second swing arm includes a plurality of first protrusions and a plurality of second protrusions that are disposed away from each other. The damping assembly includes a first clamping member, a second clamping member, and a first elastic component, a plurality of first bump groups are disposed on the first clamping member, a plurality of second bump groups are disposed on the second clamping member, and the plurality of first bump groups are disposed in one-to-one correspondence with the plurality of second bump groups. Both the first end part of the first swing arm and the first end part of the second swing arm are located between the first clamping member and the second clamping member. The first elastic component is located on a side that is of the second clamping member and that faces away from the first clamping member or on a side that is of the first clamping member and that faces away from the second clamping member. The first elastic component is configured to generate an elastic force, to enable both the first end part of the first swing arm and the first end part of the second swing arm to abut against the first clamping member and the second clamping member. The plurality of first protrusions of the first swing arm cooperate with one of the first bump groups to form a clamping structure, the plurality of second protrusions of the first swing arm cooperate with one of the second bump groups to form a clamping structure, the plurality of first protrusions of the second swing arm cooperate with another first bump group to form a clamping structure, and the plurality of second protrusions of the second swing arm cooperate with another second bump group to form a clamping structure.

In some possible implementations, a synchronization assembly is connected to the first end part of the first swing arm and the first end part of the second swing arm, so that movement of the first swing arm and the second swing arm is synchronous. For example, the first swing arm and the second swing arm are synchronously rotated toward each other to implement folding, or are synchronously rotated away from each other to implement unfolding.

According to a second aspect, this application further provides a foldable apparatus. The foldable apparatus includes a first housing, a second housing, and the foldable assembly according to any one of the foregoing, the first fastening bracket of the foldable assembly is fastened to the first housing, and the second fastening bracket is fastened to the second housing.

According to a third aspect, this application further provides an electronic device, including a flexible display and the foldable apparatus. A part that is of the flexible display and that corresponds to the first housing is fastened to the first housing, a part that is of the flexible display and that corresponds to the second housing is fastened to the second housing, and in a process in which the first housing and the second housing are unfolded relative to each other or folded relative to each other, a part that is of the flexible display and that corresponds to the foldable assembly deforms.

In this implementation, the flexible display can be unfolded or folded along with the foldable apparatus. When the electronic device is in an open state, the flexible display is in an unfolded state, and the flexible display can perform full-screen display, so that the electronic device has a large display area, to improve viewing experience and operation experience of a user. When the electronic device is in a closed state, a planar size of the electronic device is small, so that it is convenient for the user to carry and store the electronic device.

### BRIEF DESCRIPTION OF DRAWINGS

FIG. 1 is a diagram of a structure of an electronic device in an open state according to an embodiment of this application;
FIG. 2 is a diagram of a structure of the electronic device shown in FIG. 1 in an intermediate state;
FIG. 3 is a diagram of a structure of the electronic device shown in FIG. 1 in a closed state;
FIG. 4 is a diagram of a partial exploded structure of the electronic device shown in FIG. 1;
FIG. 5 is a diagram of a partial exploded structure of a foldable assembly shown in FIG. 4;
FIG. 6 is a diagram of a partial exploded structure of the foldable assembly shown in FIG. 5;
FIG. 7 is a diagram of a structure of a bottom connecting assembly shown in FIG. 6;
FIG. 8 is a diagram of a partial exploded structure of the bottom connecting assembly shown in FIG. 7;
FIG. 9 is a diagram of a structure of a connecting structure between a bottom connecting assembly shown in FIG. 5 and a main shaft from another angle;
FIG. 10 is a diagram of a connecting structure between a bottom connecting assembly shown in FIG. 6 and a main inner shaft;
FIG. 11 is a diagram of a structure of an adjustable rotating mechanism shown in FIG. 8 in some embodiments;
FIG. 12 is a schematic exploded view of a partial structure of the adjustable rotating mechanism shown in FIG. 11;
FIG. 13 is a schematic exploded view of another partial structure of the adjustable rotating mechanism shown in FIG. 11;
FIG. 14 is a diagram of structures of a first swing arm and a second swing arm shown in FIG. 12;
FIG. 15A is a diagram of a structure of a limiting member shown in FIG. 12;
FIG. 15B is a diagram of a structure of the limiting member shown in FIG. 15A from another angle;
FIG. 16A is a diagram of a structure of a stop member shown in FIG. 12;
FIG. 16B is a diagram of a structure of the stop member shown in FIG. 16A from another angle;
FIG. 17 is a diagram of a cross-sectional structure that is of the adjustable rotating mechanism shown in FIG. 11 and that is cut along A-A;
FIG. 18 is a diagram of a cross-sectional structure that is of the adjustable rotating mechanism shown in FIG. 11 and that is cut along B-B;
FIG. 19 is a diagram of a cross-sectional structure that is of the adjustable rotating mechanism shown in FIG. 11 and that is cut along C-C;
FIG. 20 is a diagram of a cross-sectional structure that is of the adjustable rotating mechanism shown in FIG. 11 and that is cut along D-D;
FIG. 21A is a diagram of a partial structure of a main inner shaft shown in FIG. 6 in some embodiments;
FIG. 21B is a diagram of a structure of the main inner shaft shown in FIG. 21A from another angle;
FIG. 22 is a diagram of an assembled structure of the adjustable rotating mechanism shown in FIG. 11 and the main inner shaft shown in FIG. 21A;
FIG. 23A is a diagram of a cross-sectional structure that is of the structure shown in FIG. 22 and that is cut along E-E;
FIG. 23B is a diagram of a partial structure of the structure shown in FIG. 23A;
FIG. 24 is a diagram of an assembled structure of a limiting member and a stop member shown in FIG. 22;
FIG. 25 is a diagram of a cross-sectional structure that is of the structure shown in FIG. 22 and that is cut along F-F;
FIG. 26 is a diagram of a cross-sectional structure that is of the structure shown in FIG. 22 and that is cut along G-G;
FIG. 27 is a diagram of a cross-sectional structure that is of the structure shown in FIG. 22 and that is cut along H-H;
FIG. 28 is a diagram of a partial structure of a stop member shown in FIG. 22 in a position adjustment process; and
FIG. 29 is a diagram of a stop member and a limiting member shown in FIG. 22 in some other embodiments.

### DESCRIPTION OF EMBODIMENTS

The following describes embodiments of this application with reference to accompanying drawings in embodiments of this application.

In descriptions of embodiments of this application, unless otherwise explicitly specified and limited, the term "and/or" in this specification describes only an association relationship for describing associated objects and represents that three relationships may exist. For example, A and/or B may represent the following three cases: only A exists, both A and B exist, and only B exists. "A plurality of" refers to two or more than two. For example, "mounting" and "connection" should be understood in a broad sense. For example, "connection" may be a detachable connection or an undetachable connection, or may be a direct connection or an indirect connection implemented through an intermediate medium. "Fastened" means that two parts are connected to each other and a relative position relationship remains unchanged after the two parts are connected to each other. "Rotatable connection" means that two parts are connected to each other and can rotate relative to each other after the two parts are connected to each other. "Slidable connection" means that two parts are connected to each other and can slide relative to each other after the two parts are connected to each other. The orientation terms mentioned in embodiments of this application, for example, "up", "down", "left", "right", "inside", and "outside", are merely directions based on the accompanying drawings. Therefore, the orientation terms are used to better and more clearly describe and understand embodiments of this application, instead of indicating or implying that a specified apparatus or element should have a specific orientation and be constructed and operated in a specific orientation. Therefore, this cannot be understood as a limitation on embodiments of this application. Terms such as "first" and "second" are used only for description purposes, and cannot be understood as implying or implying relative importance or implicitly indicating a quantity of technical features. Therefore, a feature limited by "first" or "second" may explicitly or implicitly include one or more features. An "integral structural member" means that in a process of forming one part of the structural member, the part is connected to another part of the structural member, and does not need to be connected to the another part through reprocessing (such as bonding, welding, or clamping).

This application provides an electronic device. The electronic device includes a foldable apparatus and a flexible display fastened to the foldable apparatus. The foldable apparatus includes a foldable assembly and two housings. The foldable assembly may be unfolded to an open state, may be folded to a closed state, or may be in an intermediate state between the open state and the closed state. The flexible display is unfolded and folded along with the foldable apparatus. The foldable assembly may precisely control an included angle between the two housings in the open state by using an adjustable rotating mechanism, so that the included angle between the two housings adapts to a design dimension of the flexible display, to help reduce a risk that the flexible display is damaged due to pull of the foldable apparatus, improve reliability of the flexible display, and help improve visual experience of a user when the user uses the flexible display.

The electronic device may be a foldable electronic product like a mobile phone, a tablet, a notebook computer, or a wearable device, and the wearable device may be a smart watch, a smart band, or the like. In embodiments of this application, descriptions are provided by using an example in which the electronic device is a mobile phone.

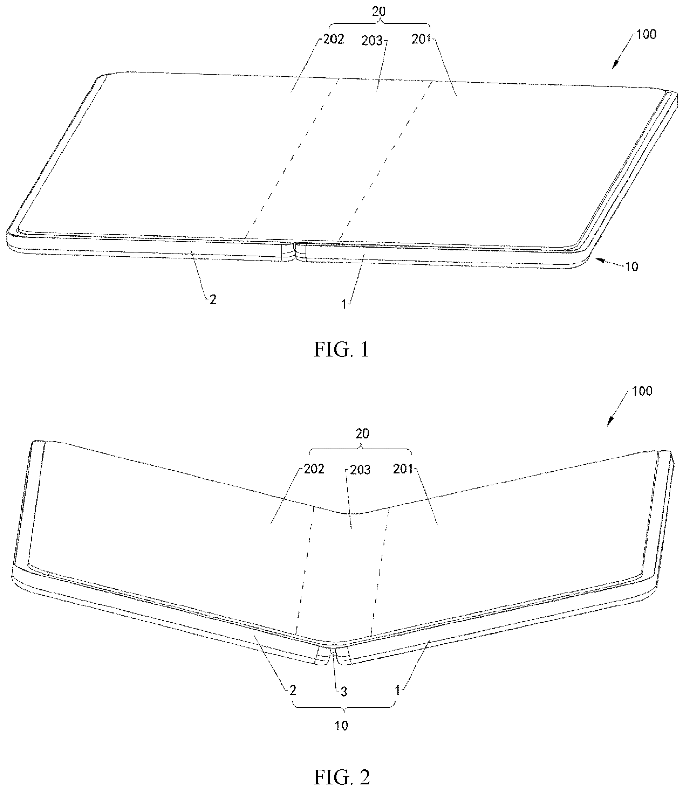

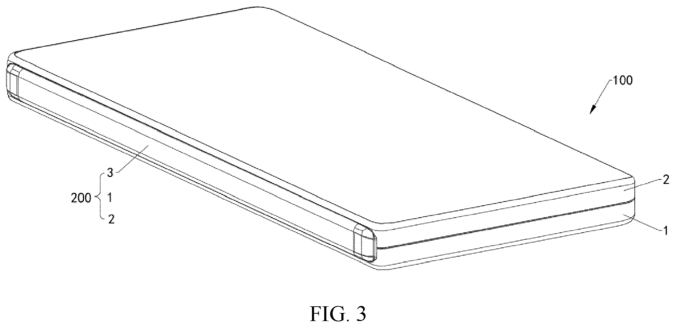

Refer to FIG. 1 to FIG. 3. FIG. 1 is a diagram of a structure of an electronic device 100 in an open state according to an embodiment of this application. FIG. 2 is a diagram of a structure the electronic device 100 shown in FIG. 1 in an intermediate state. FIG. 3 is a diagram of a structure the electronic device 100 shown in FIG. 1 in a closed state.

In some embodiments, the electronic device 100 may include a foldable apparatus 10 and a flexible display 20, and the flexible display 20 is mounted on the foldable apparatus 10. The flexible display 20 is configured to display an image. As shown in FIG. 1, the foldable apparatus 10 may be unfolded to an open state. As shown in FIG. 3, the foldable apparatus 10 may be further folded to a closed state. As shown in FIG. 2, the foldable apparatus 10 may be further unfolded or folded to an intermediate state. The intermediate state may be any state between the open state and the closed state. The flexible display 20 moves with the foldable apparatus 10. Driven by the foldable apparatus 10, the flexible display 20 may also be unfolded or folded, so that the entire electronic device 100 is unfolded to the open state or folded to the closed state. In this embodiment, when the electronic device 100 is in the closed state, the flexible display 20 is located on an inner side of the foldable apparatus 10, and the electronic device 100 is a foldable device whose screen is folded inward. It may be understood that, in some other embodiments, when the electronic device 100 is in the closed state, the flexible display 20 may also be located on an outer side of the foldable apparatus 10.

The foldable apparatus 10 may include a first housing 1, a second housing 2, and a foldable assembly 3, the foldable assembly 3 is connected to the first housing 1 and the second housing 2, and through movement of the foldable assembly 3, the first housing 1 and the second housing 2 can be unfolded relative to each other to the open state or folded relative to each other to the closed state. As shown in FIG. 1, the first housing 1 and the second housing 2 may be unfolded relative to each other to the open state, so that the foldable assembly 3, the foldable apparatus 10, and the electronic device 100 are all in the open state. The flexible display 20 is unfolded along with the foldable apparatus 10. For example, when the foldable apparatus 10 is in the open state, an included angle between the first housing 1 and the second housing 2 may be 180°, and the flexible display 20 is in an unfolded state. As shown in FIG. 3, the first housing 1 and the second housing 2 may be folded relative to each other to the closed state, so that the foldable assembly 3, the foldable apparatus 10, and the electronic device 100 are all in the closed state. The flexible display 20 is folded along with the foldable apparatus 10. For example, when the foldable apparatus 10 is in the closed state, the flexible display 20 may be located between the first housing 1 and the second housing 2. In other words, the flexible display 20 may be located on the inner side of the foldable apparatus 10 and wrapped by the foldable apparatus 10. It may be understood that, when the first housing 1 and the second housing 2 are in the closed state, the included angle between the first housing 1 and the second housing 2 may be approximately 0°. As shown in FIG. 2, the first housing 1 and the second housing 2 may alternatively be unfolded relative to each other or folded relative to each other to the intermediate state, so that the foldable assembly 3, the foldable apparatus 10, and the electronic device 100 are all in the intermediate state. The intermediate state may be any state between the open state and the closed state, and the flexible display 20 also changes accordingly.

In this embodiment, the flexible display 20 can be unfolded or folded along with the foldable apparatus 10. When the electronic device 100 is in the open state, the flexible display 20 is in the unfolded state, and the flexible display 20 can perform full-screen display, so that the electronic device 100 has a large display area, to improve viewing experience and operation experience of a user. When the electronic device 100 is in the closed state, a planar size of the electronic device 100 is small, so that it is convenient for the user to carry and store the electronic device 100.

For example, as shown in FIG. 1, when the foldable apparatus 10 is in the open state, the first housing 1 and the second housing 2 are assembled. It should be noted that, that the first housing 1 and the second housing 2 are assembled may include a case in which the first housing 1 and the second housing 2 partially or completely abut against each other, or may include a case in which there is a small gap between the first housing 1 and the second housing 2. In this embodiment, through assembling of the first housing 1 and the second housing 2, an angle at which the first housing 1 and the second housing 2 are unfolded relative to each other can be limited to some extent, to stop an unfolding action of the foldable apparatus 10, and avoid overfolding of the electronic device 100 in an unfolding process. Therefore, it is ensured that the flexible display 20 is in the unfolded state, so that the flexible display 20 can have a maximum width size when being used by the user. In addition, a force applied on the flexible display 20 can be further reduced, and reliability of the flexible display 20 and the electronic device 100 can be improved.

For example, as shown in FIG. 3, when the foldable apparatus 10 is in the closed state, the first housing 1 and the second housing 2 can be completely closed. It should be noted that, that the first housing 1 and the second housing 2 are closed may include a case in which the first housing 1 and the second housing 2 partially or completely abut against each other, or may include a case in which there is a small gap between the first housing 1 and the second housing 2. In this embodiment, a space for accommodating the flexible display 20 is reserved only in a middle part between the first housing 1 and the second housing 2, and there is no large gap at an edge, to improve a beautification degree of the housing and the electronic device 100, prevent a foreign matter outside the electronic device 100 from entering the electronic device 100 in the closed state, and improve reliability of the electronic device 100.

For example, as shown in FIG. 2, when the foldable apparatus 10 is in the intermediate state, the first housing 1 and the second housing 2 form an included angle, and the intermediate state may be any state between the open state and the closed state, to meet viewing requirements of the user for different viewing angles.

In some embodiments, the electronic device 100 may further include a plurality of components (not shown in the figure). The plurality of components are mainly accommodated inside the first housing 1 and the second housing 2, and some components may alternatively be at least partially mounted on the foldable assembly 3. This is not strictly limited in embodiments of this application. The plurality of components of the electronic device 100 may include but are not limited to a processor, an internal processor, an external storage interface, a universal serial bus (universal serial bus, USB) interface, a charging management module, a power management module, a battery, an antenna, a communication module, a camera module, an audio module, a speaker, a receiver, a microphone, a headset jack, a sensor module, a subscriber identity module (subscriber identity module, SIM) card interface, and one or more hard circuit boards or flexible circuit boards. The electronic device 100 may have more or fewer components than those described above, may combine two or more components, or may have different component configurations. A quantity, types, and positions of modules of the electronic device 100 are not limited in embodiments of this application.

In some embodiments, the flexible display 20 may further be integrated with a display function and a touch sensing function. The display function of the flexible display 20 is used to display a text, an image, a video, and the like, and the touch sensing function of the flexible display 20 is used to detect a touch action of the user, to implement information exchange between a human and a machine. The flexible display 20 may be a liquid crystal display (liquid crystal display, LCD), an organic light-emitting diode (organic light-emitting diode, OLED) display, an active-matrix organic light-emitting diode (active-matrix organic light-emitting diode, AMOLED) display, a mini organic light-emitting diode (mini organic light-emitting diode) display, a micro light-emitting diode (micro light-emitting diode) display, a micro organic light-emitting diode (micro organic light-emitting diode) display, or a quantum dot light-emitting diode (quantum dot light-emitting diode, QLED) display.

In this embodiment, as shown in FIG. 1, the flexible display 20 may include a first part 201, a second part 202, and a third part 203. The first part 201, the third part 203, and the second part 202 are sequentially arranged. A part that is of the flexible display 20 and that corresponds to the first housing 1 is the first part 201, and the first part 201 may be fastened to the first housing 1. A part that is of the flexible display 20 and that corresponds to the second housing 2 is the second part 202, and the second part 202 may be fastened to the second housing 2. A part that is of the flexible display 20 and that corresponds to the foldable assembly 3 is the third part 203. In a process in which the first housing 1 and the second housing 2 are unfolded relative to each other or folded relative to each other, the first housing 1 drives the first part 201 to rotate, the second housing 2 drives the second part 202 to rotate, and the third part 203 deforms under driving of the first part 201, the second part 202, and the foldable apparatus 10. When the flexible display 20 is in the unfolded state, the first part 201, the third part 203, and the second part 202 are all located on a same plane. When the flexible display 20 is in the closed state, the first part 201 and the second part 202 are disposed opposite to each other. The first part 201 and the second part 202 may partially abut against each other, completely abut against each other, or have a small gap. The flexible display 20 is in a U shape on the whole.

It may be understood that, in this embodiment, an example in which the electronic device 100 is of a two-fold structure is used for description. In other words, the electronic device 100 includes two housings that can be bent relative to each other. In some other embodiments, the electronic device 100 may alternatively be a three-fold structure or a more than three-fold structure. In other words, the electronic device 100 includes three or more housings that may be bent relative to each other, and two adjacent housings are connected through the foldable assembly 3. When the electronic device 100 is the three-fold structure or the more than three-fold structure, a structure of the electronic device 100 may be adaptively designed with reference to descriptions of the two-fold structure in this embodiment. Details are not described in this application.

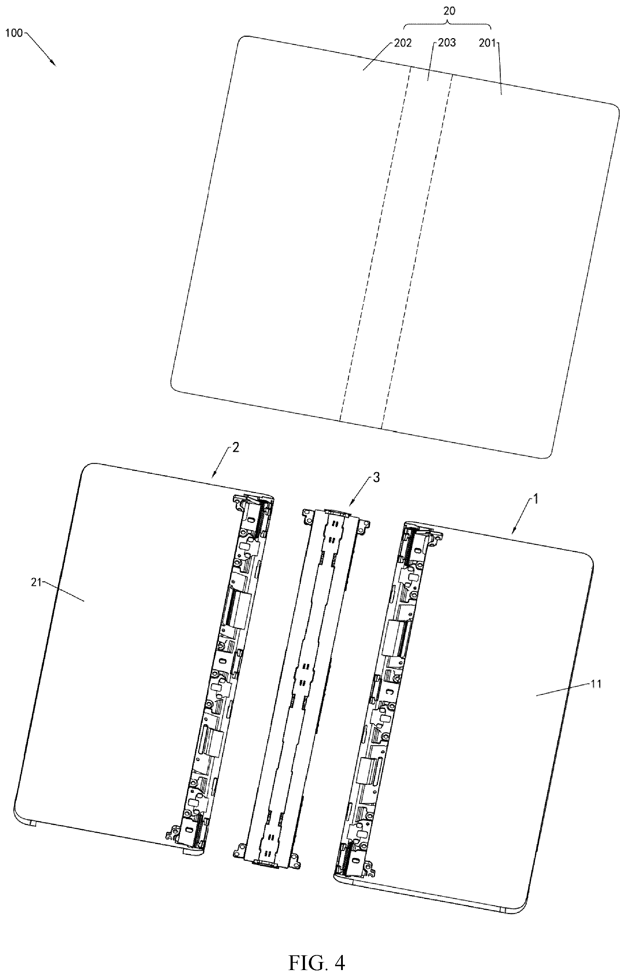

FIG. 4 is a diagram of a partial exploded structure of the electronic device 100 shown in FIG. 1.

In some embodiments, the first housing 1 includes a supporting surface 11 configured to carry the flexible display 20, and the second housing 2 includes a supporting surface 21 configured to carry the flexible display 20. For example, a first part 201 of the flexible display 20 may be bonded to the supporting surface 11 of the first housing 1 by using an adhesive layer, and a second part 202 of the flexible display 20 may be bonded to the supporting surface 21 of the second housing 2 by using an adhesive layer. The adhesive layer used for bonding may be a connected monolithic adhesive layer, may be a point-break adhesive layer, or may be an adhesive layer with a hollow region. A specific solution of the adhesive layer is not strictly limited in this embodiment of this application.

It should be noted that, in this application, an included angle between the supporting surface 11 of the first housing 1 and the supporting surface 21 of the second housing 2 is an included angle between the first housing 1 and the second housing 2. When the electronic device 100 is in an open state, the included angle between the supporting surface 11 of the first housing 1 and the supporting surface 21 of the second housing 2 may be 180°. In this embodiment of this application, specific shapes of the supporting surface 11 of the first housing 1 and the supporting surface 21 of the second housing 2 are not strictly limited. For example, one or more structures such as a notch, a concave, and a protrusion may be disposed on the supporting surface 11 of the first housing 1, and one or more structures such as a notch, a concave, and a protrusion may be disposed on the supporting surface 21 of the second housing 2.

The following describes an implementation structure of the foldable assembly 3 by using an example.

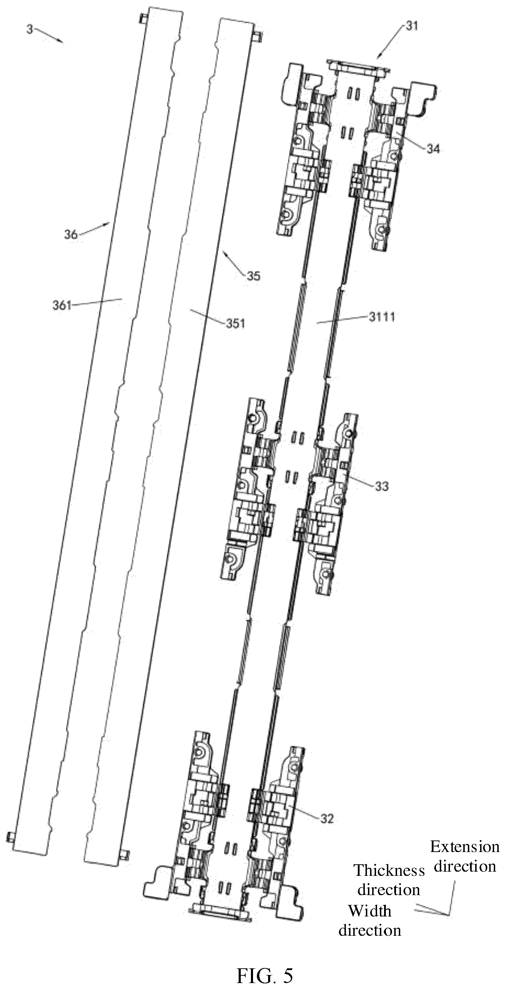

Refer to FIG. 4 and FIG. 5. FIG. 5 is a diagram of a partial exploded structure of the foldable assembly 3 shown in FIG. 4.

In some embodiments, the foldable assembly 3 may include a main shaft 31, a plurality of connecting assemblies (32, 33, and 34), a first supporting plate 35, and a second supporting plate 36.

For example, the plurality of connecting assemblies (32, 33, and 34) are all connected to the main shaft 31, and the plurality of connecting assemblies (32, 33, and 34) can move, and can be unfolded or folded relative to the main shaft 31. The plurality of connecting assemblies (32, 33, and 34) are all further connected between the first housing 1 and the second housing 2 (referring to FIG. 4). When the plurality of connecting assemblies (32, 33, and 34) move relative to the main shaft 31, the first housing 1 and the second housing 2 also move, to implement relative movement between the first housing 1 and the second housing 2.

The first supporting plate 35 and the second supporting plate 36 are both connected to the plurality of connecting assemblies (32, 33, and 34). The first supporting plate 35 and the second supporting plate 36 may move along with the plurality of connecting assemblies (32, 33, and 34), to implement relative unfolding and relative folding. When the first housing 1 and the second housing 2 are in the open state, the first supporting plate 35 and the second supporting plate 36 are respectively located on two sides of the main shaft 31. The first supporting plate 35 includes a first supporting surface 351 disposed to face the flexible display 20, and the second supporting plate 36 includes a second supporting surface 361 disposed to face the flexible display 20. The main shaft 31 includes a main supporting surface 3111 disposed to face the flexible display 20. The first supporting surface 351, the second supporting surface 361, and the main supporting surface 3111 of the main shaft 31 collaborate to support a third part 203 of the flexible display 20 in the open state, so that the flexible display 20 in the open state is flat. The third part 203 of the flexible display 20 is not prone to concave under pressing and touching of a user, which helps improve reliability of the flexible display 20.

In embodiments of this application, as shown in FIG. 5, two ends close to the main shaft 31 are defined as the top and the bottom, and the main shaft 31 has an extension direction, a thickness direction, and a width direction. The extension direction of the main shaft 31 is defined as a direction from the bottom of the main shaft 31 to the top of the main shaft 31. The thickness direction of the main shaft 31 is perpendicular to the extension direction of the main shaft 31 and is perpendicular to the main supporting surface 3111 of the main shaft 31. The width direction of the main shaft 31 is perpendicular to the extension direction of the main shaft 31 and is perpendicular to the thickness direction of the main shaft 31. In FIG. 5, for brevity, in the accompanying drawings, an "extension direction" represents the extension direction of the main shaft 31, a "thickness direction" represents the thickness direction of the main shaft 31, and a "width direction" represents the width direction of the main shaft 31.

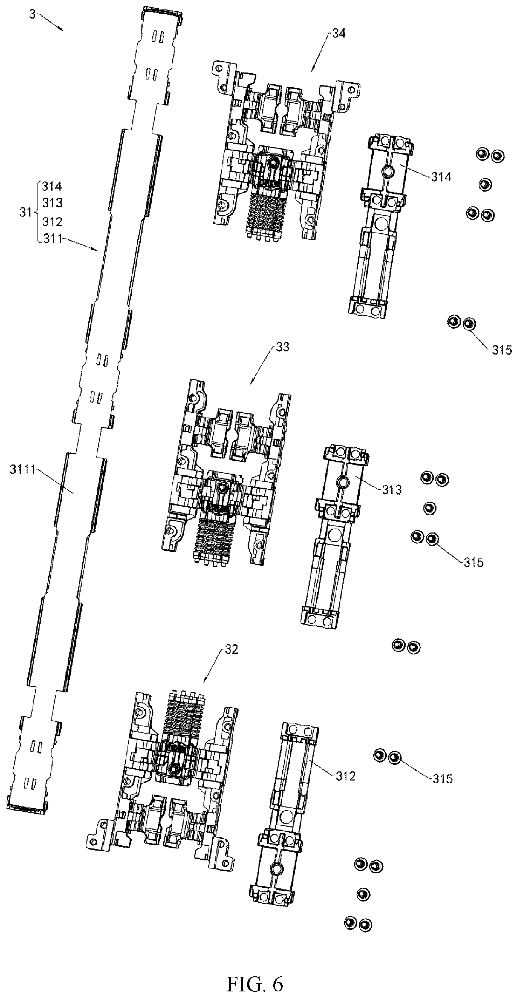

Refer to FIG. 5 and FIG. 6. FIG. 6 is a diagram of a partial exploded structure of the foldable assembly 3 shown in FIG. 5.

For example, there may be three connecting assemblies in the foldable assembly 3, which are respectively a bottom connecting assembly 32, a middle connecting assembly 33, and a top connecting assembly 34. The bottom connecting assembly 32, the middle connecting assembly 33, and the top connecting assembly 34 are arranged at intervals in the extension direction of the main shaft 31. The plurality of connecting assemblies (32, 33, and 34) move in cooperation, so that the first housing 1 and the second housing 2 move smoothly and reliably in a process in which the first housing 1 and the second housing 2 are unfolded or folded relative to each other.

It may be understood that, in some other embodiments, there may be fewer or more connecting assemblies, and the connecting assemblies may also be split or combined. Structures of the connecting assemblies may be the same or slightly different. This is not strictly limited in this application. The following mainly provides descriptions by using the bottom connecting assembly 32 as an example. Both the middle connecting assembly 33 and the top connecting assembly 34 may be designed with reference to the bottom connecting assembly 32.

In some embodiments, the main shaft 31 may include a main inner shaft 311 and a plurality of covers (312, 313, and 314). The main inner shaft 311 may be a continuous structural member, and an extension direction of the main inner shaft 311 corresponds to the extension direction of the main shaft 31. The plurality of covers (312, 313, and 314) are spaced apart in the extension direction of the main shaft 31, and are all fastened to the main inner shaft 311. For example, the plurality of covers (312, 313, 314) may be fastened to the main inner shaft 311 by using a plurality of fasteners 315. The plurality of fasteners 315 may be but are not limited to screws, bolts, or rivets. In this embodiment, the plurality of covers (312, 313, 314) may include a bottom cover 312, a middle cover 313, and a top cover 314. The bottom cover 312 is located at the bottom of the main inner shaft 311, and a bottom mounting space is formed between the bottom cover 312 and the main inner shaft 311. The middle cover 313 is located in the middle of the main inner shaft 311, and a middle mounting space is formed between the middle cover 313 and the main inner shaft 311. The top cover 314 is located at the top of the main inner shaft 311, and a top mounting space is formed between the top cover 314 and the main inner shaft 311. The plurality of connecting assemblies (32, 33, 34) are correspondingly mounted in the mounting space. For example, in this embodiment, the bottom connecting assembly 32 is mounted in the bottom mounting space, the middle connecting assembly 33 is mounted in the middle mounting space, and the top connecting assembly 34 is mounted in the top mounting space. It may be understood that a quantity and structures of the plurality of covers (312, 313, and 314) are disposed in a correspondence with the plurality of connecting assemblies (32, 33, and 34).

For example, the bottom cover 312 may be approximately of a cover structure in which the middle is recessed and two sides are raised. A plurality of cooperation structures may be disposed on a surface that is of the bottom cover 312 and that faces the main inner shaft 311, and the plurality of cooperation structures are configured to cooperate with the main inner shaft 311, to form the bottom mounting space. The plurality of cooperation structures may include structures such as a groove, an opening, a protrusion, and a notch. The middle cover 313 and the top cover 314 may be designed with reference to the bottom cover 312. The middle cover 313 and the top cover 314 are not described in this embodiment of this application.

For example, a main supporting surface 3111 is formed on a side that is of the main inner shaft 311 and that faces away from the plurality of covers (312, 313, and 314), and the main supporting surface 3111 may provide a flat supporting environment in the open state. It may be understood that the main supporting surface 3111 of the main inner shaft 311 is the main supporting surface 3111 of the main shaft 31. The main supporting surface 3111 may be a plane, and the main supporting surface 3111 in a plane state may directly provide a flat supporting environment for the third part 203 of the flexible display 20 in the open state. In some other embodiments, the main supporting surface 3111 may alternatively be a curved surface or a plane in which a plurality of segments are connected, and is configured to support the third part 203 of the flexible display 20, which has different forms, that is of the electronic device 100 and that is in the open state. This is not strictly limited in this application.

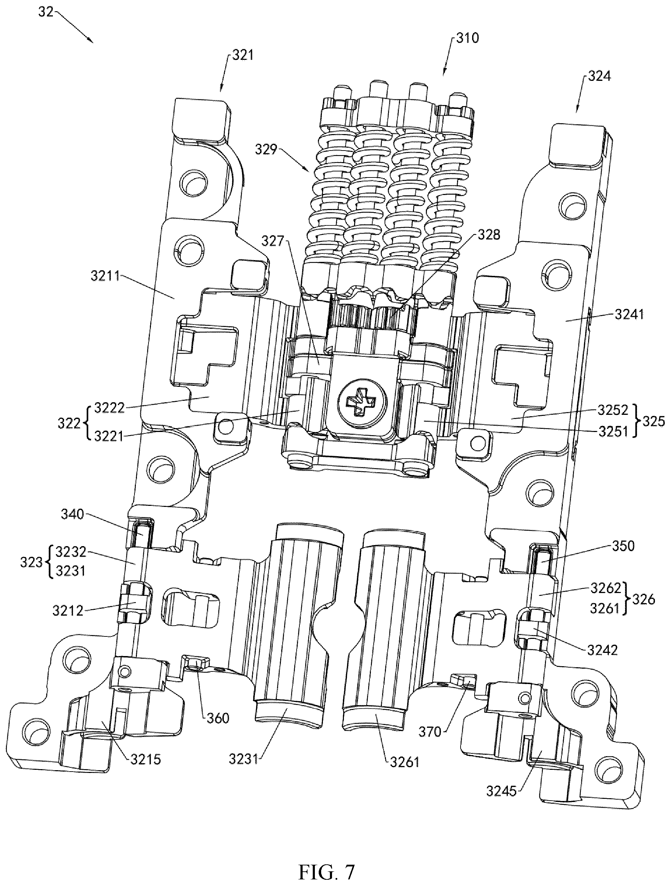

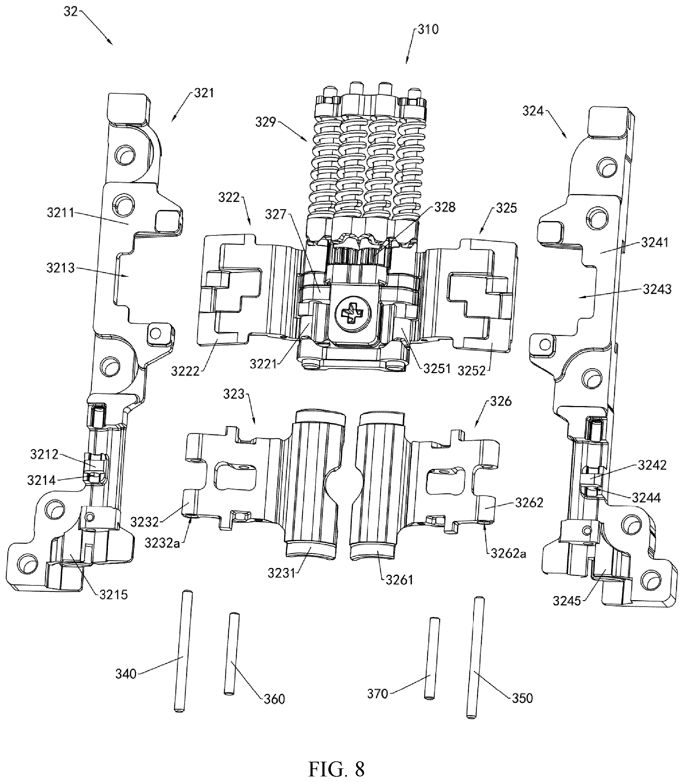

Refer to FIG. 7 and FIG. 8. FIG. 7 is a diagram of a structure of the bottom connecting assembly 32 shown in FIG. 6. FIG. 8 is a diagram of a partial exploded structure of the bottom connecting assembly 32 shown in FIG. 7. The bottom connecting assembly 32 in FIG. 7 is obtained after the bottom connecting assembly 32 shown in FIG. 6 is horizontally flipped.

In some embodiments, the bottom connecting assembly 32 may include a first fastening bracket 321, a first swing arm 322, a first rotating arm 323, a second fastening bracket 324, a second swing arm 325, a second rotating arm 326, a stop adjusting assembly 327, a synchronization assembly 328, and a damping assembly 329. The bottom connecting assembly 32 may further include a plurality of rotating shafts (340, 350, 360, and 370), and the plurality of rotating shafts (340, 350, 360, and 370) are configured to be inserted into another component of the bottom connecting assembly 32, so that components are connected. The first swing arm 322, the second swing arm 325, the stop adjusting assembly 327, the synchronization assembly 328, and the damping assembly 329 may be assembled into a modular adjustable rotating mechanism 310, to simplify assembly processes of the foldable assembly 3 and the electronic device 100.

The first fastening bracket 321 is configured to be fastened to the first housing 1, and is further configured to connect to the plurality of components of the bottom connecting assembly 32 and the first supporting plate 35. The first fastening bracket 321 may include a plurality of cooperation structures, for example, a structure that cooperates with the first housing 1, a structure that cooperates with the first swing arm 322, a structure that cooperates with the first rotating arm 323, and a structure that cooperates with the first supporting plate 35. For example, the first fastening bracket 321 includes a first sliding part 3211 and a first rotating part 3212, the first sliding part 3211 may be provided with a sliding groove 3213, and the first rotating part 3212 may be provided with a rotating shaft hole 3214.

The second fastening bracket 324 is configured to be fastened to the second housing 2, and is further configured to connect to the plurality of components of the bottom connecting assembly 32 and the second supporting plate 36. The second fastening bracket 324 may include a plurality of cooperation structures, for example, a structure that cooperates with the second housing 2, a structure that cooperates with the second swing arm 325, a structure that cooperates with the second rotating arm 326, and a structure that cooperates with the second supporting plate 36. For example, the second fastening bracket 324 includes a second sliding part 3241 and a second rotating part 3242, the second sliding part 3241 may be provided with a sliding groove 3243, and the second rotating part 3242 may be provided with a rotating shaft hole 3244.

The first swing arm 322 may include a first end part 3221 and a second end part 3222. The first end part 3221 of the first swing arm 322 may be a rotating end, and the second end part 3222 of the first swing arm 322 may be a sliding end. The second end part 3222 of the first swing arm 322 may be mounted on the first sliding part 3211, to be slidably connected to the first fastening bracket 321. The second end part 3222 of the first swing arm 322 may include a structure like a sliding block, a sliding plate, or a sliding rail, to cooperate with the sliding groove 3213 of the first sliding part 3211 to implement slidable connection. In some other embodiments, the second end part 3222 of the first swing arm 322 is provided with a sliding groove, the first sliding part 3211 is provided with a structure like a sliding block, a sliding plate, or a sliding rail, and the second end part 3222 of the first swing arm 322 may still be slidably connected to the first sliding part 3211. An implementation structure of the slidable connection between the second end part 3222 of the first swing arm 322 and the first sliding part 3211 is not strictly limited in this embodiment of this application.

The second swing arm 325 may include a first end part 3251 and a second end part 3252. The first end part 3251 of the second swing arm 325 may be a rotating end, and the second end part 3252 of the second swing arm 325 may be a sliding end. The second end part 3252 of the second swing arm 325 may be mounted on the second sliding part 3241, to be slidably connected to the second fastening bracket 324. The second end part 3252 of the second swing arm 325 may include a structure like a sliding block, a sliding plate, or a sliding rail, to cooperate with the sliding groove 3243 of the second sliding part 3241 to implement slidable connection. In some other embodiments, the second end part 3252 of the second swing arm 325 is provided with a sliding groove, the second sliding part 3241 is provided with a structure like a sliding block, a sliding plate, or a sliding rail, and the second end part 3252 of the second swing arm 325 may still be slidably connected to the second sliding part 3241. An implementation structure of the slidable connection between the second end part 3252 of the second swing arm 325 and the second sliding part 3241 is not strictly limited in this embodiment of this application.

The stop adjusting assembly 327 is connected to the first end part 3221 of the first swing arm 322 and the first end part 3251 of the second swing arm 325, and is configured to stop unfolding positions of the first swing arm 322 and the second swing arm 325. An implementation structure of the stop adjusting assembly 327 is described in the following embodiments, and is not described herein.

The synchronization assembly 328 is connected to the first end part 3221 of the first swing arm 322 and the first end part 3251 of the second swing arm 325, so that movement of the first swing arm 322 and the second swing arm 325 is synchronous. For example, the first swing arm 322 and the second swing arm 325 are synchronously rotated toward each other to implement folding, or are synchronously rotated away from each other to implement unfolding. An implementation structure of the synchronization assembly 328 is described in the following embodiments, and is not described herein.

The damping assembly 329 is connected to the first end part 3221 of the first swing arm 322 and the first end part 3251 of the second swing arm 325, and is configured to provide a damping force in a process in which the first swing arm 322 and the second swing arm 325 move relative to each other. An implementation structure of the damping assembly 329 is described in the following embodiments, and is not described herein.

The first rotating arm 323 may include a first end part 3231 and a second end part 3232. Both the first end part 3231 of the first rotating arm 323 and the second end part 3232 of the first rotating arm 323 may be rotating ends. The first end part 3231 of the first rotating arm 323 may include an arc-shaped arm. The second end part 3232 of the first rotating arm 323 is rotatably connected to the first rotating part 3212, to be rotatably connected to the first fastening bracket 321. For example, the second end part 3232 of the first rotating arm 323 may be provided with a rotating shaft hole 3232a, and a rotating shaft 340 is inserted into the rotating shaft hole 3232a and the rotating shaft hole 3214 of the first rotating part 3212.

The second rotating arm 326 may include a first end part 3261 and a second end part 3262. Both the first end part 3261 of the second rotating arm 326 and the second end part 3262 of the second rotating arm 326 may be rotating ends. The first end part 3261 of the second rotating arm 326 may include an arc-shaped arm. The second end part 3262 of the second rotating arm 326 is rotatably connected to the second rotating part 3242, to be rotatably connected to the second fastening bracket 324. For example, the second end part 3262 of the second rotating arm 326 may be provided with a rotating shaft hole 3262a, and a rotating shaft 350 is inserted into the rotating shaft hole 3262a and the rotating shaft hole 3244 of the second rotating part 3242.

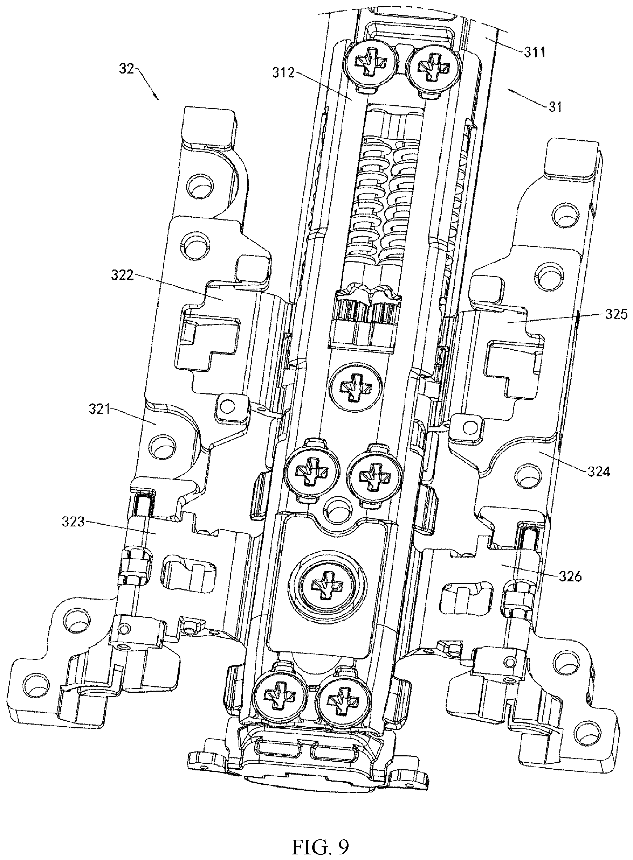

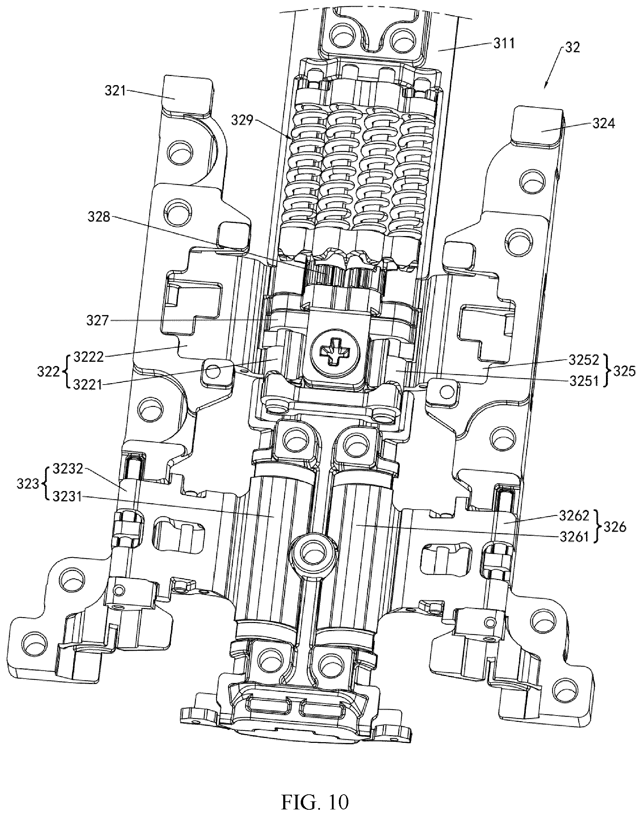

Refer to FIG. 7, FIG. 9, and FIG. 10. FIG. 9 is a diagram of a structure of a connecting structure between the bottom connecting assembly 32 and the main shaft 31 shown in FIG. 5 from another angle. FIG. 10 is a diagram of a connecting structure between the bottom connecting assembly 32 and the main inner shaft 311 shown in FIG. 6.

In some embodiments, the bottom connecting assembly 32 may be mounted on the main shaft 31. One partial structure of the bottom connecting assembly 32 may be located inside the main shaft 31, for example, may be located between the main inner shaft 311 and the bottom cover 312, and the other partial structure of the bottom connecting assembly 32 may be located outside the main shaft 31.

Both the first end part 3221 of the first swing arm 322 and the first end part 3251 of the second swing arm 325 are mounted inside the main shaft 31, and both the second end part 3222 of the first swing arm 322 and the second end part 3252 of the second swing arm 325 are located outside the main shaft 31. The first end part 3221 of the first swing arm 322 is rotatably connected to the main shaft 31, the first end part 3251 of the second swing arm 325 is rotatably connected to the main shaft 31, and the second swing arm 325 and the first swing arm 322 can be rotated relative to the main shaft 31 to be unfolded or folded relative to each other. The stop adjusting assembly 327, the synchronization assembly 328, and the damping assembly 329 are all mounted inside the main shaft 31.

For example, the first end part 3231 of the first rotating arm 323 and the first end part 3261 of the second rotating arm 326 are mounted inside the main shaft 31, and the second end part 3232 of the first rotating arm 323 and the second end part 3262 of the second rotating arm 326 are located outside the main shaft 31. The first end part 3231 of the first rotating arm 323 is rotatably connected to the main shaft 31, the second end part 3262 of the second rotating arm 326 is rotatably connected to the main shaft 31, and the first rotating arm 323 and the second rotating arm 326 can be rotated relative to the main shaft 31 to be unfolded or folded relative to each other.

The first end part 3221 of the first swing arm 322 is rotated around a first rotating axis (not shown in the figure) relative to the main shaft 31, the first end part 3251 of the second swing arm 325 is rotated around a second rotating axis (not shown in the figure) relative to the main shaft 31, the first end part 3231 of the first rotating arm 323 is rotated around a third rotating axis (not shown in the figure) relative to the main shaft 31, and the first end part 3261 of the second rotating arm 326 is rotated around a fourth rotating axis (not shown in the figure) relative to the main shaft 31. The first rotating axis, the second rotating axis, the third rotating axis, and the fourth rotating axis are all parallel to the extension direction of the main shaft 31, and do not coincide with each other.

In the electronic device 100, the first fastening bracket 321 is fastened to the first housing 1, and the second fastening bracket 324 is fastened to the second housing 2. When the first housing 1 and the second housing 2 are unfolded or folded relative to each other, the first fastening bracket 321 moves along with the first housing 1, the second fastening bracket 324 moves along with the second housing 2, the first fastening bracket 321 and the second fastening bracket 324 are rotated relative to each other, and the foldable assembly 3 is unfolded or folded.

The first swing arm 322 is rotatably connected to the main shaft 31 and slidably connected to the first fastening bracket 321 to form a connecting rod slider structure. The first rotating arm 323 is rotatably connected to the main shaft 31 and rotatably connected to the first fastening bracket 321 to form a connecting rod structure. The second swing arm 325 is rotatably connected to the main shaft 31 and slidably connected to the second fastening bracket 324 to form a connecting rod slider structure. The second rotating arm 326 is rotatably connected to the main shaft 31 and rotatably connected to the second fastening bracket 324 to form a connecting rod structure. The foldable assembly 3 implements, by using the connecting rod slider structure and the connecting structure, a process in which the foldable assembly 3 is relatively unfolded or folded. A quantity of components of the foldable assembly is small, a cooperation relationship and a cooperation position are simple, and the components are easy to be manufactured and assembled, which facilitates mass production. In addition, because the main shaft 31 is linked to the first fastening bracket 321 by using the first swing arm 322 and the first rotating arm 323, and is linked to the second fastening bracket 324 by using the second swing arm 325 and the second rotating arm 326, the foldable assembly 3 has a good mechanism tensile resistance capability and a good mechanism extrusion resistance capability.

When the first housing 1 and the second housing 2 are rotated relative to each other to the open state, the first fastening bracket 321 and the second fastening bracket 324 are also rotated relative to each other to the open state. In this way, the first swing arm 322 and the second swing arm 325 are also rotated relative to each other to the open state. In this case, the first end part 3221 of the first swing arm 322 and the first end part 3251 of the second swing arm 325 abut against the stop adjusting assembly 327. The stop adjusting assembly 327 is configured to prevent an angle at which the first swing arm 322 and the second swing arm 325 are rotated relative to each other from exceeding a preset value, to prevent an angle at which the first fastening bracket 321 and the second fastening bracket 324 are rotated relative to each other from exceeding a preset value, and prevent an angle at which the first housing 1 and the second housing 2 are rotated relative to each other from exceeding a preset value. Therefore, the stop adjusting assembly 327 stops the first swing arm 322 and the second swing arm 325, to prevent the first housing 1 and the second housing 2 from being overfolded when the electronic device 100 is in the open state. This prevents the flexible display 20 from being pulled by the first housing 1 and the second housing 2, improves reliability of the flexible display 20, and prolongs a service life of the flexible display 20. In addition, in this application, due to stop effect of the stop adjusting assembly 327, the included angle between the first housing 1 and the second housing 2 in the open state is equal to the preset value. For example, when the preset value is 180°, the foldable apparatus 10 can provide a flat supporting environment for the flexible display 20, and flatness of the flexible display 20 is good. This helps optimize overall light and shadow of the electronic device 100.

In the foregoing embodiment, the synchronization assembly 328 is configured to keep movement of the first swing arm 322 and the second swing arm 325 synchronous, so that movement of the first housing 1 and the second housing 2 is synchronous. For example, the first housing 1 and the second housing 2 are synchronously rotated toward each other to implement folding, or are synchronously rotated away from each other to implement unfolding, to improve user experience.

In the foregoing embodiment, the damping assembly 329 is mounted on the main shaft 31, and is disposed between the first swing arm 322 and the second swing arm 325, to implement damping effect on the first swing arm 322 and the second swing arm 325, that is, implement damping effect on the first housing 1 and the second housing 2 in a movement process, to provide a hand feeling of the electronic device 100 in an unfolding process and a folding process, and improve user experience. In some other embodiments, two damping assemblies 329 may exist, and the two damping assemblies are respectively disposed at a position at which the first fastening bracket 321 is slidably connected to the second end part 3222 of the first swing arm 322 and a position at which the second fastening bracket 324 is slidably connected to the second end part 3252 of the second swing arm 325, to implement damping effect on the first swing arm 322 and the second swing arm 325.

In some other embodiments, the foldable assembly 3 may not include the first rotating arm and the second rotating arm, but include a first connecting arm and a second connecting arm. A first end part of the first connecting arm is rotatably connected to the main shaft, a second end part of the first connecting arm is slidably connected to the first fastening bracket, and a sliding direction of the second end part of the first connecting arm relative to the first fastening bracket intersects a sliding direction of the second end part of the first swing arm relative to the first fastening bracket. A first end part of the second connecting arm is rotatably connected to the main shaft, a second end part of the second connecting arm is slidably connected to the second fastening bracket, and a sliding direction of the second end part of the second connecting arm relative to the second fastening bracket intersects a sliding direction of the second end part of the second swing arm relative to the second fastening bracket.

Refer to FIG. 7 and FIG. 8 again. The bottom connecting assembly 32 further includes a plurality of structures or components that cooperate with the first supporting plate 35 and the second supporting plate 36 (referring to FIG. 5). For example, the first fastening bracket 321 may further include a third rotating part 3215 that cooperates with the first supporting plate 35, and the third rotating part 3215 is rotatably connected to the first supporting plate 35. For example, the third rotating part 3215 may include an arc-shaped groove, to cooperate with an arc-shaped arm (not shown in the figure) on the first supporting plate 35 to form a rotatable connecting structure using a virtual shaft. A rotating shaft 360 may be inserted into the middle of the first rotating arm 323, and cooperate with the first supporting plate 35. For example, the rotating shaft 360 may be further inserted into a sliding groove (not shown in the figure) of the first supporting plate 35, so that the first rotating arm 323 is slidably connected to the first supporting plate 35. For example, the second fastening bracket 324 may further include a fourth rotating part 3245 that cooperates with the second supporting plate 36, and the fourth rotating part 3245 is rotatably connected to the second supporting plate 36. For example, the fourth rotating part 3245 may include an arc-shaped groove, to cooperate with an arc-shaped arm (not shown in the figure) on the second supporting plate 36 to form a rotatable connecting structure using a virtual shaft. A rotating shaft 370 may be inserted into the middle of the second rotating arm 326, and cooperate with the second supporting plate 36. For example, the rotating shaft 370 may be further inserted into a sliding groove (not shown in the figure) of the second supporting plate 36, so that the second rotating arm 326 is slidably connected to the second supporting plate 36.

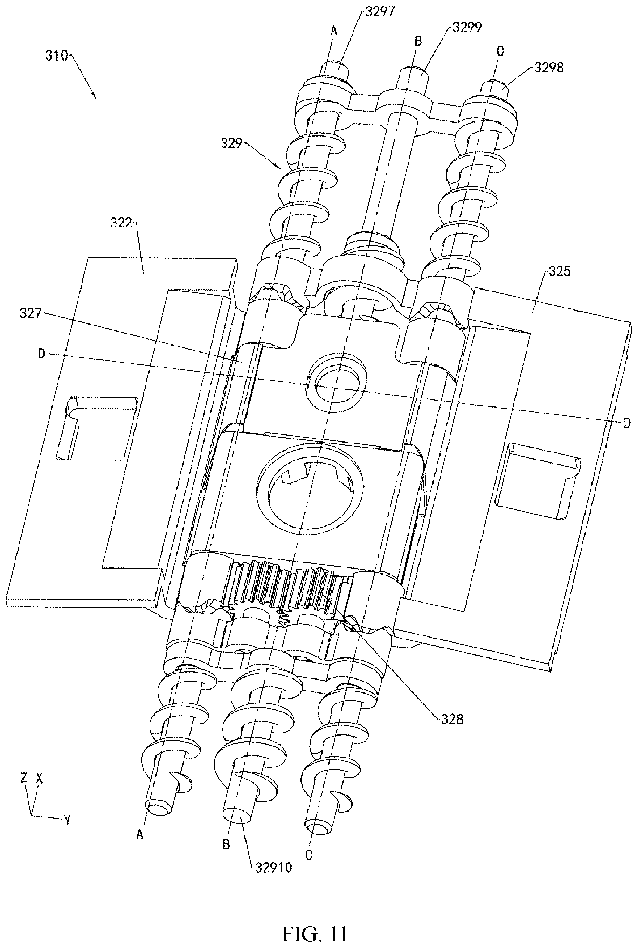

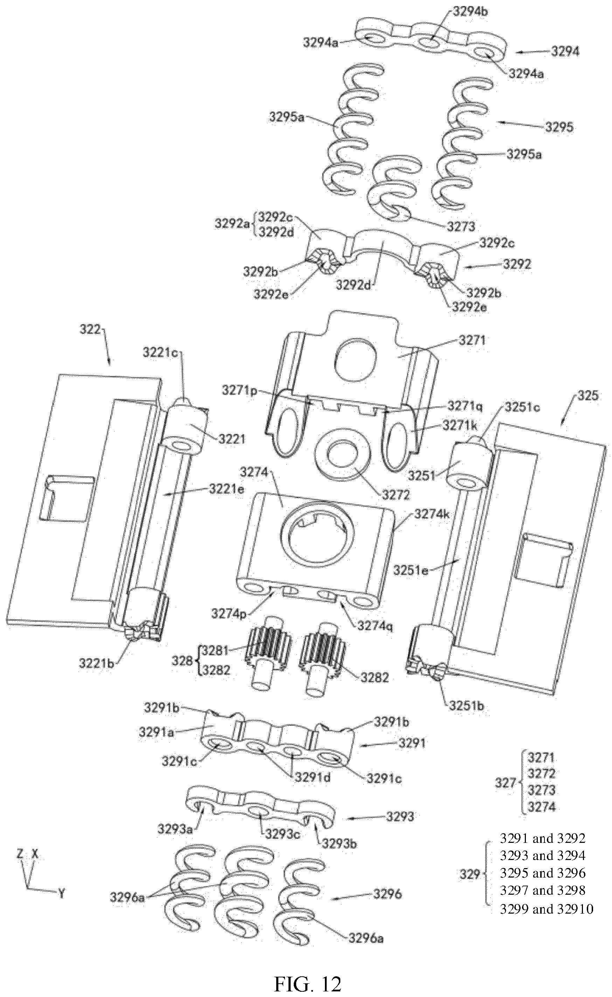

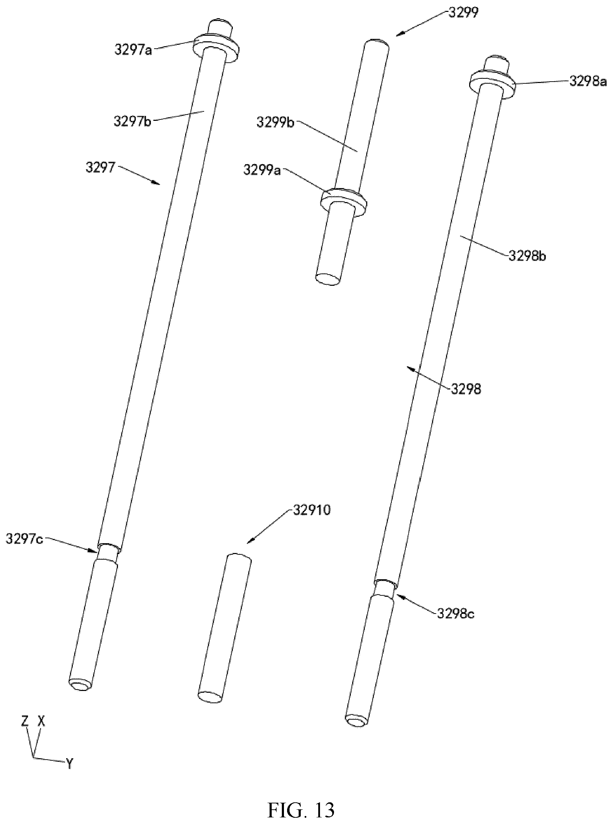

Refer to FIG. 11 to FIG. 13. FIG. 11 is a diagram of a structure of the adjustable rotating mechanism 310 shown in FIG. 8 in some embodiments. FIG. 12 is a schematic exploded view of a partial structure of the adjustable rotating mechanism 310 shown in FIG. 11. FIG. 13 is a schematic exploded view of another partial structure of the adjustable rotating mechanism 310 shown in FIG. 11. The adjustable rotating mechanism 310 in this embodiment includes all or most of the technical features of the adjustable rotating mechanism 310 described above. The following mainly describes differences between the two adjustable rotating mechanisms, and same content is not described herein again.

In some embodiments, the adjustable rotating mechanism 310 includes the first swing arm 322, the second swing arm 325, the stop adjusting assembly 327, the synchronization assembly 328, and the damping assembly 329. The adjustable rotating mechanism 310 may be a modular structure. For ease of description in the following, it is defined that the adjustable rotating mechanism 310 has a first direction X, a second direction Y, and a third direction Z. The second direction Y is perpendicular to the first direction X, and the third direction Z is perpendicular to the first direction X and the second direction Y. The first swing arm 322 and the second swing arm 325 are arranged in the second direction Y.

For example, the stop adjusting assembly 327 may include a stop member 3271, a first fastener (not shown in the figure), a first elastic member 3272, a second elastic member 3273, a limiting member 3274, and a second fastener (not shown in the figure). The synchronization assembly 328 may include a plurality of synchronization gears. In this embodiment, an example in which there are two synchronization gears is used for illustration. For example, the synchronization assembly 328 includes a first synchronization gear 3281 and a second synchronization gear 3282. It may be understood that, in some other embodiments, there may be more synchronization gears, for example, more than three synchronization gears. The damping assembly 329 may include a first clamping member 3291, a second clamping member 3292, a third clamping member 3293, a fourth clamping member 3294, a first elastic component 3295, a second elastic component 3296, a first rotating shaft 3297, a second rotating shaft 3298, a third rotating shaft 3299, and a fourth rotating shaft 32910. The first rotating shaft 3297, the second rotating shaft 3298, the third rotating shaft 3299, and the fourth rotating shaft 32910 may be inserted into another structure of the adjustable rotating mechanism 310, to be assembled into the modular structure.

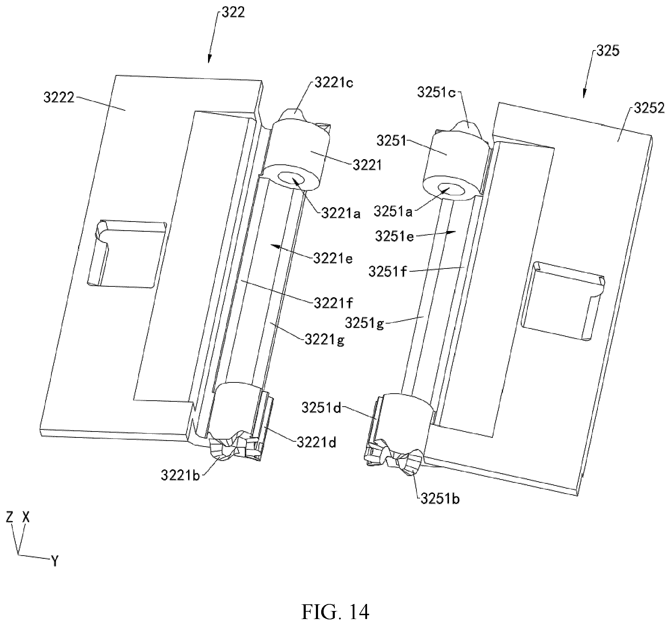

FIG. 14 is a diagram of structures of the first swing arm 322 and the second swing arm 325 shown in FIG. 12.

In some embodiments, the first swing arm 322 may include the first end part 3221 and the second end part 3222. The first end part 3221 of the first swing arm 322 is provided with a rotating shaft hole 3221a, and the rotating shaft hole 3221a penetrates through two ends of the first end part 3221 of the first swing arm 322. An axial direction of the rotating shaft hole 3221a of the first swing arm 322 may be parallel to the first direction X. The first end part 3221 of the first swing arm 322 is further provided with a structure that cooperates with the synchronization assembly 328 and the damping assembly 329. For example, the first end part 3221 of the first swing arm 322 may include a plurality of first protrusions 3221b, a plurality of second protrusions 3221c, and a plurality of engagement teeth 3221d. The plurality of first protrusions 3221b and the plurality of second protrusions 3221c are disposed away from each other at the two ends of the first end part 3221 of the first swing arm 322. The plurality of first protrusions 3221b are arranged in an annular shape and are spaced away from each other, and the plurality of first protrusions 3221b are arranged around the rotating shaft hole 3221a of the first end part 3221 of the first swing arm 322. The plurality of second protrusions 3221c are arranged in an annular shape and are spaced away from each other, and the plurality of second protrusions 3221c are arranged around the rotating shaft hole 3221a of the first end part 3221 of the first swing arm 322. The plurality of engagement teeth 3221d may be located on a side surface of the first end part 3221 of the first swing arm 322. The plurality of engagement teeth 3221d may be close to the plurality of first protrusions 3221b and far away from the plurality of second protrusions 3221c.

The first end part 3221 of the first swing arm 322 may be further provided with a first avoidance space 3221e, and the first avoidance space 3221e may be located in the middle of the first end part 3221 of the first swing arm 322. The first avoidance space 3221e may communicate with the rotating shaft hole 3221a, so that the middle of the first end part 3221 of the first swing arm 322 is approximately a C-shaped structure. The first swing arm 322 further includes a first stop end surface 3221f, and the first stop end surface 3221f forms one end surface of the C-shaped structure. The first swing arm 322 may further include a first avoidance end surface 3221g, and the first avoidance end surface 3221g may form the other end surface of the C-shaped structure. **In** this case, the first stop end surface 3221f and the first avoidance end surface 3221g each are a part of a wall surface of the first avoidance space 3221e.

The first swing arm 322 may be an integral structural member, to have high structural strength. For example, the first swing arm 322 may be formed by using a metal injection process or another process. This is not strictly limited in this application.

For example, the second swing arm 325 may include the first end part 3251 and the second end part 3252. The first end part 3251 of the second swing arm 325 is provided with a rotating shaft hole 3251a, and the rotating shaft hole 3251a penetrates through two ends of the first end part 3251 of the second swing arm 325. An axial direction of the rotating shaft hole 3251a of the second swing arm 325 may be parallel to the first direction X. The first end part 3251 of the second swing arm 325 is further provided with a structure that cooperates with the synchronization assembly 328 and the damping assembly 329. For example, the first end part 3251 of the second swing arm 325 may include a plurality of first protrusions 3251b, a plurality of second protrusions 3251c, and a plurality of engagement teeth 3251d. The plurality of first protrusions 3251b and the plurality of second protrusions 3251c are disposed away from each other at two ends of the second swing arm 325. The plurality of first protrusions 3251b are arranged in an annular shape and are spaced away from each other, and the plurality of first protrusions 3251b are arranged around the rotating shaft hole 3251a of the first end part 3251 of the second swing arm 325. The plurality of second protrusions 3251c are arranged in an annular shape and are spaced away from each other, and the plurality of second protrusions 3251c are arranged around the rotating shaft hole 3251a of the first end part 3251 of the second swing arm 325. The plurality of engagement teeth 3251d may be located on a side surface of the first end part 3251 of the second swing arm 325. The plurality of engagement teeth 3251d may be close to the plurality of first protrusions 3251b and far away from the plurality of second protrusions 3251c.

For example, the first end part 3251 of the second swing arm 325 may be further provided with a second avoidance space 3251e, and the second avoidance space 3251e is located in the middle of the first end part 3251 of the second swing arm 325. The second avoidance space 3251e may communicate with the rotating shaft hole 3251a, so that the middle of the first end part 3251 of the second swing arm 325 is approximately a C-shaped structure. The second swing arm 325 further includes a second stop end surface 3251f, and the second stop end surface 3251f forms one end surface of the C-shaped structure. The second swing arm 325 may further include a second avoidance end surface 3251g, and the second avoidance end surface 3251g may form the other end surface of the C-shaped structure. In this case, the second stop end surface 3251f and the second avoidance end surface 3251g each are a part of a wall surface of the second avoidance space 3251e.

The second swing arm 325 may be an integral structural member, to have high structural strength. For example, the second swing arm 325 may be formed by using a metal injection process or another process. This is not strictly limited in this application.

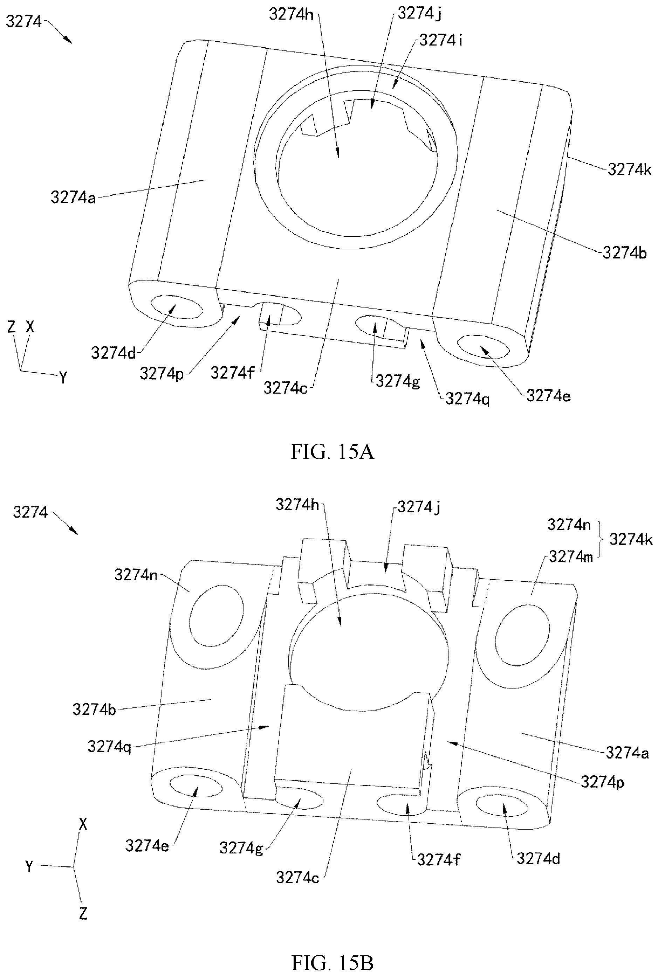

Refer to FIG. 15A and FIG. 15B. FIG. 15A is a diagram of a structure of the limiting member 3274 shown in FIG. 12. FIG. 15B is a diagram of a structure of the limiting member 3274 shown in FIG. 15A from another angle. FIG. 15B is a diagram of a structure of the limiting member 3274 shown in FIG. 15A after the limiting member 3274 is horizontally flipped.

In some embodiments, the limiting member 3274 includes a first fastening part 3274a, a second fastening part 3274b, and a third fastening part 3274c that are fastened to each other, and the third fastening part 3274c is connected between the first fastening part 3274a and the second fastening part 3274b. In embodiments of this application, that a component A is connected between a component B and a component C means that the component A is located between the component B and the component C, and is connected to the component B and the component C. The first fastening part 3274a, the third fastening part 3274c, and the second fastening part 3274b may be arranged in the second direction Y. The limiting member 3274 may be an integral structural member, to have high structural strength. For example, the limiting member 3274 may be made of a metal material and formed by using a metal injection process or another process. In some other embodiments, the limiting member 3274 may alternatively be made of a plastic material and formed by using an injection molding process or another process.

The first fastening part 3274a is provided with a first rotating shaft hole 3274d, the second fastening part 3274b is provided with a second rotating shaft hole 3274e, and an axial direction of the second rotating shaft hole 3274e is parallel to an axial direction of the first rotating shaft hole 3274d. The first rotating shaft hole 3274d and the second rotating shaft hole 3274e are through holes, and both the axial direction of the first rotating shaft hole 3274d and the axial direction of the second rotating shaft hole 3274e are parallel to the first direction X.

The third fastening part 3274c may be provided with a third rotating shaft hole 3274f, a fourth rotating shaft hole 3274g, a first through hole 3274h, a first sink 3274i, and a first groove 3274j. Both an axial direction of the third rotating shaft hole 3274f and an axial direction of the fourth rotating shaft hole 3274g are parallel to the axial direction of the first rotating shaft hole 3274d, and the third rotating shaft hole 3274f and the fourth rotating shaft hole 3274g may be blind holes or through holes. An axial direction of the first through hole 3274h is perpendicular to the axial direction of the first rotating shaft hole 3274d, and the axial direction of the first through hole 3274h may be parallel to the third direction Z. The first sink 3274i communicates with the first through hole 3274h, and the first sink 3274i and the first through hole 3274h are arranged in the third direction Z. The first groove 3274j is located on a side that is of the first through hole 3274h and that is away from the third rotating shaft hole 3274f, the first groove 3274j communicates with the first through hole 3274h, and an extension direction of the first groove 3274j is parallel to the first direction X.

For example, the limiting member 3274 has a limiting surface 3274k, and the limiting surface 3274k is located on a side of the limiting member 3274. The limiting surface 3274k is inclined relative to the first direction X and inclined relative to the third direction Z. The limiting surface 3274k may be disposed away from the first sink 3274i. The limiting surface 3274k may be a plane, and the limiting surface 3274k is parallel to the second direction Y. For example, the limiting surface 3274k includes a first part 3274m and a second part 3274n that are coplanar. The first part 3274m of the limiting surface 3274k is located at the first fastening part 3274a, and the first rotating shaft hole 3274d penetrates through the first part 3274m of the limiting surface 3274k. The second part 3274n of the limiting surface 3274k is located at the second fastening part 3274b, and the second rotating shaft hole 3274e penetrates through the second part 3274n of the limiting surface 3274k.

For example, a first concave space 3274p is formed between the first fastening part 3274a and the third fastening part 3274c, and a second concave space 3274q is formed between the third fastening part 3274c and the second fastening part 3274b.

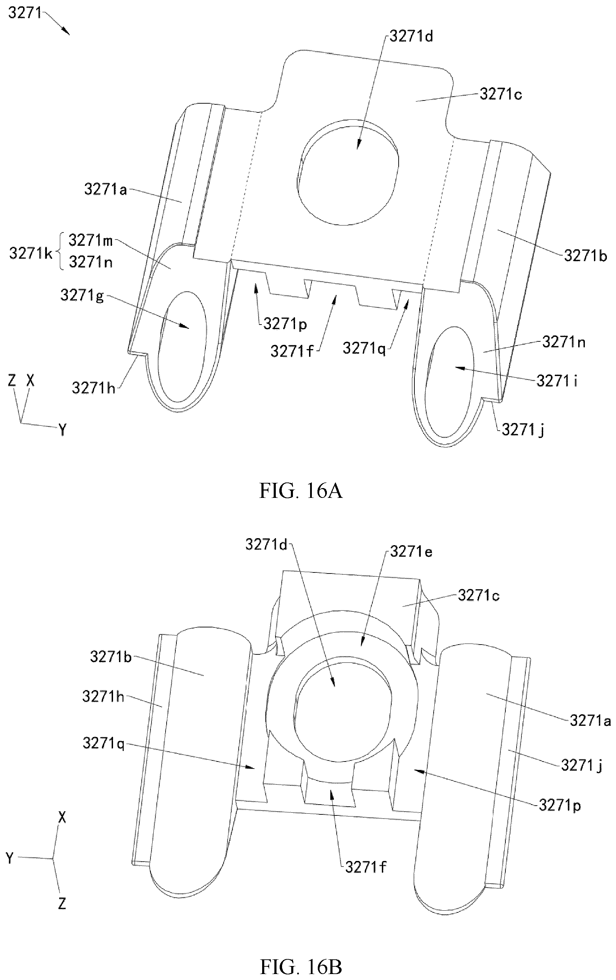

Refer to FIG. 16A and FIG. 16B. FIG. 16A is a diagram of a structure of the stop member 3271 shown in FIG. 12. FIG. 16B is a diagram of a structure of the stop member 3271 shown in FIG. 16A from another angle. FIG. 16B is a diagram of a structure of the stop member 3271 shown in FIG. 16A after the stop member 3271 is horizontally flipped.

In some embodiments, the stop member 3271 includes a first stop part 3271a, a second stop part 3271b, and a mounting part 3271c. The first stop part 3271a and the second stop part 3271b are respectively fastened to two sides of the mounting part 3271c. The first stop part 3271a, the mounting part 3271c, and the second stop part 3271b may be arranged in the second direction Y. The stop member 3271 may be an integral structural member, to have high structural strength. For example, the stop member 3271 may be made of a metal material and formed by using a metal injection process or another process. In some other embodiments, the limiting member 3274 may alternatively be made of a plastic material and formed by using an injection molding process or another process.

The mounting part 3271c may be provided with a second through hole 3271d, a second sink 3271e, and a second groove 3271f. The second through hole 3271d may be a kidney-shaped hole, an axial direction of the second through hole 3271d may be parallel to the third direction Z, and a length direction of the second through hole 3271d may be parallel to the first direction X. A hole wall of the kidney-shaped hole includes two straight edges disposed opposite to each other and two arc edges disposed opposite to each other, a length direction of the kidney-shaped hole is a direction from one arc edge to the other arc edge, and the length direction of the kidney-shaped hole is parallel to the straight edge. When a rotating shaft is inserted into the second through hole 3271d, the rotating shaft is inserted into the second through hole 3271d in the third direction Z, and the rotating shaft may move relative to the mounting part 3271c in the first direction X. The second sink 3271e communicates with the second through hole 3271d, and the second sink 3271e and the second through hole 3271d are arranged in the third direction Z. The second groove 3271f communicates with the second sink 3271e.

The first stop part 3271a has a first adjusting hole 3271g. The first adjusting hole 3271g may be a kidney-shaped hole, an axial direction of the first adjusting hole 3271g may be parallel to the first direction X, and a length direction of the first adjusting hole 3271g may be parallel to the third direction Z. When a rotating shaft is inserted into the first adjusting hole 3271g, the rotating shaft is inserted into the first adjusting hole 3271g in the first direction X, and the rotating shaft may move relative to the first stop part 3271a in the third direction Z.

The first stop part 3271a has a first stop surface 3271h, and the first stop surface 3271h may be located on a side that is of the first stop part 3271a and that is away from the mounting part 3271c. The first stop surface 3271h is not parallel to the third direction Z, that is, the first stop surface 3271h intersects the third direction Z. For example, the first stop surface 3271h may be a plane, and the first stop surface 3271h is perpendicular to the third direction Z, or an included angle is formed between the first stop surface 3271h and the third direction Z. In some other embodiments, the first stop surface 3271h may alternatively be a curved surface. This is not strictly limited in this embodiment of this application.

The second stop part 3271b has a second adjusting hole 3271i. The second adjusting hole 3271i may be a kidney-shaped hole, an axial direction of the second adjusting hole 3271i may be parallel to the first direction X, and a length direction of the second adjusting hole 3271i may be parallel to the third direction Z. When a rotating shaft is inserted into the second adjusting hole 3271i, the rotating shaft is inserted into the second adjusting hole 3271i in the first direction X, and the rotating shaft may move relative to the second stop part 3271b in the third direction Z.

The second stop part 3271b has a second stop surface 3271j, and the second stop surface 3271j may be located on a side that is of the second stop part 3271b and that is away from the mounting part 3271c. The second stop surface 3271j is not parallel to the third direction Z, that is, the second stop surface 3271j intersects the third direction Z. For example, the second stop surface 3271j may be a plane, and the second stop surface 3271j is perpendicular to the third direction Z, or an included angle is formed between the second stop surface 3271j and the third direction Z. In some other embodiments, the second stop surface 3271j may alternatively be a curved surface. This is not strictly limited in this embodiment of this application.

For example, the stop member 3271 may have an adjusting surface 3271k, and the adjusting surface 3271k is located on a side of the stop member 3271. The adjusting surface 3271k may be inclined relative to the first direction X and inclined relative to the third direction Z. The adjusting surface 3271k may be disposed away from the second sink 3271e. The adjusting surface 3271k may be a plane, and the adjusting surface 3271k is parallel to the second direction Y. For example, the adjusting surface 3271k includes a first part 3271m and a second part 3271n that are coplanar. The first part 3271m of the adjusting surface 3271k is located at the first stop part 3271a, and the first adjusting hole 3271g penetrates through the first part 3271m of the adjusting surface 3271k. The second part 3271n of the adjusting surface 3271k is located at the second stop part 3271b, and the second adjusting hole 3271i penetrates through the second part 3271n of the adjusting surface 3271k.

For example, a third concave space 3271p is formed on a side that is of the mounting part 3271c and that is close to the first stop part 3271a, and a fourth concave space 3271q is formed on a side that is of the mounting part 3271c and that is close to the second stop part 3271b. A bottom wall of the third concave space 3271p forms a first avoidance surface 3271r of the stop member 3271, a bottom wall of the fourth concave space 3271q forms a second avoidance surface 3271s of the stop member 3271, and orientations of the first avoidance surface 3271r and the second avoidance surface 3271s of the stop member 3271 are the same as an orientation of the second sink 3271e.

In some embodiments, the first elastic member 3272 may be an elastic gasket, and the elastic member may be provided with a through hole. The elastic gasket may be made of a metal material. For example, the elastic gasket may be an elastic washer, a plate-form spring, or the like. Alternatively, the elastic gasket may be made of an elastic rubber material or the like. In some embodiments, the first elastic member 3272 may include a plurality of stacked pieces. For example, the first elastic member 3272 may include an elastic washer and a flat washer that are stacked, and the flat washer may be a metal washer, a rubber washer, or the like. In some other embodiments, the first elastic member 3272 may alternatively be a spring. A specific implementation solution of the first elastic member 3272 is not strictly limited in embodiments of this application.

In some embodiments, the second elastic member 3273 may be a spring. In some other embodiments, the second elastic member 3273 may alternatively be a structure like an elastic rubber member. This is not strictly limited in embodiments of this application.

Refer to FIG. 12 again. In some embodiments, the first synchronization gear 3281 may include a gear and a rotating shaft, the rotating shaft is located in the middle of the gear, and two ends of the rotating shaft protrude on two sides of the gear. The gear and the rotating shaft may be fastened. For example, the first synchronization gear 3281 may be an integral structural member. Alternatively, the gear may also be rotatably connected to the rotating shaft. For example, the second synchronization gear 3282 may also include a gear and a rotating shaft, the rotating shaft is located in the middle of the gear, and two ends of the rotating shaft protrude on two sides of the gear. The gear and the rotating shaft may be fastened. For example, the second synchronization gear 3282 may be an integral structural member. Alternatively, the gear may also be rotatably connected to the rotating shaft.

In some embodiments, the first clamping member 3291 may include a first clamping plate 3291a and two first bump groups 3291b, and the two first bump groups 3291b protrude and are fastened to a same side of the first clamping plate 3291a. The first clamping plate 3291a may be generally plate-shaped. The first clamping plate 3291a has two first holes 3291c and two rotating holes 3291d, and the two rotating holes 3291d are located between the two first holes 3291c. The first hole 3291c is a through hole, and the rotating hole 3291d may be a through hole or a blind hole. The two first bump groups 3291b are respectively disposed in a correspondence with the two first holes 3291c. Each first bump group 3291b may include a plurality of first bumps. The plurality of first bumps are arranged in an annular shape and are spaced away from each other. A plurality of first bumps in a same first bump group 3291b are disposed around a corresponding first hole 3291c, and a first clamping groove is formed between two adjacent first bumps. The first clamping member 3291 may be an integral structural member, to have high structural strength.

For example, the second clamping member 3292 includes a main body 3292a and two second bump groups 3292b, and the two second bump groups 3292b protrude and are fastened to a same side of the main body 3292a. The main body 3292a may include two clamping parts 3292c and a connecting part 3292d connecting the two clamping parts 3292c. The two clamping parts 3292c are spaced apart from each other, each clamping part 3292c has a second hole 3292e, and the second hole 3292e is a through hole. Two ends of the connecting part 3292d are respectively connected to two clamping parts 3292c, and the middle of the connecting part 3292d protrudes toward one side, to form an avoidance space on the other side. The two second bump groups 3292b are respectively fastened to the two clamping parts 3292c, and the two second bump groups 3292b are respectively disposed in a correspondence with the two second holes 3292e. Each second bump group 3292b may include a plurality of second bumps. The plurality of second bumps are arranged in an annular shape and are spaced away from each other. A plurality of second bumps in a same second bump group 3292b are disposed around a corresponding second hole 3292e, and a second clamping groove is formed between two adjacent second bumps. The second clamping member 3292 may be an integral structural member, to have high structural strength. In some other embodiments, the main body 3292a may alternatively have another implementation structure, and the main body 3292a may include at least two second holes 3292e that are spaced apart.

For example, the third clamping member 3293 includes a first clamping groove 3293a and a second clamping groove 3293b that are spaced apart, and the first clamping groove 3293a and the second clamping groove 3293b form an opening on one side of the third clamping member 3293, so that another component may be clamped into the first clamping groove 3293a and the second clamping groove 3293b through the opening. The third clamping member 3293 may further include a third hole 3293c, and the third hole 3293c may be a blind hole or a through hole. The third clamping member 3293 may be approximately plate-shaped. The third clamping member 3293 may be an integral structural member, to have high structural strength.

For example, the fourth clamping member 3294 includes two fourth holes 3294a that are spaced apart, and the fourth holes 3294a are through holes. The fourth clamping member 3294 further includes a fifth hole 3294b, and the fifth hole 3294b may be a through hole or a blind hole. The fifth hole 3294b may be located between the two fourth holes 3294a. The fourth clamping member 3294 may be approximately plate-shaped. The fourth clamping member 3294 may be an integral structural member, to have high structural strength.

For example, the first elastic component 3295 may include two first springs 3295a. In some other embodiments, the first elastic component 3295 may alternatively be of an elastic material like an elastic rubber. This is not strictly limited in this application.

For example, the second elastic component 3296 may include three second springs 3296a. In some other embodiments, the second elastic component 3296 may alternatively be of an elastic material like an elastic rubber. This is not strictly limited in this application.

Refer to FIG. 13 again. For example, a limiting flange 3297a is disposed at one end of the first rotating shaft 3297, and an outer diameter of the limiting flange 3297a is greater than an outer diameter of a main body part 3297b of the first rotating shaft 3297. A limiting clamping groove 3297c is provided at the other end of the first rotating shaft 3297, the limiting clamping groove 3297c contracts inward relative to an outer surface of the main body part 3297b of the first rotating shaft 3297, and a diameter of a groove bottom wall of the limiting clamping groove 3297c is less than the outer diameter of the main body part 3297b of the first rotating shaft 3297. A limiting flange 3298a is disposed at one end of the second rotating shaft 3298, and an outer diameter of the limiting flange 3298a is greater than an outer diameter of a main body part 3298b of the second rotating shaft 3298. A limiting clamping groove 3298c is provided at the other end of the second rotating shaft 3298, the limiting clamping groove 3298c contracts inward relative to an outer surface of the main body part 3298b of the second rotating shaft 3298, and a diameter of a groove bottom wall of the limiting clamping groove 3298c is less than the outer diameter of the main body part 3298b of the second rotating shaft 3298. A limiting flange 3299a is disposed on the third rotating shaft 3299, and an outer diameter of the limiting flange 3299a is greater than an outer diameter of a main body part 3299b of the third rotating shaft 3299.

As shown in FIG. 11 and FIG. 12, in the adjustable rotating mechanism 310, the stop member 3271 and the limiting member 3274 are arranged in the first direction X, and both are located between the first swing arm 322 and the second swing arm 325. The adjusting surface 3271k of the stop member 3271 faces the limiting surface 3274k of the limiting member 3274. The third concave space 3271p of the stop member 3271 can communicate with the first concave space 3274p of the limiting member 3274, and the third concave space 3271p communicate with the first concave space 3274p to form a common avoidance space, to avoid the first swing arm 322. The fourth concave space 3271q of the stop member 3271 can communicate with the second concave space 3274q of the limiting member 3274, and the fourth concave space 3271q communicate with the second concave space 3274q to form a common avoidance space, to avoid the second swing arm 325.

The stop member 3271 and the limiting member 3274 are further clamped into the first avoidance space 3221e of the first swing arm 322, to clamp the first end part 3221 of the first swing arm 322. The stop member 3271 and the limiting member 3274 are further clamped into the second avoidance space 3251e of the second swing arm 325, to clamp the first end part 3251 of the second swing arm 325. The first elastic member 3272 is stacked on a side of the stop member 3271. The second elastic member 3273 is located on a side that is of the stop member 3271 and that faces away from the limiting member 3274.

The first synchronization gear 3281 and the second synchronization gear 3282 of the synchronization assembly 328 are engaged with each other, the first synchronization gear 3281 is engaged with the first end part 3221 of the first swing arm 322, and the second synchronization gear 3282 is engaged with the first end part 3251 of the second swing arm 325. In this case, the first end part 3221 of the first swing arm 322 is indirectly engaged with the first end part 3251 of the second swing arm 325 by using the synchronization assembly 328. The first synchronization gear 3281 and the second synchronization gear 3282 may be located on a side that is of the stop member 3271 and that faces away from the limiting member 3274.

The first clamping member 3291 and the second clamping member 3292 are spaced apart, and the plurality of first bump groups 3291b of the first clamping member 3291 face the plurality of second bump groups 3292b of the second clamping member 3292. The first end part 3221 of the first swing arm 322, the first end part 3251 of the second swing arm 325, the stop member 3271, the limiting member 3274, the first synchronization gear 3281, and the second synchronization gear 3282 are all located between the first clamping member 3291 and the second clamping member 3292. The plurality of first protrusions 3221b of the first swing arm 322 are disposed to face the first clamping member 3291, the plurality of second protrusions 3221c of the first swing arm 322 are disposed to face the second clamping member 3292, the plurality of first protrusions 3221b of the second swing arm 325 are disposed to face the first clamping member 3291, and the plurality of second protrusions 3221c of the second swing arm 325 are disposed to face the second clamping member 3292. In this case, the first clamping member 3291 is located on a side that is of the synchronization assembly 328 and that faces away from the limiting member 3274, and the second clamping member 3292 is located on a side that is of the stop member 3271 and that faces away from the limiting member 3274.

For example, the third clamping member 3293 is located on a side that is of the first clamping member 3291 and that faces away from the second clamping member 3292, the fourth clamping member 3294 is located on a side that is of the second clamping member 3292 and that faces away from the first clamping member 3291, the first elastic component 3295 is located between the second clamping member 3292 and the fourth clamping member 3294, and the second elastic component 3296 is located on a side that is of the third clamping member 3293 and that faces away from the first clamping member 3291.

The first rotating shaft 3297, the second rotating shaft 3298, the third rotating shaft 3299, and the fourth rotating shaft 32910 are inserted with the foregoing a plurality of components, so that the adjustable rotating mechanism 310 forms a modular structure. Details are as follows.

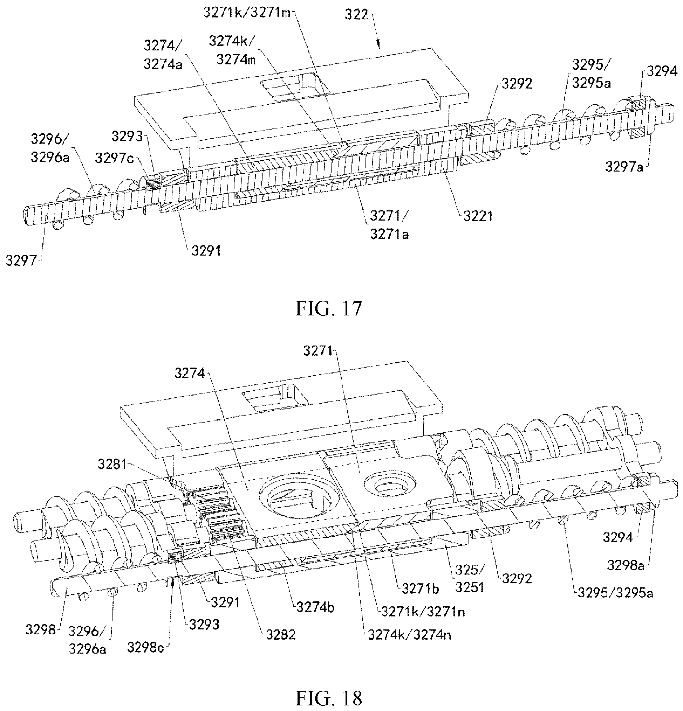

Refer to FIG. 11, FIG. 12, and FIG. 17. FIG. 17 is a diagram of a cross-sectional structure that is of the adjustable rotating mechanism 310 shown in FIG. 11 and that is cut along A-A.

In some embodiments, the first rotating shaft 3297 is sequentially inserted into the fourth clamping member 3294, the first elastic component 3295, the second clamping member 3292, the first end part 3221 of the first swing arm 322, the stop member 3271, the limiting member 3274, the first clamping member 3291, the third clamping member 3293, and the second elastic component 3296. The first rotating shaft 3297 passes through one of the fourth holes 3294a of the fourth clamping member 3294, an inner space of one of the first springs 3295a of the first elastic component 3295, one of the second holes 3292e of the second clamping member 3292, the rotating shaft hole 3221a of the first end part 3221 of the first swing arm 322, the first adjusting hole 3271g of the first stop part 3271a of the stop member 3271, the first rotating shaft hole 3274d of the first fastening part 3274a of the limiting member 3274, one of the first holes 3291c of the first clamping member 3291, one of the first clamping grooves 3293a of the third clamping member 3293, and an inner space of one of the second springs 3296a of the second elastic component 3296.

The adjusting surface 3271k of the stop member 3271 faces the limiting surface 3274k of the limiting member 3274. The first part 3271m of the adjusting surface 3271k faces the first part 3274m of the limiting surface 3274k. The plurality of first protrusions 3221b of the first end part 3221 of the first swing arm 322 are disposed in a correspondence with one first bump group 3291b of the first clamping member 3291, and the plurality of second protrusions 3221c of the first end part 3221 of the first swing arm 322 are disposed in a correspondence with one second bump group 3292b of the second clamping member 3292. The first fastening part 3274a of the limiting member 3274 and the first stop part 3271a of the stop member 3271 are mounted in the first avoidance space 3221e of the first swing arm 322.

The first spring 3295a is in a compressed state, the limiting flange 3297a of the first rotating shaft 3297 is located on a side that is of the fourth clamping member 3294 and that faces away from the second clamping member 3292, and abuts against the fourth clamping member 3294. The third clamping member 3293 is at least partially clamped into the limiting clamping groove 3297c of the first rotating shaft 3297, and the third clamping member 3293 abuts against a side wall of the limiting clamping groove 3297c of the first rotating shaft 3297. One end of the first spring 3295a abuts against the fourth clamping member 3294, the fourth clamping member 3294 abuts against the limiting flange 3297a of the first rotating shaft 3297, the other end of the first spring 3295a abuts against the second clamping member 3292, the second clamping member 3292 abuts against the first end part 3221 of the first swing arm 322, the first end part 3221 of the first swing arm 322 abuts against the first clamping member 3291, the first clamping member 3291 abuts against the third clamping member 3293, the third clamping member 3293 abuts against the side wall of the limiting clamping groove 3297c of the first rotating shaft 3297, and the first spring 3295a is disposed in the compressed state between the second clamping member 3292 and the fourth clamping member 3294, so that the first clamping member 3291 and the second clamping member 3292 tend to approach each other. In this case, both the first clamping member 3291 and the second clamping member 3292 abut against the first end part 3221 of the first swing arm 322.

In some states, the plurality of first protrusions 3221b of the first swing arm 322 and a plurality of first bumps of a first bump group 3291b of the first clamping member 3291 are interleaved to form a clamping structure, and the plurality of first protrusions 3221b are correspondingly clamped into the plurality of first clamping grooves of the first bump group 3291b. The plurality of second protrusions 3221c of the first swing arm 322 and a plurality of second bumps of a second bump group 3292b of the second clamping member 3292 are interleaved to form a clamping structure, and the plurality of second protrusions 3221c are correspondingly clamped into the plurality of second clamping grooves of the second bump group 3292b.

Refer to FIG. 11, FIG. 12, and FIG. 18. FIG. 18 is a diagram of a cross-sectional structure that is of the adjustable rotating mechanism 310 shown in FIG. 11 and that is cut along B-B.

In some embodiments, the second rotating shaft 3298 is sequentially inserted into the fourth clamping member 3294, the first elastic component 3295, the second clamping member 3292, the first end part 3251 of the second swing arm 325, the stop member 3271, the limiting member 3274, the first clamping member 3291, the third clamping member 3293, and the second elastic component 3296. The second rotating shaft 3298 passes through the other fourth hole 3294a of the fourth clamping member 3294, an inner space of the other first spring 3295a of the first elastic component 3295, the other second hole 3292e of the second clamping member 3292, the rotating shaft hole 3251a of the first end part 3251 of the second swing arm 325, the second adjusting hole 3271i of the second stop part 3271b of the stop member 3271, the second rotating shaft hole 3274e of the second fastening part 3274b of the limiting member 3274, the other first hole 3291c of the first clamping member 3291, the second clamping groove 3293b of the third clamping member 3293, and an inner space of another second spring 3296a of the second elastic component 3296.

The second part 3271n of the adjusting surface 3271k of the stop member 3271 faces the second part 3274n of the limiting surface 3274k of the limiting member 3274. The plurality of first protrusions 3251b of the first end part 3251 of the second swing arm 325 are disposed in a correspondence with the other first bump group 3291b of the first clamping member 3291, and the plurality of second protrusions 3251c of the first end part 3251 of the second swing arm 325 are disposed in a correspondence with the other second bump group 3292b of the second clamping member 3292. The second fastening part 3274b of the limiting member 3274 and the second stop part 3271b of the stop member 3271 are mounted in the second avoidance space 3251e of the second swing arm 325.

The first spring 3295a is in a compressed state, the limiting flange 3298a of the second rotating shaft 3298 is located on a side that is of the fourth clamping member 3294 and that faces away from the second clamping member 3292, and abuts against the fourth clamping member 3294. The third clamping member 3293 is at least partially clamped into the limiting clamping groove 3298c of the second rotating shaft 3298, and the third clamping member 3293 abuts against a side wall of the limiting clamping groove 3298c of the second rotating shaft 3298. One end of the first spring 3295a abuts against the fourth clamping member 3294, the fourth clamping member 3294 abuts against the limiting flange 3298a of the second rotating shaft 3298, the other end of the first spring 3295a abuts against the second clamping member 3292, the second clamping member 3292 abuts against the first end part 3251 of the second swing arm 325, the first end part 3251 of the second swing arm 325 abuts against the first clamping member 3291, the first clamping member 3291 abuts against the third clamping member 3293, the third clamping member 3293 abuts against the side wall of the limiting clamping groove 3298c of the second rotating shaft 3298, and the first spring 3295a is disposed in the compressed state between the second clamping member 3292 and the fourth clamping member 3294, so that the first clamping member 3291 and the second clamping member 3292 tend to approach each other. In this case, both the first clamping member 3291 and the second clamping member 3292 abut against the first end part 3251 of the second swing arm 325.

In some states, the plurality of first protrusions 3221b of the second swing arm 325 and a plurality of first bumps of the other first bump group 3291b of the first clamping member 3291 are interleaved to form a clamping structure, and the plurality of first protrusions 3221b are correspondingly clamped into the plurality of first clamping grooves of the first bump group 3291b. The plurality of second protrusions 3221c of the second swing arm 325 and a plurality of second bumps of the other second bump group 3292b of the second clamping member 3292 are interleaved to form a clamping structure, and the plurality of second protrusions 3221c are correspondingly clamped into the plurality of second clamping grooves of the second bump group 3292b.

Refer to FIG. 12, FIG. 17, and FIG. 18. In the adjustable rotating mechanism 310, the first elastic component 3295 is configured to generate an elastic force, so that both the first end part 3221 of the first swing arm 322 and the first end part 3251 of the second swing arm 325 abut against the first clamping member 3291 and the second clamping member 3292. In addition, the plurality of first protrusions 3221b of the first swing arm 322 cooperate with one of the first bump groups 3291b of the first clamping member 3291 to form a clamping structure, the plurality of second protrusions 3221c of the first swing arm 322 cooperate with one of the second bump groups 3292b of the second clamping member 3292 to form a clamping structure, the plurality of first protrusions 3221b of the second swing arm 325 cooperate with the other first bump group 3291b of the first clamping member 3291 to form a clamping structure, and the plurality of second protrusions 3221c of the second swing arm 325 cooperate with the other second bump group 3292b of the second clamping member 3292 to form a clamping structure.

The two first bump groups 3291b of the first clamping member 3291 are disposed in a correspondence with the second bump groups 3292b of the second clamping member 3292. In the first bump group 3291b and the second bump group 3292b that are correspondingly disposed, a position of the first bump may be opposite to a position of the second bump, and a position of the first clamping groove may be opposite to a position of the second clamping groove. In some other embodiments, a position of the first bump and a position of the second bump may alternatively be staggered or present another position relationship. A person skilled in the art may adjust a position relationship of a corresponding structural member based on a design requirement. This is not strictly limited in this application.

Refer to FIG. 12 and FIG. 18. In some embodiments, the rotating shaft of the first synchronization gear 3281 is inserted into the limiting member 3274 and the first clamping member 3291. For example, the rotating shaft of the first synchronization gear 3281 may be inserted into the third rotating shaft hole 3274f of the limiting member 3274 and one of the rotating holes 3291d of the first clamping member 3291. The gear of the first synchronization gear 3281 is located between the limiting member 3274 and the first clamping member 3291. In this case, the first synchronization gear 3281 is rotatably connected to the limiting member 3274 and the first clamping member 3291. The rotating shaft of the second synchronization gear 3282 is inserted into the limiting member 3274 and the first clamping member 3291. For example, the rotating shaft of the second synchronization gear 3282 may be inserted into the fourth rotating shaft hole 3274g of the limiting member 3274 and the other rotating hole 3291d of the first clamping member 3291. The gear of the second synchronization gear 3282 is located between the limiting member 3274 and the first clamping member 3291. In this case, the second synchronization gear 3282 is rotatably connected to the limiting member 3274 and the first clamping member 3291.

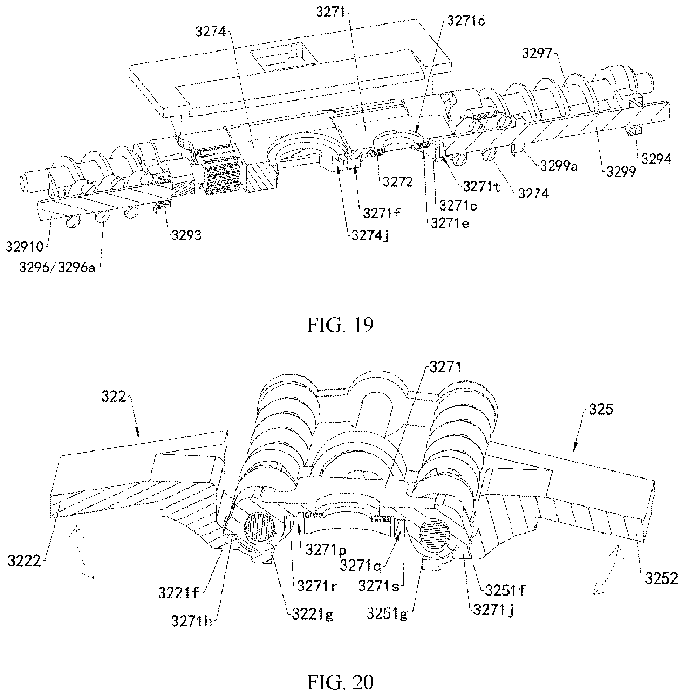

Refer to FIG. 11, FIG. 12, and FIG. 19. FIG. 19 is a diagram of a cross-sectional structure that is of the adjustable rotating mechanism 310 shown in FIG. 11 and that is cut along C-C.

In some embodiments, the second groove 3271f of the stop member 3271 and the first groove 3274j of the limiting member 3274 are placed close to each other, and the two are disposed opposite to and communicate with each other. The stop member 3271 further has a third groove 3271t, the third groove 3271t may be located in the mounting part 3271c of the stop member 3271, and the third groove 3271t is located on a side that is of the second sink 3271e and that faces away from the second groove 3271f. The first elastic member 3272 is mounted in the second sink 3271e of the stop member 3271. The through hole of the first elastic member 3272 is provided in a correspondence with the second through hole 3271d of the stop member 3271, and the two communicate with each other.

In some embodiments, the third rotating shaft 3299 is inserted into the fourth clamping member 3294, the first elastic member 3272, and the stop member 3271. The third rotating shaft 3299 may be located between the first rotating shaft 3297 and the second rotating shaft 3298. One end of the third rotating shaft 3299 is inserted into the fifth hole 3294b of the fourth clamping member 3294, the third rotating shaft 3299 passes through the inner space of the second elastic member 3273, and the other end of the third rotating shaft 3299 is inserted into the third groove 3271t of the stop member 3271. The second elastic member 3273 and the third rotating shaft 3299 may be partially located in the avoidance space of the second clamping member 3292, to pass through the second clamping member 3292.

The limiting flange 3299a of the third rotating shaft 3299 is located on a side that is of the second elastic member 3273 and that faces away from the stop member 3271. The second elastic member 3273 is in the compressed state, one end of the second elastic member 3273 abuts against the limiting flange 3299a of the third rotating shaft 3299, and the other end abuts against the stop member 3271. In this embodiment, an elastic force of the second elastic member 3273 enables the stop member 3271 to tend to approach the limiting member 3274, so that the adjusting surface 3271k of the stop member 3271 can stably abut against the limiting surface 3274k of the limiting member 3274 (reference may be made to FIG. 17 and FIG. 18).

In some embodiments, the fourth rotating shaft 32910 may be located between the first rotating shaft 3297 and the second rotating shaft 3298. The fourth rotating shaft 32910 is inserted into the third clamping member 3293 and the second elastic component 3296. For example, one end of the fourth rotating shaft 32910 is inserted into the third hole 3293c of the third clamping member 3293, and the fourth rotating shaft 32910 further passes through an inner space of one of the second springs 3296a of the second elastic component 3296.

Refer to FIG. 17 to FIG. 19 again. Under an action of the elastic force of the first elastic component 3295 and a cooperation action of structures of all components, the entire adjustable rotating mechanism 310 forms a modular whole, and the first swing arm 322 and the second swing arm 325 can be rotated relative to each other.

For example, when the first swing arm 322 and the second swing arm 325 are rotated relative to each other, for the clamping structure between the plurality of first protrusions 3221b of the first end part 3221 of the first swing arm 322 and the corresponding first bump group 3291b, the first protrusion 3221b is detached from one first clamping groove, crosses one first bump, and is clamped into another adjacent first clamping groove; and for the clamping structure between the plurality of second protrusions 3221c of the first end part 3221 of the first swing arm 322 and the corresponding second bump group 3292b, the second protrusion 3221c is detached from one second clamping groove, crosses one second bump, and is clamped into another adjacent second clamping groove. In this process, the first end part 3221 of the first swing arm 322 pushes the first clamping member 3291 to move in a direction away from the limiting member 3274, and pushes the second clamping member 3292 to move in a direction away from the stop member 3271. The first elastic component 3295 is compressed, and a part of a damping force and a driving force is generated. Similarly, when the first swing arm 322 and the second swing arm 325 are rotated relative to each other, for the clamping structure between the plurality of first protrusions 3251b of the first end part 3251 of the second swing arm 325 and the corresponding first bump group 3291b, the first protrusion 3251b is detached from one first clamping groove, crosses one first bump, and is clamped into another adjacent first clamping groove; and for the clamping structure between the plurality of second protrusions 3251c of the first end part 3251 of the second swing arm 325 and the corresponding second bump group 3292b, the second protrusion 3251c is detached from one second clamping groove, crosses one second bump, and is clamped into another adjacent second clamping groove. In this process, the first end part 3251 of the second swing arm 325 pushes the first clamping member 3291 to move in a direction away from the limiting member 3274, and pushes the second clamping member 3292 to move in a direction away from the stop member 3271. The first elastic component 3295 is compressed, and another part of the damping force and the driving force is generated.

In some other embodiments, the third clamping member 3293 and the fourth clamping member 3294 may not be disposed on the damping assembly 329. For example, the damping assembly 329 includes the first clamping member 3291, the second clamping member 3292, and the first elastic component 3295. One end that is of the first elastic component 3295 and that faces away from the second clamping member 3292 may abut against the second clamping member 3292, and the other end directly abuts against a wall surface of the main inner shaft 311. In this case, the first elastic component 3295 can still be in the compressed state, and the damping assembly 329 can still provide a damping force and a driving force for rotation of the first swing arm 322 and the second swing arm 325. It may be understood that the damping assembly 329 may further have another implementation structure. A specific implementation structure of the damping assembly 329 is not strictly limited in embodiments of this application.

In some other embodiments, the first elastic component 3295 may alternatively be located on a side that is of the first clamping member 3291 and that faces away from the second clamping member 3292, and the elastic force generated by the first elastic component 3295 can also enable the first clamping member 3291 and the second clamping member 3292 to tend to approach each other. Both the first end part 3221 of the first swing arm 322 and the first end part 3251 of the second swing arm 325 abut against the first clamping member 3291 and the second clamping member 3292, and form the corresponding clamping structure (for details, refer to the foregoing embodiments, and details are not described herein). In this case, structures and positions of the plurality of rotating shafts (340, 350, 360, and 370) of the adjustable rotating mechanism 310, the third clamping member 3293, and the fourth clamping member 3294 are adaptively changed. For example, one end of the first elastic component 3295 abuts against the first clamping member 3291, the other end may abut against another clamping member or the main shaft 31, and the first elastic component 3295 may also be in the compressed state. This application imposes no strict limitation on a specific structure of a related structural member.

For example, as shown in FIG. 18, because the synchronization assembly 328 is engaged with the first end part 3221 of the first swing arm 322 and the first end part 3251 of the second swing arm 325, when the first swing arm 322 and the second swing arm 325 are rotated relative to each other, the first synchronization gear 3281 and the second synchronization gear 3282 are rotated. In this embodiment, disposing the synchronization assembly 328 helps improve synchronization and stability during relative rotation between the first swing arm 322 and the second swing arm 325. Certainly, in some other embodiments, the adjustable rotating mechanism 310 may not be disposed with the synchronization assembly 328. When the adjustable rotating mechanism 310 is not disposed with the synchronization assembly 328, the first end part 3221 of the first swing arm 322 may not be disposed with the engagement teeth 3221d, and the first end part 3251 of the second swing arm 325 may not be disposed with the engagement teeth 3221d. A person skilled in the art may select, based on a structural design requirement, a proper structural position and space to dispose a gear structure that implements synchronous rotation of the first housing 1 and the second housing 2.

FIG. 20 is a diagram of a cross-sectional structure that is of the adjustable rotating mechanism 310 shown in FIG. 11 and that is cut along D-D.

In some embodiments, the first swing arm 322 and the second swing arm 325 can be rotated relative to each other, to be unfolded relative to each other to an open state or folded relative to each other to a closed state.

When the first swing arm 322 and the second swing arm 325 are in the open state, the first stop end surface 3221f of the first swing arm 322 and the first stop surface 3271h of the stop member 3271 at least partially abut against each other, the first avoidance end surface 3221g of the first swing arm 322 and the first avoidance surface 3271r of the stop member 3271 are spaced apart, and an included angle between the first avoidance end surface 3221g and the first avoidance surface 3271r reaches a maximum value. The second stop end surface 3251f of the second swing arm 325 and the second stop surface 3271j of the stop member 3271 at least partially abut against each other, the second avoidance end surface 3251g of the second swing arm 325 and the second avoidance surface 3271s of the stop member 3271 are spaced apart, and an included angle between the second avoidance end surface 3251g and the second avoidance surface 3271s reaches a maximum value.

In a process in which the first swing arm 322 and the second swing arm 325 are folded relative to each other, the second end part 3222 of the first swing arm 322 and the second end part 3252 of the second swing arm 325 are close to each other. The first swing arm 322 is rotated counterclockwise, the first stop end surface 3221f of the first swing arm 322 moves in a direction away from the first stop surface 3271h of the stop member 3271, the first avoidance end surface 3221g of the first swing arm 322 moves in a direction close to the first avoidance surface 3271r of the stop member 3271, and the first avoidance end surface 3221g of the first swing arm 322 may be rotated into the third concave space 3271p of the stop member 3271 and the first concave space 3274p of the limiting member 3274 (referring to FIG. 12). The second swing arm 325 is rotated clockwise, the second stop end surface 3251f of the second swing arm 325 moves in a direction away from the second stop surface 3271j of the stop member 3271, the second avoidance end surface 3251g of the second swing arm 325 moves in a direction close to the second avoidance surface 3271s of the stop member 3271, and the second avoidance end surface 3251g of the second swing arm 325 may be rotated into the fourth concave space 3271q of the stop member 3271 and the second concave space 3274q of the limiting member 3274 (referring to FIG. 12). It should be noted that rotation directions of the first swing arm 322 and the second swing arm 325 in this embodiment of this application are both described based on an illustrated direction. In use of an actual product, the rotation directions of the first swing arm 322 and the second swing arm 325 may be exchanged.

When the first swing arm 322 and the second swing arm 325 are in the closed state, an included angle between the first stop end surface 3221f of the first swing arm 322 and the first stop surface 3271h of the stop member 3271 reaches a maximum value. An included angle between the first avoidance end surface 3221g of the first swing arm 322 and the first avoidance surface 3271r of the stop member 3271 reaches a minimum value, and a gap may exist between the first avoidance end surface 3221g and the first avoidance surface 3271r. An included angle between the second stop end surface 3251f of the second swing arm 325 and the second stop surface 3271j of the stop member 3271 reaches a maximum value. An included angle between the second avoidance end surface 3251g of the second swing arm 325 and the second avoidance surface 3271s of the stop member 3271 reaches a minimum value, and a gap may exist between the second avoidance end surface 3251g and the second avoidance surface 3271s.

In a process in which the first swing arm 322 and the second swing arm 325 are unfolded relative to each other, the second end part 3222 of the first swing arm 322 and the second end part 3252 of the second swing arm 325 are away from each other. The first swing arm 322 is rotated clockwise, the first stop end surface 3221f of the first swing arm 322 moves in a direction close to the first stop surface 3271h of the stop member 3271, the first avoidance end surface 3221g of the first swing arm 322 moves in a direction away from the first avoidance surface 3271r of the stop member 3271, and the first avoidance end surface 3221g of the first swing arm 322 may be rotated out of the third concave space 3271p of the stop member 3271 and the first concave space 3274p of the limiting member 3274 (referring to FIG. 12). The second swing arm 325 is rotated counterclockwise, the second stop end surface 3251f of the second swing arm 325 moves in a direction close to the second stop surface 3271j of the stop member 3271, the second avoidance end surface 3251g of the second swing arm 325 moves in a direction away from the second avoidance surface 3271s of the stop member 3271, and the second avoidance end surface 3251g of the second swing arm 325 is rotated out of the fourth concave space 3271q of the stop member 3271 and the second concave space 3274q of the limiting member 3274 (referring to FIG. 12).

In this embodiment of this application, a stop cooperation structure between the first stop surface 3271h of the stop member 3271 and the first stop end surface 3221f of the first swing arm 322 and a stop cooperation structure between the second stop surface 3271j of the stop member 3271 and the second stop end surface 3251f of the second swing arm 325 are disposed, so that when the first swing arm 322 and the second swing arm 325 are unfolded relative to each other to the open state, the first swing arm 322 and the second swing arm 325 can be limited to continue to be rotated relative to each other, and the included angle between the first swing arm 322 and the second swing arm 325 can stay at a preset angle, avoiding excessive rotation. In addition, a relative position relationship between the first avoidance end surface 3221g of the first swing arm 322 and the first avoidance surface 3271r of the stop member 3271, and a relative position relationship between the second avoidance end surface 3251g of the second swing arm 325 and the second avoidance surface 3271s of the stop member 3271 are set, so that interference between the first swing arm 322 and the second swing arm 325 and the stop member 3271 can be avoided in a moving process, to ensure normal working of the entire foldable assembly 3. In this way, the foldable assembly 3 has high stability.

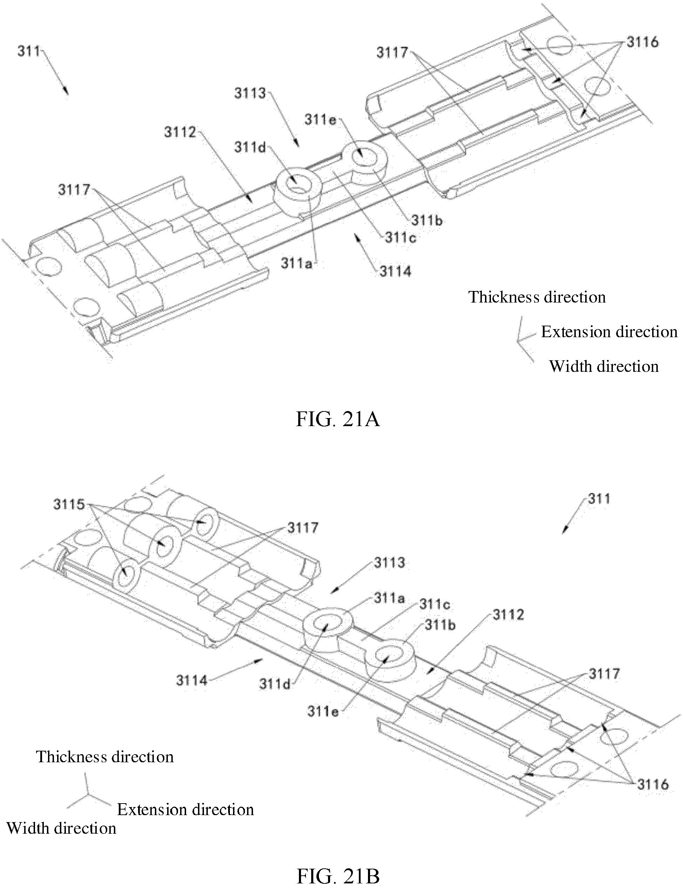

Refer to FIG. 21A and FIG. 21B. FIG. 21A is a diagram of a partial structure of the main inner shaft 311 shown in FIG. 6 in some embodiments. FIG. 21B is a diagram of a structure of the main inner shaft 311 shown in FIG. 21A from another angle. An extension direction of the main inner shaft 311 is consistent with an extension direction of the main shaft 31, a thickness direction of the main inner shaft 311 is consistent with a thickness direction of the main shaft 31, and a width direction of the main inner shaft 311 is consistent with a width direction of the main shaft 31. The following solution is described based on the direction of the main shaft 31. In addition, for brevity, in FIG. 21A and subsequent accompanying drawings, an "extension direction" represents the extension direction of the main shaft 31, a "thickness direction" represents the thickness direction of the main shaft 31, and a "width direction" represents the width direction of the main shaft 31.

In some embodiments, the main inner shaft 311 has a mounting space 3112, a first notch 3113, a second notch 3114, a plurality of mounting holes 3115, and a plurality of mounting grooves 3116. A plurality of ribs 3117 may be disposed on a bottom wall of the mounting space 3112. The plurality of ribs 3117 are configured to divide the mounting space 3112 into a plurality of regions, and are also used as limiting structures, so that an assembled structure of a structural member mounted in the mounting space 3112 and the main inner shaft 311 is stable. The ribs 3117 may be arranged in the extension direction of the main shaft 31, and the plurality of ribs 3117 are spaced apart in the width direction of the main shaft 31. The first notch 3113 and the second notch 3114 are arranged at an interval in the width direction of the main shaft 31, and both communicate with the mounting space 3112. The first notch 3113 and the second notch 3114 may be respectively located on two sides of the main inner shaft 311. The plurality of mounting holes 3115 are located on one side of the mounting space 3112 and communicate with the mounting space 3112, and an axial direction of the mounting holes 3115 may be parallel to the extension direction of the main shaft 31. The plurality of mounting holes 3115 are spaced apart in the width direction of the main shaft 31, and the plurality of mounting holes 3115 may be disposed in one-to-one correspondence with the plurality of regions in the mounting space 3112. The plurality of mounting grooves 3116 are located on the other side of the mounting space 3112 and communicate with the mounting space 3112. In this case, the plurality of mounting holes 3115, the mounting space 3112, and the plurality of mounting grooves 3116 are sequentially arranged in the extension direction of the main shaft 31. The plurality of mounting grooves 3116 are spaced apart in the width direction of the main shaft 31, and the plurality of mounting grooves 3116 may be disposed in one-to-one correspondence with the plurality of regions in the mounting space 3112.

For example, the main inner shaft 311 includes a first boss 311a, a second boss 311b, and a connecting boss 311c that are located between the first notch 3113 and the second notch 3114. The first boss 311a and the second boss 311b are arranged at an interval in the extension direction of the main shaft 31, the first boss 311a is provided with a first mounting hole 311d, and the second boss 311b is provided with a second mounting hole 311e. The connecting boss 311c is located between the first boss 311a and the second boss 311b, and the connecting boss 311c may extend in the extension direction of the main shaft 31. The connecting boss 311c may be connected to the first boss 311a and the second boss 311b, to improve overall structural strength of the first boss 311a, the connecting boss 311c, and the second boss 311b.

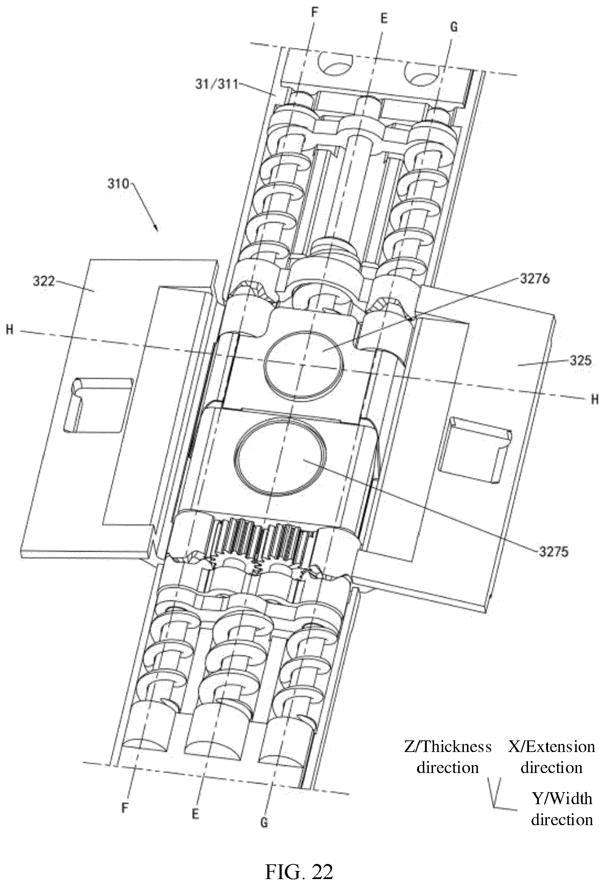

Refer to FIG. 21A to FIG. 22. FIG. 22 is a diagram of an assembled structure of the adjustable rotating mechanism 310 shown in FIG. 11 and the main inner shaft 311 shown in FIG. 21A.

In some embodiments, the adjustable rotating mechanism 310 may be mounted on the main inner shaft 311 of the main shaft 31 by using the first fastener 3275 and the second fastener 3276 of the adjustable rotating mechanism 310. In this case, all components of the adjustable rotating mechanism 310 are mounted on the main shaft 31. Most structures of the adjustable rotating mechanism 310 are located in the mounting space 3112 of the main inner shaft 311. End parts of some rotating shafts may be inserted into the mounting holes 3115 and/or placed in the mounting grooves 3116. The first swing arm 322 is disposed in a correspondence with the first notch 3113, and the second swing arm 325 is disposed in a correspondence with the second notch 3114. The first direction X of the adjustable rotating mechanism 310 is consistent with the extension direction of the main shaft 31, the second direction Y of the adjustable rotating mechanism 310 is consistent with the thickness direction of the main shaft 31, and the third direction Z of the adjustable rotating mechanism 310 is consistent with the thickness direction of the main shaft 31.

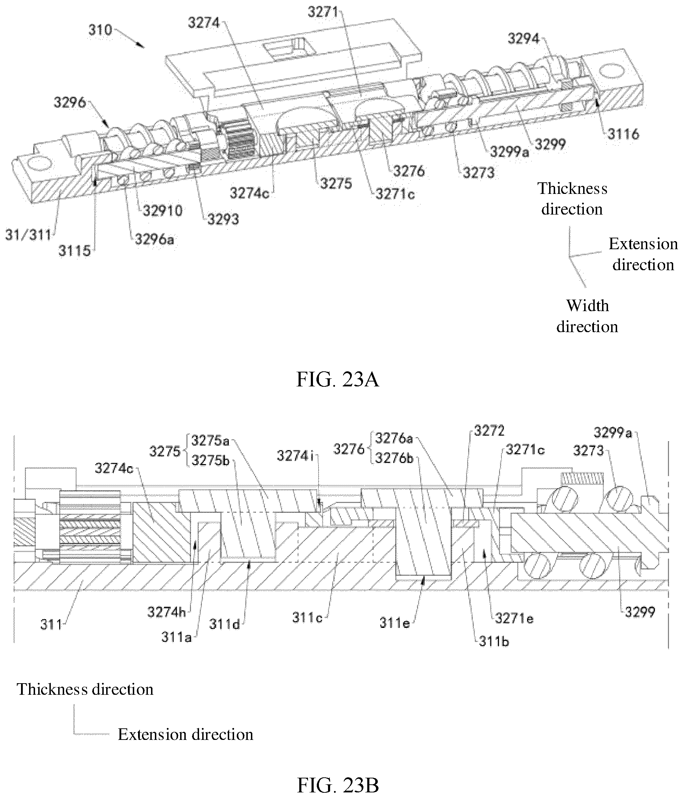

Refer to FIG. 19, FIG. 23A, and FIG. 23B. FIG. 23A is a diagram of a cross-sectional structure that is of the structure shown in FIG. 22 and that is cut along E-E. FIG. 23B is a diagram of a partial structure of the structure shown in FIG. 23A.

In some embodiments, the limiting member 3274 is fastened to the main inner shaft 311 by using the first fastener 3275, and the stop member 3271 is fastened to the main inner shaft 311 by using the second fastener 3276. The first boss 311a of the main inner shaft 311 may be at least partially located in the first through hole 3274h of the limiting member 3274, the second boss 311b is at least partially located in the second sink 3271e of the stop member 3271, and the connecting boss 311c is at least partially located in the first groove 3274j of the limiting member 3274 and the second groove 3271f of the stop member 3271. The plurality of bosses of the main inner shaft 311 can pre-position the limiting member 3274 and the stop member 3271, and help improve structural stability after assembly.

One end of the first fastener 3275 is connected to the third fastening part 3274c of the limiting member 3274, and the other end is connected to the main inner shaft 311, to mount the limiting member 3274 on the main shaft 31. For example, the first fastener 3275 may include a limiting end 3275a and a connecting end 3275b fastened to one side of the limiting end 3275a. The connecting end 3275b of the first fastener 3275 extends into the first mounting hole 311d of the first boss 311a, and is fastened to the first boss 311a. The limiting end 3275a of the first fastener 3275 may be at least partially located in the first sink 3274i, and abuts against a bottom wall of the first sink 3274i. The limiting end 3275a of the first fastener 3275 presses the limiting member 3274 tightly on the main inner shaft 311.

The connecting end 3275b of the first fastener 3275 may be provided with an outer thread (not shown in the figure), and a hole wall of the first mounting hole 311d may form an inner thread (not shown in the figure). The connecting end 3275b of the first fastener 3275 is threadedly connected to the first boss 311a, to implement a fastened connection between the first fastener 3275 and the main inner shaft 311. In some other embodiments, the connecting end 3275b of the first fastener 3275 and the first boss 311a may also be fastened in another manner, for example, clamping. This is not strictly limited in embodiments of this application. In some other embodiments, the first sink 3274i may not be provided on the limiting member 3274, and the limiting end 3275a of the first fastener 3275 abuts against a surface that is of the limiting member 3274 and that faces away from the first boss 311a.

One end of the second fastener 3276 is connected to the mounting part 3271c of the stop member 3271, and the other end is threadedly connected to the main inner shaft 311, to mount the stop member 3271 on the main shaft 31. For example, the second fastener 3276 may include a limiting end 3276a and a connecting end 3276b fastened to one side of the limiting end 3276a. The connecting end 3276b of the second fastener 3276 extends into the second mounting hole 311e of the second boss 311b, and is fastened to the second boss 311b. The connecting end 3276b of the second fastener 3276 may be provided with an outer thread (not shown in the figure), and a hole wall of the second mounting hole 311e may form an inner thread (not shown in the figure). The connecting end 3276b of the second fastener 3276 is threadedly connected to the second boss 311b, to implement a fastened connection between the second fastener 3276 and the main inner shaft 311. In this embodiment, because a fastened connection manner between the second fastener 3276 and the main inner shaft 311 is a threaded connection, a relative position between the second fastener 3276 and the main inner shaft 311 is adjustable.

The limiting end 3276a of the second fastener 3276 is located on a side that is of the mounting part 3271c of the stop member 3271 and that faces away from to the second boss 311b, the first elastic member 3272 abuts between the mounting part 3271c of the stop member 3271 and the main inner shaft 311, and the limiting end 3276a of the second fastener 3276 and the first elastic member 3272 limit the mounting part 3271c of the stop member 3271, so that the stop member 3271 is fixed in relative to the main shaft 31.

The first elastic member 3272 may be located in the second sink 3271e, and is located between the mounting part 3271c of the stop member 3271 and a top surface of the second boss 311b. In some other embodiments, the first elastic member 3272 may alternatively be located outside the second sink 3271e, and the first elastic member 3272 may be located between the mounting part 3271c of the stop member 3271 and another structure of the main inner shaft 311. This is not strictly limited in embodiments of this application. In some other embodiments, a sink may be provided on a side that is of the mounting part 3271c of the stop member 3271 and that faces away from the main inner shaft 311, and the limiting end 3276a of the second fastener 3276 may be at least partially located in the sink.

For example, two ends of the second elastic member 3273 respectively abut against the limiting flange 3299a of the third rotating shaft 3299 and the mounting part 3271c of the stop member 3271, and one end that is of the third rotating shaft 3299 and that is away from the second elastic member 3273 is mounted in one of the mounting grooves 3116 of the main inner shaft 311. The second elastic member 3273 is in a compressed state, and an elastic force generated by the second elastic member 3273 enables the third rotating shaft 3299 to abut against the main inner shaft 311, and further enables the stop member 3271 to tend to approach the limiting member 3274, so that the stop member 3271 is enabled to abut against the limiting member 3274. In some other embodiments, no limiting flange 3299a may alternatively be disposed on the third rotating shaft 3299, and one end that is of the second elastic member 3273 and that is away from the stop member 3271 may abut against the fourth clamping member 3294 or the main inner shaft 311. The second elastic member 3273 may also be in the compressed state, to generate an elastic force, so that the stop member 3271 abuts against the limiting member 3274.

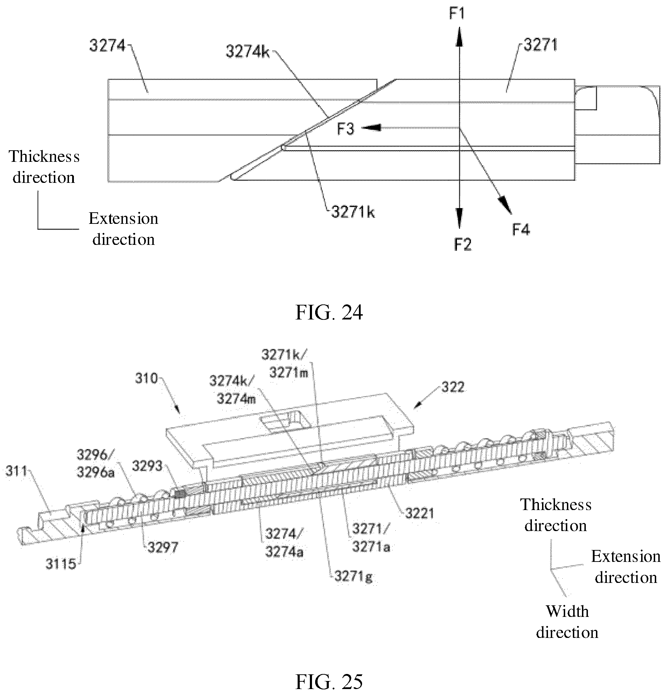

Refer to FIG. 23A and FIG. 24. FIG. 24 is a diagram of an assembled structure of the limiting member 3274 and the stop member 3271 shown in FIG. 22.

In this embodiment, the first elastic member 3272 applies a first acting force F1 to the stop member 3271, where the first acting force F1 is an elastic force of the first elastic member 3272, and the first acting force F1 is parallel to the thickness direction of the main shaft 31 and faces away from the main inner shaft 311. The limiting end 3276a of the second fastener 3276 applies a second acting force F2 to the stop member 3271, where the second acting force F2 is parallel to the thickness direction of the main shaft 31 and faces the main inner shaft 311. The second elastic member 3273 applies a third acting force F3 to the stop member 3271, where the third acting force F3 is an elastic force of the second elastic member 3273, and the third acting force F3 is parallel to the extension direction of the main shaft 31 and faces the limiting member 3274. The limiting member 3274 applies a fourth acting force F4 to the stop member 3271, where the fourth acting force F4 is a support force of the limiting member 3274 to the stop member 3271, and the fourth acting force F4 is inclined relative to the extension direction of the main shaft 31 and inclined relative to the thickness direction of the main shaft 31. In the electronic device 100, the stop member 3271 is jointly limited by a plurality of structural members, and the stop member 3271 is fixed in relative to the main inner shaft 311.

For example, the limiting surface 3274k is inclined relative to the thickness direction of the main shaft 31 and inclined relative to the extension direction of the main shaft 31. In this case, the limiting surface 3274k limits the stop member 3271 in the thickness direction of the main shaft 31 and the extension direction of the main shaft 31, and the third acting force F3 applied by the limiting member 3274 to the stop member 3271 by using the limiting surface 3274k is also inclined relative to the thickness direction of the main shaft 31 and inclined relative to the extension direction of the main shaft 31.

For example, the adjusting surface 3271k may be parallel to the limiting surface 3274k and contact the limiting surface 3274k, and the adjusting surface 3271k is in surface contact with the contact surface. Therefore, a contact area between the adjusting surface 3271k and the limiting surface 3274k is large, and an abutting relationship is stable, and the limiting member 3274 can limit the stop member 3271, to ensure that a relative position relationship between the stop member 3271 and the main shaft 31 is stable.

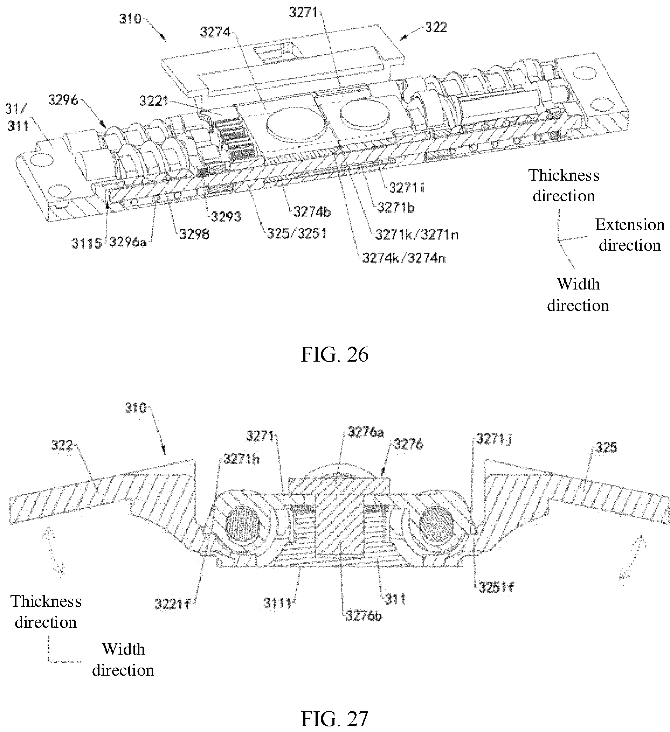

Refer to FIG. 23A, FIG. 25, and FIG. 26. FIG. 25 is a diagram of a cross-sectional structure that is of the structure shown in FIG. 22 and that is cut along F-F. FIG. 26 is a diagram of a cross-sectional structure that is of the structure shown in FIG. 22 and that is cut along G-G.

In some embodiments, as shown in FIG. 23A, one end of the fourth rotating shaft 32910 is mounted in one of the mounting holes 3115 of the main inner shaft 311, and two ends that are of the second spring 3296a in the second elastic component 3296 and that are sleeved on the fourth rotating shaft 32910 respectively abut the main inner shaft 311 and the third clamping member 3293. As shown in FIG. 25, one end of the first rotating shaft 3297 is mounted in the other mounting hole 3115 of the main inner shaft 311, and the other end is mounted in the other mounting groove 3116 of the main inner shaft 311. Two ends that are of the second spring 3296a in the second elastic component 3296 and that are sleeved on the first rotating shaft 3297 respectively abut against the main inner shaft 311 and the third clamping member 3293. As shown in FIG. 26, one end of the second rotating shaft 3298 is mounted in the other mounting hole 3115 of the main inner shaft 311, and the other end is mounted in the other mounting groove 3116 of the main inner shaft 311. Two ends that are of the second spring 3296a in the second elastic component 3296 and that are sleeved on the second rotating shaft 3298 respectively abut against the main inner shaft 311 and the third clamping member 3293.

Under elastic forces of a plurality of second springs 3296a of the second elastic component 3296, the entire adjustable rotating mechanism 310 tends to move toward a direction away from the mounting hole 3115 of the main inner shaft 311, and a side that is of the adjustable rotating mechanism 310 and that is away from the second elastic component 3296 abuts against the main inner shaft 311, for example, one end that is of the first rotating shaft 3297 and that is away from the second elastic component 3296 and one end that is of the second rotating shaft 3298 and that is away from the second elastic component 3296 may abut against the main inner shaft 311, so that the relative position relationship between the adjustable rotating mechanism 310 and the main inner shaft 311 is stable. In addition, because the limiting member 3274 is fastened to the main inner shaft 311, under an elastic force of the second elastic component 3296, a friction surface is formed between the first end part 3221 of the first swing arm 322 and the limiting member 3274, and a friction surface is formed between the first end part 3251 of the second swing arm 325 and the limiting member 3274. When the first swing arm 322 and the second swing arm 325 are rotated relative to each other, a friction torque is formed on the friction surface, and a damping force is generated. In this way, when the user rotates the first housing 1 and the second housing 2, a hand feeling is stable, and user experience is good.

In some other embodiments, the adjustable rotating mechanism 310 may not include the second elastic component 3296. The adjustable rotating mechanism 310 may implement a stable relative position relationship with the main inner shaft 311 by using another structure, or may provide, by using another structure, a damping force during relative rotation between the first swing arm 322 and the second swing arm 325. This is not strictly limited in embodiments of this application.

It may be understood that the connecting structures between the plurality of rotating shafts (3297, 3298, 3299, and 32910) of the adjustable rotating mechanism 310 and the main inner shaft 311 are example structures, and the plurality of rotating shafts (3297, 3298, 3299, and 32910) may also be connected to the main inner shaft 311 by using other implementations. This is not strictly limited in embodiments of this application.

For example, as shown in FIG. 23A, FIG. 25, and FIG. 26, the third fastening part 3274c of the limiting member 3274 is fastened to the main inner shaft 311 by using the first fastener 3275, the first rotating shaft 3297 is inserted into the first fastening part 3274a of the limiting member 3274 and one of the mounting holes 3115 of the main inner shaft 311, and the second rotating shaft 3298 is inserted into the second fastening part 3274b of the limiting member 3274 and the other mounting hole 3115 of the main inner shaft 311. Therefore, positions of the first rotating shaft 3297 and the second rotating shaft 3298 relative to the main inner shaft 311 are fastened in the thickness direction of the main shaft 31 and the width direction of the main shaft 31. Because the first rotating shaft 3297 is further inserted into the first end part 3221 of the first swing arm 322, the first swing arm 322 can be rotatably connected to the main inner shaft 311 through the first rotating shaft 3297, to be rotatably connected to the main shaft 31. Because the second rotating shaft 3298 is further inserted into the first end part 3251 of the second swing arm 325, the second swing arm 325 can be rotatably connected to the main inner shaft 311 through the second rotating shaft 3298, to be rotatably connected to the main shaft 31.

In this embodiment, because the limiting member 3274 is fastened to the main inner shaft 311, the first rotating shaft 3297 and the second rotating shaft 3298 are mounted on the main inner shaft 311, the first rotating shaft 3297 is inserted into both the first end part 3221 of the first swing arm 322 and the first fastening part 3274a, and the second rotating shaft 3298 is inserted into both the first end part 3251 of the second swing arm 325 and the second fastening part 3274b, when the first swing arm 322 and the second swing arm 325 are rotated relative to each other, rotation actions are stable and are not prone to shake, which helps improve reliability of the foldable assembly 3. In addition, the first fastening part 3274a is further clamped into the first end part 3221 of the first swing arm 322, and the second fastening part 3274b is further clamped into the first end part 3251 of the second swing arm 325. This helps further improve stability of the rotation actions of the first swing arm 322 and the second swing arm 325.

In addition, as shown in FIG. 25 and FIG. 26, because the first rotating shaft 3297 further passes through the first adjusting hole 3271g of the first stop part 3271a of the stop member 3271, the first stop part 3271a of the stop member 3271 abuts against the first fastening part 3274a of the limiting member 3274, the second rotating shaft 3298 further passes through the second adjusting hole 3271i of the second stop part 3271b of the stop member 3271, and the second stop part 3271b of the stop member 3271 abuts against the second fastening part 3274b of the limiting member 3274, positions of the first stop part 3271a and the second stop part 3271b of the stop member 3271 are stable, the risk of deformation is low, thereby improving the stop reliability.

For example, as shown in FIG. 25 and FIG. 26, the first part 3274m of the limiting surface 3274k is located at the first fastening part 3274a of the limiting member 3274, the first fastening part 3274a is sleeved on the first rotating shaft 3297, the second part 3274n of the limiting surface 3274k is located at the second fastening part 3274b of the limiting member 3274, and the second fastening part 3274b is sleeved on the second rotating shaft 3298. Therefore, when the limiting surface 3274k is subject to a force, positions of the first part 3274m of the limiting surface 3274k and the second part 3274n of the limiting surface 3274k are stable, the limiting surface 3274k and the limiting member 3274 are not prone to deform, and structural stability is high. In this way, the limiting member 3274 can limit the stop member 3271, to reinforce the stop member 3271, thereby improving stop reliability of the stop member 3271.

For example, as shown in FIG. 25, the first part 3274m of the limiting surface 3274k of the limiting member 3274 is inclined relative to the thickness direction of the main shaft 31 and inclined relative to the extension direction of the main shaft 31. The first part 3271m of the adjusting surface 3271k of the stop member 3271 abuts against the first part 3274m of the limiting surface 3274k of the limiting member 3274. The first part 3271m of the adjusting surface 3271k may be parallel to the first part 3274m of the limiting surface 3274k, and the first part 3271m of the adjusting surface 3271k is in surface contact with the first part 3274m of the limiting surface 3274k. As shown in FIG. 26, the second part 3274n of the limiting surface 3274k is inclined relative to the thickness direction of the main shaft 31 and inclined relative to the extension direction of the main shaft 31. The second part 3271n of the adjusting surface 3271k of the stop member 3271 abuts against the second part 3274n of the limiting surface 3274k of the limiting member 3274. The second part 3271n of the adjusting surface 3271k may be parallel to the second part 3274n of the limiting surface 3274k, and the second part 3271n of the adjusting surface 3271k is in surface contact with the second part 3274n of the limiting surface 3274k.

In this embodiment, the adjusting surface 3271k is parallel to the limiting surface 3274k and contacts the limiting surface 3274k, the adjusting surface 3271k is in surface contact with the contact surface, and two parts of the limiting surface 3274k are in one-to-one contact with two parts of the adjusting surface 3271k. Therefore, a contact area between the adjusting surface 3271k and the limiting surface 3274k is large and an abutting relationship is stable, and the limiting member 3274 can limit the stop member 3271, to ensure that a relative position relationship between the stop member 3271 and the main shaft 31 is stable.

FIG. 27 is a diagram of a cross-sectional structure that is of the structure shown in FIG. 22 and that is cut along H-H.

In some embodiments, the first swing arm 322 is rotatably connected to the main inner shaft 311, and the second swing arm 325 is rotatably connected to the main inner shaft 311. When the first swing arm 322 and the second swing arm 325 are unfolded to an open state, the first stop end surface 3221f of the first swing arm 322 at least partially abuts against the first stop surface 3271h of the stop member 3271, the second stop end surface 3251f of the second swing arm 325 at least partially abuts against the second stop surface 3271j of the stop member 3271. In this embodiment of this application, that the first stop end surface 3221f at least partially abuts against the first stop surface 3271h includes a case in which a partial region of the first stop end surface 3221f abuts against the first stop surface 3271h, and also a case in which an entire region of the first stop end surface 3221f abuts against the first stop surface 3271h. That the second stop end surface 3251f at least partially abuts against the second stop surface 3271j includes a case in which a partial region of the second stop end surface 3251f abuts against the second stop surface 3271j, and a case in which an entire region of the second stop end surface 3251f abuts against the second stop surface 3271j.

In this embodiment, because the stop member 3271 is limited by a plurality of structural members and is fixed in relative to the main inner shaft 311, the stop member 3271 can prevent the first swing arm 322 and the second swing arm 325 from being rotated relative to each other at an excessively large angle, thereby preventing the first fastening bracket 321 and the second fastening bracket 324 from being rotated relative to each other at an excessively large angle, and preventing the first housing 1 and the second housing 2 from being rotated relative to each other at an excessively large angle. Therefore, the stop member 3271 stops the first swing arm 322 and the second swing arm 325, to prevent the first housing 1 and the second housing 2 from being overfolded when the electronic device 100 is in the open state. This prevents the flexible display 20 from being pulled by the first housing 1 and the second housing 2, improves reliability of the flexible display 20, and prolongs a service life of the flexible display 20.

In addition, due to stop effect of the stop member 3271, an included angle between the first housing 1 and the second housing 2 in the open state is equal to a preset value. For example, the preset value may be 180°, and the first housing 1 and the second housing 2 are in a flat form when being in the open state. The foldable apparatus 10 can provide a flat supporting environment for the flexible display 20, and flatness of the flexible display 20 is good. This helps optimize overall light and shadow of the electronic device 100.

In addition, the first stop surface 3271h and the second stop surface 3271j are disposed on a same stop member 3271, and the first swing arm 322 and the second swing arm 325 are stopped by using the same stop member 3271. This can effectively reduce a quantity of stop members 3271 required by the foldable assembly 3, reduce a space occupied by the stop member 3271 inside the foldable assembly 3, and help reduce costs.

In this embodiment, with reference to FIG. 25 and FIG. 26, because the limiting member 3274 is fastened to the main inner shaft 311, and the limiting member 3274 can limit the stop member 3271, structural stability and structural rigidity of the stop member 3271 relative to the main inner shaft 311 can be improved, and the stop member 3271 can stop the first swing arm 322 and the second swing arm 325. In this way, good stop effect is achieved, and an unfolded state of the foldable assembly 3 and the electronic device 100 is stable and reliable.

The first stop surface 3271h and the second stop surface 3271j may be of a symmetric structure or a basically symmetric structure. In this embodiment, the first stop surface 3271h and the second stop surface 3271j are symmetric with respect to a plane, and the plane may be parallel to the thickness direction of the main shaft 31. In this case, when the first swing arm 322 and the second swing arm 325 are unfolded relative to each other to the open state, the first stop end surface 3221f of the first swing arm 322 abuts against the first stop surface 3271h, and the second stop end surface 3251f of the second swing arm 325 abuts against the second stop surface 3271j. A stop process of stopping the first swing arm 322 and the second swing arm 325 by the stop member 3271 is easy to control, and stop effect is better. In addition, symmetry between the first stop surface 3271h and the second stop surface 3271j also helps reduce processing difficulty of the stop member 3271. The first stop end surface 3221f of the first swing arm 322 and the second stop end surface 3251f of the second swing arm 325 may be of a symmetric structure or a basically symmetric structure. It may be understood that, in embodiments of this application, "the surface and the surface are of a basically symmetric structure" means that positions of the two surfaces are symmetric, but a difference is allowed between shapes and areas of the two surfaces. In some other embodiments, the first stop surface 3271h and the second stop surface 3271j may not be of a symmetric structure, and a cooperation structure of the first stop surface 3271h and the first swing arm 322 may be different from a cooperation structure of the second stop surface 3271j and the second swing arm 325.

For example, a friction layer (not shown in the figure) is disposed on the limiting surface 3274k and/or a friction layer is disposed on the adjusting surface 3271k, and the friction layer is configured to increase a static friction coefficient between the limiting surface 3274k and the adjusting surface 3271k. For example, the friction layer may be disposed on the limiting surface 3274k. The friction layer may be fastened to the limiting surface 3274k through assembly, and the friction layer may be made of a material with a high static friction coefficient, for example, a frosted film material, or a film material with a concavo-convex texture. Alternatively, the friction layer may perform surface roughening processing on the limiting surface 3274k, so that a surface layer of the limiting surface 3274k forms the friction layer. The surface roughening process is the conventional technology, and details are not described herein. Similarly, the friction layer may alternatively be disposed on the adjusting surface 3271k. For formation of the friction layer, refer to related descriptions of the friction layer on the limiting surface 3274k. Details are not described herein again.

In this embodiment, the static friction coefficient between the limiting surface 3274k and the adjusting surface 3271k is increased, so that the static friction force between the limiting surface 3274k and the adjusting surface 3271k is increased, and the abutting relationship between the limiting surface 3274k and the adjusting surface 3271k is stable. When the stop member 3271 is subject to acting forces of the first swing arm 322 and the second swing arm 325, the limiting surface 3274k and the adjusting surface 3271k of the stop member 3271 are not prone to separate from the contact relationship, so that stop reliability can be improved.

It may be understood that, in a process of part manufacturing and assembling of the foldable apparatus 10, a slight deviation is easily to occur due to a device, a process, or the like. Consequently, product precision after the foldable apparatus 10 is assembled is insufficient, for example, a deviation exists between an angle between two housings in the open state and a preset value. In embodiments of this application, after the entire foldable apparatus 10 is assembled, the included angle between the first housing 1 and the second housing 2 in the open state may be further detected. If the included angle between the first housing 1 and the second housing 2 deviates from the preset value, the included angle between the first swing arm 322 and the second swing arm 325 and the included angle between the first fastening bracket 321 and the second fastening bracket 324 may be adjusted by adjusting a relative position between the stop member 3271 and the main inner shaft 311, so that the angle between the first housing 1 and the second housing 2 can be adjusted to the preset value.

As shown in FIG. 27, because the connecting end 3276b of the second fastener 3276 is threadedly connected to the main inner shaft 311, and a position of the second fastener 3276 relative to the main inner shaft 311 is adjustable, the limiting end 3276a of the second fastener 3276 may move in the thickness direction of the main shaft 31, and the stop member 3271 can move with the limiting end 3276a of the second fastener 3276 in the thickness direction of the main shaft 31 under cooperation between the limiting end 3276a of the second fastener 3276 and the first elastic member 3272, to perform position adjustment.

Neither the first stop surface 3271h nor the second stop surface 3271j of the stop member 3271 is parallel to the thickness direction of the main shaft 31, that is, both the first stop surface 3271h and the second stop surface 3271j are inclined relative to the thickness direction of the main shaft 31. When the stop member 3271 moves in the thickness direction of the main shaft 31, the first stop surface 3271h and the second stop surface 3271j move in the thickness direction of the main shaft 31. When the first swing arm 322 and the second swing arm 325 are in the open state, a position of the first stop end surface 3221f of the first swing arm 322 changes with the first stop surface 3271h, and a position of the second stop end surface 3251f of the second swing arm 325 changes with the second stop surface 3271j. In this way, the included angle between the first swing arm 322 and the second swing arm 325 can be adjusted by adjusting a position of the stop member 3271.

For example, after the foldable apparatus 10 is assembled, if the included angle between the first housing 1 and the second housing 2 exceeds the preset value, that is, the included angle between the first housing 1 and the second housing 2 is excessively large, and the included angle between the first swing arm 322 and the second swing arm 325 is also excessively large, the second fastener 3276 may be further tightened, so that the limiting end 3276a of the second fastener 3276 moves in a direction close to the main inner shaft 311, the stop member 3271 moves in the direction close to the main inner shaft 311, and the first stop surface 3271h and the second stop surface 3271j move in the direction close to the main supporting surface 3111 close to the main inner shaft 311. In this case, the included angle between the first swing arm 322 and the second swing arm 325 is reduced in the open state, so that the included angle between the first housing 1 and the second housing 2 is adjusted to the preset value. If the included angle between the first housing 1 and the second housing 2 is less than the preset value, that is, the included angle between the first housing 1 and the second housing 2 is excessively small, and the included angle between the first swing arm 322 and the second swing arm 325 is also excessively small, the second fastener 3276 may be loosened, so that the limiting end 3276a of the second fastener 3276 moves in a direction away from the main inner shaft 311, the stop member 3271 moves in the direction away from the main inner shaft 311, and the first stop surface 3271h and the second stop surface 3271j move in the direction away from the main supporting surface 3111 of the main inner shaft 311. In this case, the included angle between the first swing arm 322 and the second swing arm 325 increases in the open state, so that the included angle between the first housing 1 and the second housing 2 is adjusted to the preset value.

For example, both the first stop surface 3271h and the second stop surface 3271j of the stop member 3271 may be perpendicular to the thickness direction of the main shaft 31. Alternatively, an included angle between the first stop surface 3271h and the thickness direction of the main shaft 31 is greater than or equal to 45°, for example, may range from 60° to 90°; and an included angle between the second stop surface 3271j and the thickness direction of the main shaft 31 is greater than or equal to 45°, for example, may range from 60° to 90°. In this case, when the first stop surface 3271h and the second stop surface 3271j move with the stop member 3271 in the thickness direction of the main shaft 31, the included angle between the first swing arm 322 and the second swing arm 325 may be effectively adjusted through small displacement.

In this application, as shown in FIG. 24 and FIG. 27, the limiting surface 3274k is inclined relative to the thickness direction of the main shaft 31 and inclined relative to the extension direction of the main shaft 31, and the stop member 3271 abuts against the limiting surface 3274k of the limiting member 3274 under the first acting force F1 of the first elastic member 3272 and the third acting force F3 of the second elastic member 3273, so that the stop member 3271 is limited by the limiting surface 3274k in a position adjustment process, and the stop member 3271 moves in both the thickness direction of the main shaft 31 and the extension direction of the main shaft 31.

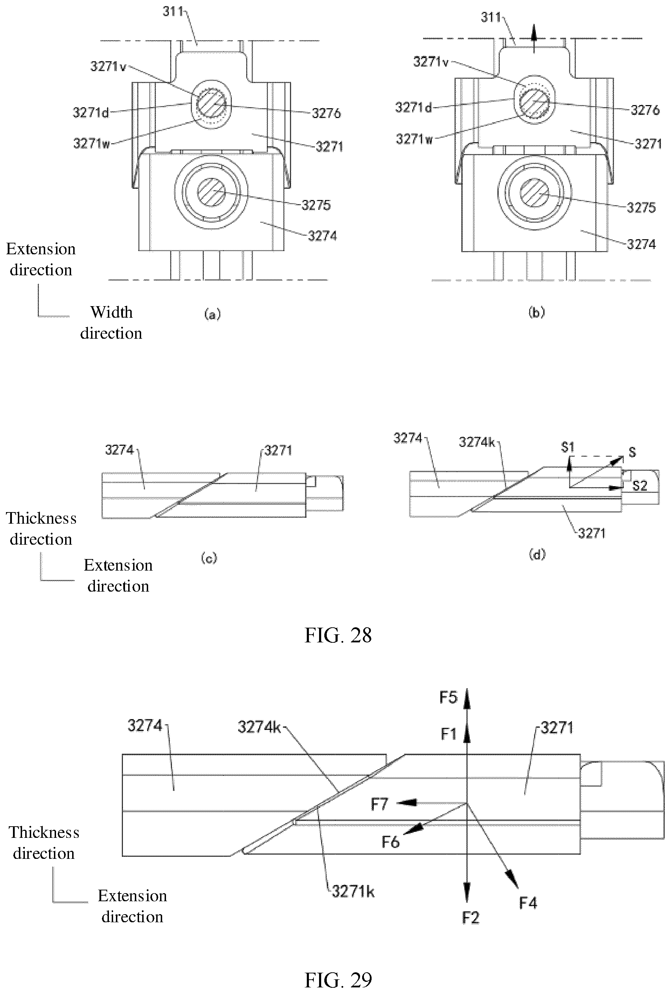

Refer to FIG. 23B and FIG. 28. FIG. 28 is a diagram of a partial structure of the stop member 3271 shown in FIG. 22 in a position adjustment process. In FIG. 28, (a) corresponds to (c), and (b) corresponds to (d).

In this embodiment, in the position adjustment process of the stop member 3271, the first fastener 3275 always fastens the limiting member 3274 to the main inner shaft 311, positions of the limiting member 3274 and the main inner shaft 311 are fixed in relative to each other, and the second fastener 3276 may be rotated (for example, be tightened or loosened) relative to the main inner shaft 311, so that the limiting end 3276a of the second fastener 3276 moves in the thickness direction of the main shaft 31, and the stop member 3271 can move in the thickness direction of the main shaft 31 and the extension direction of the main shaft 31, to perform position adjustment.

For example, the second through hole 3271d of the stop member 3271 has at least two stay positions, the at least two stay positions are arranged in the extension direction of the main shaft 31, and the second fastener 3276 passes through one of the stay positions. When the second fastener 3276 passes through the stay position of the stop member 3271, and the second fastener 3276 is threadedly connected to the main inner shaft 311, the stop member 3271 stays at a position relative to the main inner shaft 311, and a relative position relationship between the two is stable and reliable. When the second fastener 3276 switches from one of the stay positions of the stop member 3271 to the other stay position, the stay position of the stop member 3271 relative to the main inner shaft 311 changes, and the stop member 3271 and the main inner shaft 311 are still fixed in relative to each other after the change. For example, the second through hole 3271d has a first stay position 3271v and a second stay position 3271w. As shown in (a) in FIG. 28, the second fastener 3276 passes through the first stay position 3271v and is connected to the main inner shaft 311, the stop member 3271 stays at a first position, the first position is shown in (c) in FIG. 28, and the stop member 3271 is fixed in relative to the main inner shaft 311. As shown in (b) in FIG. 28, the second fastener 3276 passes through the second stay position 3271w and is connected to the main inner shaft 311, the stop member 3271 stays at a second position, the second position is shown in (d) in FIG. 28, and the stop member 3271 is fixed in relative to the main inner shaft 311. As indicated by an arrow in (d) in FIG. 28, displacement of the stop member 3271 in the thickness direction of the main shaft 31 is S1, displacement of the stop member 3271 in the extension direction of the main shaft 31 is S2, a resultant of the displacement S1 and the displacement S2 is displacement S, a direction of the displacement S is parallel to the limiting surface 3274k, and the stop member 3271 moves from the first position to the second position through the displacement S.

In some embodiments, the second through hole 3271d may further include a third stay position and the like. In other words, the second through hole 3271d may include more than three stay positions, and the stop member 3271 can correspondingly stay at more than three positions, to meet adjustment requirements.

In the embodiment shown in FIG. 28, the second through hole 3271d is a kidney-shaped hole, and a length direction of the second through hole 3271d may be parallel to the extension direction of the main shaft 31, so that the second through hole 3271d has a plurality of stay positions arranged in the extension direction of the main shaft 31. In this embodiment, the length direction of the second through hole 3271d is parallel to the extension direction of the main shaft 31, so that the plurality of stay positions may be arranged in the extension direction of the main shaft 31, the stop member 3271 can be continuously adjusted in the extension direction of the main shaft 31, the first stop end surface 3221f and the second stop end surface 3251f can be continuously adjusted in the thickness direction of the main shaft 31, and the angle between the first swing arm 322 and the second swing arm 325 in the open state can be continuously adjusted. In addition, two straight edges of the kidney-shaped hole further have a guiding function. When the included angle between the first swing arm 322 and the second swing arm 325 is adjusted, the stop member 3271 is not prone to offset in the width direction of the main shaft 31, the stop member 3271 does not squeeze the first rotating shaft 3297 or the second rotating shaft 3298, and a relative position relationship between the adjustable rotating mechanism 310 and the main shaft 31 in the width direction of the main shaft 31 is stable.

In some other embodiments, the second through hole 3271d may alternatively be a rectangular hole, the rectangular hole includes two long edges disposed opposite to each other and two short edges disposed opposite to each other, and a length direction of the second through hole 3271d is parallel to the extension direction of the main shaft 31. Therefore, the plurality of stay positions are arranged in the extension direction of the main shaft 31, the length direction of the second through hole 3271d is a direction from one short edge to the other short edge, and the length direction of the second through hole 3271d is parallel to the long edge. A specific shape of the second through hole 3271d is not strictly limited in embodiments of this application. The second through hole 3271d provides the plurality of stay positions arranged in the extension direction of the main shaft 31.

In some other embodiments, the mounting part 3271c of the stop member 3271 may alternatively include a plurality of second through holes 3271d, the plurality of second through holes 3271d are arranged in the extension direction of the main shaft 31, and the plurality of second through holes 3271d are spaced apart from each other or partially overlap. Each second through hole 3271d has a stop position, so that the mounting part 3271c of the stop member 3271 has a plurality of stop positions arranged in the extension direction of the main shaft 31, and the second fastener 3276 passes through one of the stop positions. In this application, the foldable assembly 3 may alternatively implement, by using another solution, that the stop member 3271 is adjustable relative to the second fastener 3276 in the extension direction of the main shaft 31. This is not strictly limited in embodiments of this application.

Refer to FIG. 27 and FIG. 29. FIG. 29 is a diagram of the stop member 3271 and the limiting member 3274 shown in FIG. 22 in some other embodiments.

In some other embodiments, the adjustable rotating mechanism 310 may not include the second elastic member 3273, a static friction force may exist between the limiting surface 3274k of the limiting member 3274 and the stop member 3271, and a static friction force may exist between the stop member 3271 and the first elastic member 3272. For example, when the first swing arm 322 and the second swing arm 325 are in the open state, the first elastic member 3272 applies a first acting force F1 to the stop member 3271, where the first acting force F1 is an elastic force of the first elastic member 3272, and the first acting force F1 is parallel to the thickness direction of the main shaft 31 and faces away from the main inner shaft 311; the first swing arm 322 and the second swing arm 325 apply a fifth acting force F5 to the stop member 3271, where the fifth acting force F5 is parallel to the thickness direction of the main shaft 31 and faces away from the main inner shaft 311; the limiting end 3276a of the second fastener 3276 applies a second acting force F2 to the stop member 3271, where the second acting force F2 is parallel to the thickness direction of the main shaft 31 and faces the main inner shaft 311; and the limiting member 3274 applies a fourth acting force F4 and a sixth acting force F6 to the stop member 3271, where the fourth acting force F4 is a supporting force of the limiting member 3274 on the stop member 3271, the fourth acting force F4 is inclined relative to the extension direction of the main shaft 31 and inclined relative to the thickness direction of the main shaft 31, the fourth acting force F4 is biased toward the main inner shaft 311 and deviates from the limiting member 3274, the sixth acting force F6 is a static friction force between the limiting surface 3274k of the limiting member 3274 and the stop member 3271, the sixth acting force F6 is inclined relative to the extension direction of the main shaft 31 and inclined relative to the thickness direction of the main shaft 31, and the seventh limiting member 3274 is biased toward the main inner shaft 311 and biased toward the limiting member 3274.

In this embodiment, the adjustable rotating mechanism 310 balances, by using a static friction force (namely, the sixth acting force F6) between the limiting member 3274 and the stop member 3271, a component force of a supporting force (namely, the fourth acting force F4) of the limiting member 3274 on the stop member 3271 in the extension direction of the main shaft 31, so that a position of the stop member 3271 relative to the main inner shaft 311 is stable, and stop effect of the stop member 3271 on the first swing arm 322 and the second swing arm 325 is reliable.

When a friction layer is disposed on the limiting surface 3274k and/or the adjusting surface 3271k, a static friction coefficient between the limiting surface 3274k of the limiting member 3274 and the adjusting surface 3271k of the stop member 3271 is large, so that a static friction force between the limiting surface 3274k and the adjusting surface 3271k is large, the limiting member 3274 can limit the stop member 3271, and stop effect of the stop member 3271 on the first swing arm 322 and the second swing arm 325 is reliable.

In some embodiments, a structure of the first elastic member 3272 may be designed, so that when the first swing arm 322 and the second swing arm 325 are in the open state, the first elastic member 3272 applies a seventh acting force F7 to the stop member 3271, the seventh acting force F7 is a static friction force between the first elastic member 3272 and the stop member 3271, and a direction of the seventh acting force F7 is parallel to the extension direction of the main shaft 31 and faces the limiting member 3274. For example, the first elastic member 3272 is an elastic washer, or the first elastic member 3272 includes a spring washer and a flat washer that are stacked. In these solutions, an abutting structure between the first elastic member 3272 and the stop member 3271 and an abutting structure between the first elastic member 3272 and the main inner shaft 311 cause a static friction force to be formed between the first elastic member 3272 and the stop member 3271, and the first elastic member 3272 applies the seventh acting force F7 to the stop member 3271. In this embodiment, the seventh acting force F7 may cooperate with the sixth acting force F6, to balance a component force of the fourth acting force F4 in the extension direction of the main shaft 31, to improve structural stability of the stop member 3271. This ensures stop effect on the first swing arm 322 and the second swing arm 325.

It may be understood that a value relationship between the sixth force F6 and the seventh force F7 is not limited in embodiments of this application. In the adjustable rotating mechanism 310, the sixth acting force F6 may exist alone, or the seventh acting force F7 may exist alone, or both the sixth acting force F6 and the seventh acting force F7 exist. A structure of the adjustable rotating mechanism 310 adaptively changes.

It may be understood that, in the foregoing embodiments, the stop member 3271 is disposed with the adjusting surface 3271k, and the adjusting surface 3271k is parallel to the limiting surface 3274k and contacts the limiting surface 3274k. In this way, a contact area between the adjusting surface 3271k and the limiting surface 3274k is large, and a contact relationship between the stop member 3271 and the limiting member 3274 is stable. In some other embodiments, the adjusting surface 3271k may alternatively be a curved surface or a surface of another shape, and the adjusting surface 3271k may not be parallel to the limiting surface 3274k. Alternatively, the stop member 3271 may not be disposed with the adjusting surface 3271k, and the stop member 3271 may be provided with an abutting structure like a protrusion or a bump, provided that the abutting structure abuts against the limiting surface 3274k.

In the foregoing embodiments, the limiting surface 3274k of the limiting member 3274 includes the first part 3274m and the second part 3274n. In some other embodiments, the limiting surface 3274k may alternatively include only the first part 3274m or only the second part 3274n, or in addition to the first part 3274m and the second part 3274n, more parts (for example, a third part) are further included. This is not strictly limited in embodiments of this application. For positions of one or more parts included in the limiting surface 3274k, the solution in the foregoing embodiment may be used, or there may be another implementation solution. This is not strictly limited in embodiments of this application. Similarly, the stop member 3271 may be adaptively changed, and details are not described herein.

It may be understood that, in some other embodiments, the adjustable rotating mechanism 310 may not be disposed with the limiting member 3274, and the adjustable rotating mechanism 310 is fastened to the main shaft 31 by using the stop member 3271. In this case, a structure of the entire foldable assembly 3 is simple, which facilitates lightweight of the foldable assembly 3, simplifies a mounting process of the foldable assembly 3, and reduces production costs of the foldable assembly 3.

It may be understood that, in some other embodiments, the included angle between the first swing arm 322 and the second swing arm 325 in the open state does not need to be adjusted. In this case, the first stop surface 3271h and the second stop surface 3271j may alternatively be parallel to the thickness direction of the main shaft 31, and there may alternatively be only one stop position. A person skilled in the art may correspondingly adjust a cooperation structure of another structural member based on a structural design requirement.

It may be understood that the foregoing embodiments are described by using an example in which the electronic device 100 is a mobile phone. When the electronic device 100 is a foldable electronic product like a tablet computer, a notebook computer, or a wearable device, and the foldable apparatus 10 is in an open state, the included angle between the first housing 1 and the second housing 2 may alternatively be 120°, 150°, 170°, or another angle. In other words, based on a stop function of the stop member 3271, when the first stop end surface 3221f of the first swing arm 322 abuts against the first stop surface 3271h of the stop member 3271, when the first stop surface 3271h of the second swing arm 325 abuts against the second stop surface 3271j of the stop member 3271, the included angle between the first housing 1 and the second housing 2 in the open state may be correspondingly 120°, 150°, 170°, or another angle, to prevent the flexible display 20 from being overfolded. In addition, positions of the first stop end surface 3221f and the second stop end surface 3251f may be further adjusted by using the second fastener 3276, to eliminate a precision error and a part assembly error.

The foregoing descriptions are merely specific embodiments of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable assembly, comprising a main shaft, a first fastening bracket, a first swing arm, a second fastening bracket, a second swing arm, a limiting member, a stop member, a second fastener, and a first elastic member, wherein
a first end part of the first swing arm is rotatably connected to the main shaft, a second end part of the first swing arm is slidably connected to the first fastening bracket, and the first end part of the first swing arm has a first stop end surface; and a first end part of the second swing arm is rotatably connected to the main shaft, a second end part of the second swing arm is slidably connected to the second fastening bracket, and the first end part of the second swing arm has a second stop end surface;
the limiting member is fastened to the main shaft, the limiting member has a limiting surface, the limiting surface is inclined relative to a thickness direction of the main shaft and is inclined relative to an extension direction of the main shaft, and the extension direction of the main shaft is perpendicular to the thickness direction of the main shaft;
the stop member comprises a first stop part, a second stop part, and a mounting part, the first stop part and the second stop part are respectively fastened to two sides of the mounting part, one end of the second fastener is connected to the mounting part, the other end is threadedly connected to the main shaft, the first elastic member abuts between the mounting part and the main shaft, and the stop member abuts against the limiting surface;
the first stop part has a first stop surface, the second stop part has a second stop surface, and neither the first stop surface nor the second stop surface is parallel to the thickness direction of the main shaft; and
in a process in which the first swing arm and the second swing arm are unfolded relative to each other, the first stop end surface moves in a direction close to the first stop surface, and the second stop end surface moves in a direction close to the second stop surface; and when the first swing arm and the second swing arm are in an open state, the first stop end surface at least partially abuts against the first stop surface, and the second stop end surface at least partially abuts against the second stop surface.

2. The foldable assembly according to claim 1, wherein the mounting part has a second through hole, the second through hole has at least two stay positions, the at least two stay positions are arranged in the extension direction of the main shaft, and the second fastener passes through one of the stay positions.

3. The foldable assembly according to claim 2, wherein the second through hole is a kidney-shaped hole or a rectangular hole, and a length direction of the second through hole is parallel to the extension direction of the main shaft.

4. The foldable assembly according to claim 3, wherein the foldable assembly further comprises a second elastic member, the second elastic member is mounted on the main shaft and is located on a side that is of the stop member and that faces away from the limiting member, the second elastic member abuts against the mounting part, and an elastic force generated by the second elastic member enables the stop member to abut against the limiting surface.

5. The foldable assembly according to any one of claims 1 to 4, wherein the stop member has an adjusting surface, and the adjusting surface is parallel to the limiting surface and is in contact with the limiting surface.

6. The foldable assembly according to claim 5, wherein a friction layer is disposed on the limiting surface and/or a friction layer is disposed on the adjusting surface, and the friction layer is configured to increase a static friction coefficient between the limiting surface and the adjusting surface.

7. The foldable assembly according to any one of claims 1 to 6, wherein the limiting member comprises a first fastening part, a second fastening part, and a third fastening part, the third fastening part is connected between the first fastening part and the second fastening part, and the third fastening part is fastened to the main shaft; and
the foldable assembly further comprises a first rotating shaft and a second rotating shaft that are mounted on the main shaft, the first rotating shaft is inserted into the first end part of the first swing arm and the first fastening part, and the second rotating shaft is inserted into the first end part of the second swing arm and the second fastening part.

8. The foldable assembly according to claim 7, wherein the limiting surface comprises a first part and a second part that are coplanar, the first part of the limiting surface is located at the first fastening part, and the second part of the limiting surface is located at the second fastening part.

9. The foldable assembly according to claim 7 or 8, wherein the first stop part has a first adjusting hole, the second stop part has a second adjusting hole, the first rotating shaft passes through the first adjusting hole, the second rotating shaft passes through the second adjusting hole, both the first adjusting hole and the second adjusting hole are rectangular holes or kidney-shaped holes, and length directions of the first adjusting hole and the second adjusting hole are parallel to the thickness direction of the main shaft.

10. The foldable assembly according to claim 9, wherein the first stop part abuts against the first fastening part, and the second stop part abuts against the second fastening part.

11. The foldable assembly according to any one of claims 1 to 10, wherein the first stop surface and the second stop surface are of a symmetric structure.

12. The foldable assembly according to any one of claims 1 to 11, wherein the first end part of the first swing arm comprises a plurality of first protrusions and a plurality of second protrusions that are disposed away from each other, and the first end part of the second swing arm comprises a plurality of first protrusions and a plurality of second protrusions that are disposed away from each other;
the foldable assembly further comprises a damping assembly, the damping assembly comprises a first clamping member, a second clamping member, and a first elastic component, a plurality of first bump groups are disposed on the first clamping member, a plurality of second bump groups are disposed on the second clamping member, and the plurality of first bump groups are disposed in one-to-one correspondence with the plurality of second bump groups; and
both the first end part of the first swing arm and the first end part of the second swing arm are located between the first clamping member and the second clamping member, the first elastic component is located on a side that is of the second clamping member and that faces away from the first clamping member or on a side that is of the first clamping member and that faces away from the second clamping member, the first elastic component is configured to generate an elastic force, to enable both the first end part of the first swing arm and the first end part of the second swing arm to abut against the first clamping member and the second clamping member, the plurality of first protrusions of the first swing arm cooperate with one of the first bump groups to form a clamping structure, the plurality of second protrusions of the first swing arm cooperate with one of the second bump groups to form a clamping structure, the plurality of first protrusions of the second swing arm cooperate with another first bump group to form a clamping structure, and the plurality of second protrusions of the second swing arm cooperate with another second bump group to form a clamping structure.

13. A foldable apparatus, wherein the foldable apparatus comprises a first housing, a second housing, and the foldable assembly according to any one of claims 1 to 12, the first fastening bracket of the foldable assembly is fastened to the first housing, and the second fastening bracket is fastened to the second housing.

14. An electronic device, comprising a flexible display and the foldable apparatus according to claim 13, wherein
a part that is of the flexible display and that corresponds to the first housing is fastened to the first housing, a part that is of the flexible display and that corresponds to the second housing is fastened to the second housing, and in a process in which the first housing and the second housing are unfolded relative to each other or folded relative to each other, a part that is of the flexible display and that corresponds to the foldable assembly deforms.

## Patentansprüche

1. Faltbare Baugruppe, umfassend eine Hauptwelle, eine erste Befestigungshalterung, einen ersten Schwenkarm, eine zweite Befestigungshalterung, einen zweiten Schwenkarm, ein Begrenzungselement, ein Anschlagelement, ein zweites Befestigungsmittel und ein erstes elastisches Element, wobei ein erster Endteil des ersten Schwenkarms drehbar mit der Hauptwelle verbunden ist, ein zweiter Endteil des ersten Schwenkarms verschiebbar mit der ersten Befestigungshalterung verbunden ist und der erste Endteil des ersten Schwenkarms eine erste Anschlagendoberfläche aufweist; und ein erster Endteil des zweiten Schwenkarms drehbar mit der Hauptwelle verbunden ist, ein zweiter Endteil des zweiten Schwenkarms verschiebbar mit der zweiten Befestigungshalterung verbunden ist und der erste Endteil des zweiten Schwenkarms eine zweite Anschlagendoberfläche aufweist;
das Begrenzungselement an der Hauptwelle befestigt ist, das Begrenzungselement eine Begrenzungsoberfläche aufweist, die Begrenzungsoberfläche relativ zu einer Dickenrichtung der Hauptwelle geneigt ist und relativ zu einer Erstreckungsrichtung der Hauptwelle geneigt ist und die Erstreckungsrichtung der Hauptwelle senkrecht zu der Dickenrichtung der Hauptwelle verläuft;
das Anschlagelement ein erstes Anschlagteil, ein zweites Anschlagteil und ein Montageteil umfasst, das erste Anschlagteil und das zweite Anschlagteil jeweils an zwei Seiten des Montageteils befestigt sind, ein Ende des zweiten Befestigungsmittels mit dem Montageteil verbunden ist, das andere Ende verschraubt mit der Hauptwelle verbunden ist, das erste elastische Element zwischen dem Montageteil und der Hauptwelle anliegt und das Anschlagelement gegen die Begrenzungsoberfläche anliegt;
das erste Anschlagteil eine erste Anschlagoberfläche aufweist, das zweite Anschlagteil eine zweite Anschlagoberfläche aufweist und weder die erste Anschlagoberfläche noch die zweite Anschlagoberfläche parallel zu der Dickenrichtung der Hauptwelle verläuft; und
während eines Vorgangs, bei dem der erste Schwenkarm und der zweite Schwenkarm relativ zueinander auseinandergefaltet werden, sich die erste Anschlagendoberfläche in einer Richtung in die Nähe der ersten Anschlagoberfläche bewegt und sich die zweite Anschlagendoberfläche in einer Richtung in die Nähe der zweiten Anschlagoberfläche bewegt; und, wenn sich der erste Schwenkarm und der zweite Schwenkarm in einem offenen Zustand befinden, die erste Anschlagendoberfläche mindestens teilweise gegen die erste Anschlagoberfläche anliegt und die zweite Anschlagendoberfläche mindestens teilweise gegen die zweite Anschlagoberfläche anliegt.

2. Faltbare Baugruppe nach Anspruch 1, wobei das Montageteil ein zweites Durchgangsloch aufweist, das zweite Durchgangsloch mindestens zwei Haltepositionen aufweist, die mindestens zwei Haltepositionen in der Erstreckungsrichtung der Hauptwelle angeordnet sind und das zweite Befestigungsmittel durch eine der Haltepositionen hindurchgeht.

3. Faltbare Baugruppe nach Anspruch 2, wobei das zweite Durchgangsloch ein nierenförmiges Loch oder ein rechteckiges Loch ist und eine Längsrichtung des zweiten Durchgangslochs parallel zu der Erstreckungsrichtung der Hauptwelle verläuft.

4. Faltbare Baugruppe nach Anspruch 3, wobei die faltbare Baugruppe ferner ein zweites elastisches Element umfasst, das zweite elastische Element auf der Hauptwelle montiert ist und sich auf einer Seite, die dem Anschlagelement zugehörig ist und die von dem Begrenzungselement abgewandt ist, befindet, das zweite elastische Element gegen das Montageteil anliegt und eine durch das zweite elastische Element erzeugte elastische Kraft es dem Anschlagelement ermöglicht, gegen die Begrenzungsoberfläche anzuliegen.

5. Faltbare Baugruppe nach einem der Ansprüche 1 bis 4, wobei das Anschlagelement eine Einstelloberfläche aufweist und die Einstelloberfläche parallel zu der Begrenzungsoberfläche verläuft und mit der Begrenzungsoberfläche in Kontakt steht.

6. Faltbare Baugruppe nach Anspruch 5, wobei eine Reibungsschicht auf der Begrenzungsoberfläche angeordnet ist und/oder eine Reibungsschicht auf der Einstelloberfläche angeordnet ist und die Reibungsschicht ausgelegt ist, um einen statischen Reibungskoeffizienten zwischen der Begrenzungsoberfläche und der Einstelloberfläche zu erhöhen.

7. Faltbare Baugruppe nach einem der Ansprüche 1 bis 6, wobei das Begrenzungselement ein erstes Befestigungsteil, ein zweites Befestigungsteil und ein drittes Befestigungsteil umfasst, das dritte Befestigungsteil zwischen dem ersten Befestigungsteil und dem zweiten Befestigungsteil verbunden ist und das dritte Befestigungsteil an der Hauptwelle befestigt ist; und
die faltbare Baugruppe ferner eine erste Drehwelle und eine zweite Drehwelle umfasst, die auf der Hauptwelle montiert sind, die erste Drehwelle in den ersten Endteil des ersten Schwenkarms und das erste Befestigungsteil eingesetzt ist und die zweite Drehwelle in den ersten Endteil des zweiten Schwenkarms und das zweite Befestigungsteil eingesetzt ist.

8. Faltbare Baugruppe nach Anspruch 7, wobei die Begrenzungsoberfläche einen ersten Teil und einen zweiten Teil umfasst, die koplanar verlaufen, wobei sich der erste Teil der Begrenzungsoberfläche an dem ersten Befestigungsteil befindet und sich der zweite Teil der Begrenzungsoberfläche an dem zweiten Befestigungsteil befindet.

9. Faltbare Baugruppe nach Anspruch 7 oder 8, wobei das erste Anschlagteil ein erstes Einstellloch aufweist, das zweite Anschlagteil ein zweites Einstellloch aufweist, die erste Drehwelle durch das erste Einstellloch hindurchgeht, die zweite Drehwelle durch das zweite Einstellloch hindurchgeht, sowohl das erste Einstellloch als auch das zweite Einstellloch rechteckige Löcher oder nierenförmige Löcher sind und Längsrichtungen des ersten Einstelllochs und des zweiten Einstelllochs parallel zu der Dickenrichtung der Hauptwelle verlaufen.

10. Faltbare Baugruppe nach Anspruch 9, wobei das erste Anschlagteil gegen das erste Befestigungsteil anliegt und das zweite Anschlagteil gegen das zweite Befestigungsteil anliegt.

11. Faltbare Baugruppe nach einem der Ansprüche 1 bis 10, wobei die erste Anschlagoberfläche und die zweite Anschlagoberfläche von einer symmetrischen Struktur sind.

12. Faltbare Baugruppe nach einem der Ansprüche 1 bis 11, wobei der erste Endteil des ersten Schwenkarms eine Vielzahl von ersten Vorsprüngen und eine Vielzahl von zweiten Vorsprüngen aufweist, die voneinander entfernt angeordnet sind, und der erste Endteil des zweiten Schwenkarms eine Vielzahl von ersten Vorsprüngen und eine Vielzahl von zweiten Vorsprüngen aufweist, die voneinander entfernt angeordnet sind;
die faltbare Baugruppe ferner eine Dämpfungsbaugruppe umfasst, die Dämpfungsbaugruppe ein erstes Klemmelement, ein zweites Klemmelement und ein erstes elastisches Bauteil umfasst, eine Vielzahl von ersten Erhebungsgruppen auf dem ersten Klemmelement angeordnet sind, eine Vielzahl von zweiten Erhebungsgruppen auf dem zweiten Klemmelement angeordnet sind und die Vielzahl von ersten Erhebungsgruppen in Eins-zu-Eins-Entsprechung zu der Vielzahl von zweiten Erhebungsgruppen angeordnet sind; und sich sowohl der erste Endteil des ersten Schwenkarms als auch der erste Endteil des zweiten Schwenkarms zwischen dem ersten Klemmelement und dem zweiten Klemmelement befinden, sich das erste elastische Bauteil auf einer Seite, die dem zweiten Klemmelement zugehörig ist und die von dem ersten Klemmelement abgewandt ist, oder auf einer Seite, die dem ersten Klemmelement zugehörig ist und die von dem zweiten Klemmelement abgewandt ist, befindet, das erste elastische Bauteil ausgelegt ist, um eine elastische Kraft zu erzeugen, um es sowohl dem ersten Endteil des ersten Schwenkarms als auch dem ersten Endteil des zweiten Schwenkarms zu ermöglichen, gegen das erste Klemmelement und das zweite Klemmelement anzuliegen, die Vielzahl von ersten Vorsprüngen des ersten Schwenkarms mit einer der ersten Erhebungsgruppen zusammenwirken, um eine Klemmstruktur auszubilden, die Vielzahl von zweiten Vorsprüngen des ersten Schwenkarms mit einer der zweiten Erhebungsgruppen zusammenwirken, um eine Klemmstruktur auszubilden, die Vielzahl von ersten Vorsprüngen des zweiten Schwenkarms mit einer anderen ersten Erhebungsgruppe zusammenwirken, um eine Klemmstruktur auszubilden, und die Vielzahl von zweiten Vorsprüngen des zweiten Schwenkarms mit einer anderen zweiten Erhebungsgruppe zusammenwirken, um eine Klemmstruktur auszubilden.

13. Faltbare Einrichtung, wobei die faltbare Einrichtung ein erstes Gehäuse, ein zweites Gehäuse und die faltbare Baugruppe nach einem der Ansprüche 1 bis 12 umfasst, die erste Befestigungshalterung der faltbaren Baugruppe an dem ersten Gehäuse befestigt ist und die zweite Befestigungshalterung an dem zweiten Gehäuse befestigt ist.

14. Elektronische Vorrichtung, umfassend ein flexibles Display und die faltbare Einrichtung nach Anspruch 13, wobei ein Teil, der dem flexiblen Display zugehörig ist und der dem ersten Gehäuse entspricht, an dem ersten Gehäuse befestigt ist, ein Teil, der dem flexiblen Display zugehörig ist und der dem zweiten Gehäuse entspricht, an dem zweiten Gehäuse befestigt ist, und sich ein Teil, der dem flexiblen Display zugehörig ist und der der faltbaren Baugruppe entspricht, während eines Vorgangs, bei dem das erste Gehäuse und das zweite Gehäuse relativ zueinander auseinandergefaltet oder relativ zueinander zusammengefaltet werden, verformt.

## Revendications

1. Ensemble pliable, comprenant un arbre principal, un premier support de fixation, un premier bras oscillant, un second support de fixation, un second bras oscillant, un élément de limitation, un élément d'arrêt, une seconde fixation et un premier élément élastique, dans lequel
une première partie d'extrémité du premier bras oscillant est reliée de manière rotative à l'arbre principal, une seconde partie d'extrémité du premier bras oscillant est reliée de manière coulissante au premier support de fixation, et la première partie d'extrémité du premier bras oscillant a une première surface d'extrémité d'arrêt ; et une première partie d'extrémité du second bras oscillant est reliée de manière rotative à l'arbre principal, une seconde partie d'extrémité du second bras oscillant est reliée de manière coulissante au second support de fixation, et la première partie d'extrémité du second bras oscillant a une seconde surface d'extrémité d'arrêt ;
l'élément de limitation est fixé à l'arbre principal, l'élément de limitation a une surface de limitation, la surface de limitation est inclinée par rapport à une direction d'épaisseur de l'arbre principal et est inclinée par rapport à une direction d'extension de l'arbre principal, et la direction d'extension de l'arbre principal est perpendiculaire à la direction d'épaisseur de l'arbre principal ;
l'élément d'arrêt comprend une première partie d'arrêt, une seconde partie d'arrêt et une partie de montage, la première partie d'arrêt et la seconde partie d'arrêt sont respectivement fixées de deux côtés de la partie de montage, une extrémité de la seconde fixation est connectée à la partie de montage, l'autre extrémité est reliée par filetage à l'arbre principal, le premier élément élastique vient en butée entre la partie de montage et l'arbre principal, et l'élément d'arrêt vient en butée contre la surface de limitation ;
la première partie d'arrêt a une première surface d'arrêt, la seconde partie d'arrêt a une seconde surface d'arrêt, et ni la première surface d'arrêt ni la seconde surface d'arrêt ne sont parallèles à la direction d'épaisseur de l'arbre principal ; et dans un processus au cours duquel le premier bras oscillant et le second bras oscillant se déplient l'un par rapport à l'autre, la première surface d'extrémité d'arrêt se déplace dans une direction proche de la première surface d'arrêt, et la seconde surface d'extrémité d'arrêt se déplace dans une direction proche de la seconde surface d'arrêt ; et lorsque le premier bras oscillant et le second bras oscillant sont dans un état ouvert, la première surface d'extrémité d'arrêt vient en butée au moins partiellement contre la première surface d'arrêt, et la seconde surface d'extrémité d'arrêt vient en butée au moins partiellement contre la seconde surface d'arrêt.

2. Ensemble pliable selon la revendication 1, dans lequel la partie de montage a un second trou traversant, le second trou traversant a au moins deux positions de maintien, les au moins deux positions de maintien sont agencées dans la direction d'extension de l'arbre principal, et la seconde fixation passe à travers l'une des positions de maintien.

3. Ensemble pliable selon la revendication 2, dans lequel le second trou traversant est un trou en forme de rein ou un trou rectangulaire, et une direction de longueur du second trou traversant est parallèle à la direction d'extension de l'arbre principal.

4. Ensemble pliable selon la revendication 3, dans lequel l'ensemble pliable comprend en outre un second élément élastique, le second élément élastique est monté sur l'arbre principal et est situé sur un côté qui est de l'élément d'arrêt et qui fait face à l'élément de limitation, le second élément élastique vient en butée contre la partie de montage, et une force élastique générée par le second élément élastique permet à l'élément d'arrêt de venir en butée contre la surface de limitation.

5. Ensemble pliable selon l'une quelconque des revendications 1 à 4, dans lequel l'élément d'arrêt a une surface de réglage, et la surface de réglage est parallèle à la surface de limitation et est en contact avec la surface de limitation.

6. Ensemble pliable selon la revendication 5, dans lequel une couche de friction est disposée sur la surface de limitation et/ou une couche de friction est disposée sur la surface de réglage, et la couche de friction est configurée pour augmenter un coefficient de friction statique entre la surface de limitation et la surface de réglage.

7. Ensemble pliable selon l'une quelconque des revendications 1 à 6, dans lequel l'élément de limitation comprend une première partie de fixation, une deuxième partie de fixation et une troisième partie de fixation, la troisième partie de fixation est reliée entre la première partie de fixation et la deuxième partie de fixation, et la troisième partie de fixation est fixée à l'arbre principal ; et
l'ensemble pliable comprend en outre un premier arbre rotatif et un second arbre rotatif qui sont montés sur l'arbre principal, le premier arbre rotatif est inséré dans la première partie d'extrémité du premier bras oscillant et dans la première partie de fixation, et le second arbre rotatif est inséré dans la première partie d'extrémité du second bras oscillant et dans la deuxième partie de fixation.

8. Ensemble pliable selon la revendication 7, dans lequel la surface de limitation comprend une première partie et une seconde partie qui sont coplanaires, la première partie de la surface de limitation est située au niveau de la première partie de fixation et la seconde partie de la surface de limitation est située au niveau de la deuxième partie de fixation.

9. Ensemble pliable selon la revendication 7 ou 8, dans lequel la première partie d'arrêt a un premier trou de réglage, la seconde partie d'arrêt comporte un second trou de réglage, le premier arbre rotatif passe à travers le premier trou de réglage, le second arbre rotatif passe à travers le second trou de réglage, le premier trou de réglage et le second trou de réglage sont des trous rectangulaires ou des trous en forme de rein, et les directions de longueur du premier trou de réglage et du second trou de réglage sont parallèles à la direction d'épaisseur de l'arbre principal.

10. Ensemble pliable selon la revendication 9, dans lequel la première partie d'arrêt vient en butée contre la première partie de fixation, et la seconde partie d'arrêt vient en butée contre la deuxième partie de fixation.

11. Ensemble pliable selon l'une quelconque des revendications 1 à 10, dans lequel la première surface d'arrêt et la seconde surface d'arrêt sont de structure symétrique.

12. Ensemble pliable selon l'une quelconque des revendications 1 à 11, dans lequel la première partie d'extrémité du premier bras oscillant comprend une pluralité de premières saillies et une pluralité de secondes saillies qui sont disposées à distance les une des autres, et la première partie d'extrémité du second bras oscillant comprend une pluralité de premières saillies et une pluralité de secondes saillies qui sont disposées à distance les une des autres ;
l'ensemble pliable comprend en outre un ensemble d'amortissement, l'ensemble d'amortissement comprend un premier élément de serrage, un second élément de serrage et un premier composant élastique, une pluralité de premiers groupes de bossages sont disposés sur le premier élément de serrage, une pluralité de seconds groupes de bossages sont disposés sur le second élément de serrage, et la pluralité de premiers groupes de bossages sont disposés en correspondance biunivoque avec la pluralité de seconds groupes de bossages ; et
la première partie d'extrémité du premier bras oscillant et la première partie d'extrémité du second bras oscillant sont toutes deux situées entre le premier élément de serrage et le second élément de serrage, le premier composant élastique est situé sur un côté qui est du second élément de serrage qui fait face au premier élément de serrage ou sur un côté qui est du premier élément de serrage qui fait face au second élément de serrage, le premier composant élastique est configuré pour générer une force élastique, afin de permettre à la fois à la première partie d'extrémité du premier bras oscillant et à la première partie d'extrémité du second bras oscillant de venir en butée contre le premier élément de serrage et le second élément de serrage, la pluralité de premières saillies du premier bras oscillant coopèrent avec un des premiers groupes de bossages pour former une structure de serrage, la pluralité de secondes saillies du premier bras oscillant coopèrent avec un des seconds groupes de bossages pour former une structure de serrage, la pluralité de premières saillies du second bras oscillant coopèrent avec un autre premier groupe de bossages pour former une structure de serrage, et la pluralité de secondes saillies du second bras oscillant coopèrent avec un autre second groupe de bossages pour former une structure de serrage.

13. Appareil pliable, dans lequel l'appareil pliable comprend un premier boîtier, un second boîtier, et l'ensemble pliable selon l'une quelconque des revendications 1 à 12, le premier support de fixation de l'ensemble pliable est fixé au premier boîtier, et le second support de fixation étant fixé au second boîtier.

14. Dispositif électronique, comprenant un affichage flexible et l'appareil pliable selon la revendication 13, dans lequel une partie qui est de l'affichage flexible et qui correspond au premier boîtier est fixée au premier boîtier, une partie qui est de l'affichage flexible et qui correspond au second boîtier est fixée au second boîtier, et dans un processus au cours duquel le premier boîtier et le second boîtier sont dépliés l'un par rapport à l'autre ou pliés l'un par rapport à l'autre, une partie qui est de l'affichage flexible et qui correspond à l'ensemble pliable se déforme.
